# EUROPEAN PATENT APPLICATION

(11) **EP 2 289 966 A1**
(43) Date of publication of application: **02.03.2011**
(21) Application number: 09762570.1
(22) Date of filing: 10.06.2009
(51) Int. Cl.: C08G 61/12, C09K 11/06, G02F 1/13357, H01L 29/786, H01L 51/05, H01L 51/30, H01L 51/42, H01L 51/50

(54) **COPOLYMER AND POLYMER LIGHT-EMITTING ELEMENT USING THE SAME**

(30) Priority: 13.06.2008 JP 2008155110
(71) Applicant: Sumitomo Chemical Company, Limited, Tokyo 104-8260 (JP); Sumation Co., Ltd., Chuo-ku Tokyo 104-8260 (JP)
(72) Inventor: GOTO, Osamu, Tsukuba-shi Ibaraki 305-0821 (JP); ASADA, Kohei, Tsukuba-shi Ibaraki 305-0821 (JP)
(74) Representative: Duckworth, Timothy John
(86) International application number: PCT/JP2009/060974
(87) International publication number: WO 2009/151144

(57) **Abstract**

A copolymer having a block (A') composed of a repeating unit represented by the formula (I-1), and/or a block (A) containing a repeating unit represented by the formula (I-1) and a repeating unit represented by the formula (II). 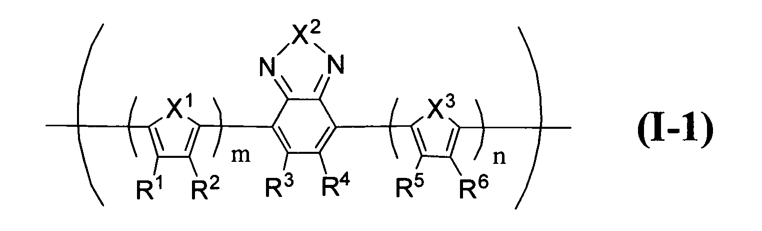 (wherein X¹, X² and X³ may be the same or mutually different and represent an oxygen atom, a sulfur atom or C(R⁷)=C(R⁸)-, and R¹, R², R³, R⁴, R⁵, R⁶, R⁷ and R⁸ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, and m and n may be the same or mutually different and represent 2 or 3. A plurality of R¹s may be the same or mutually different. A plurality of R²s may be the same or mutually different. A plurality of R⁵s may be the same or mutually different. A plurality of R⁶s may be the same or mutually different. A plurality of X¹s may be the same or mutually different. A plurality of X³s may be the same or mutually different.)

-(Ar¹)- (II)

(wherein Ar¹ represents an arylene group.).

## Description

### Technical Field

The present invention relates to a copolymer and a polymer light emitting device using the same.

### Background Art

As the material used in a polymer light emitting device, various polymer compounds are investigated, and a random copolymer having as a repeating unit a group represented by the formula (M) and a fluorene-diyl group which is an arylene group is known (Japanese Patent Application National Publication (Laid-Open) No. 2004-534863) as an example thereof.

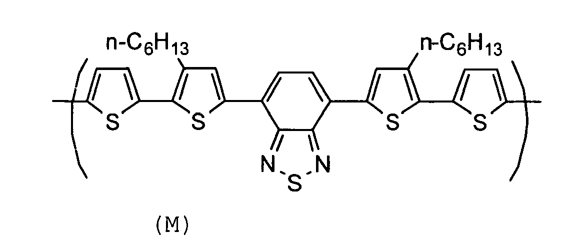

### Disclosure of the Invention

When the above-described random copolymer is used in a polymer light emitting device, however, the lifetime of light emission of the polymer light emitting device is not sufficient yet.

The present invention has an object of providing a copolymer which is capable of giving a polymer light emitting device showing light emission for a long period of time.

The present invention provides, in a first aspect, a copolymer having a block (A') composed of a repeating unit represented by the formula (I-1), and/or a block (A) containing a repeating unit represented by the formula (I-1) and a repeating unit represented by the formula (II). 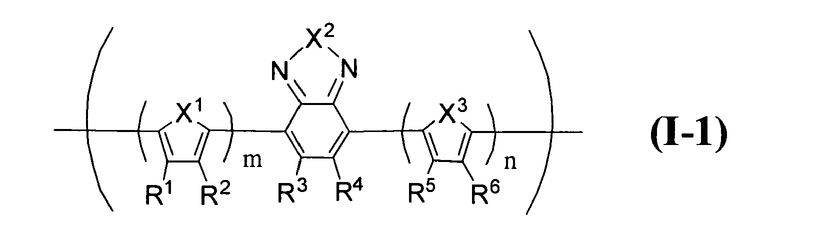 (wherein X¹, X² and X³ may be the same or mutually different and represent an oxygen atom, a sulfur atom or C(R⁷)=C(R⁸)-, and R¹, R², R³, R⁴, R⁵, R⁶, R⁷ and R⁸ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, and m and n may be the same or mutually different and represent 2 or 3. A plurality of R¹s may be the same or mutually different. A plurality of R²s may be the same or mutually different. A plurality of R⁵s may be the same or mutually different. A plurality of R⁶s may be the same or mutually different. A plurality of X¹s may be the same or mutually different. A plurality of X³s may be the same or mutually different.)

-(Ar¹)- (II)

(wherein Ar¹ represents an arylene group.).

The present invention provides, in a second aspect, a composition comprising the above-described copolymer, and at least one material selected from the group consisting of a light emitting material, a hole transporting material and an electron transporting material.

The present invention provides, in a third aspect, a composition comprising the above-described copolymer and a solvent.

The present invention provides, in a fourth aspect, a film comprising the above-described copolymer or the above-described composition.

The present invention provides, in a fifth aspect, a polymer light emitting device having and anode, a cathode, and an organic layer containing the above-described copolymer or the above-described composition located between the anode and the cathode.

The present invention provides, in a sixth aspect, a planar light source and an illumination using the above-described polymer light emitting device, and a liquid crystal display using the above-described polymer light emitting device as a backlight.

The present invention provides, in a seventh aspect, an organic transistor having an active layer containing the above-described copolymer.

The present invention provides, in an eighth aspect, a photoelectric conversion device having an anode, a cathode, and an organic layer containing the above-described copolymer disposed between the anode and the cathode.

The present invention provides, in a ninth aspect, a method of producing the above-described copolymer having a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, and a step of condensation-polymerizing this first compound with a compound having two substituents capable of participating in condensation polymerization, to synthesize a copolymer having a block (A') and/or a block (A) :
(wherein -A- represents a repeating unit represented by the formula (I-1) or a repeating unit represented by the formula (1-2), Ar¹ represents the same meaning as described above, and W¹ and W² may be the same or mutually different and represent a substituent capable of participating in condensation polymerization.).

The present invention provides, in a tenth aspect, a method of producing the above-described copolymer having a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, and a step of condensation-polymerizing this first compound with a compound represented by W¹-Ar¹-W² and a compound represented by W¹-Ar²-W², or condensation-polymerizing this first compound with a compound represented by W¹-Ar¹-W², a compound represented by W¹-Ar²-W² and a compound having two substituents capable of participqating in condensation polymerization, to synthesize a copolymer having a block (A') and/or a block (A) and a block (B):
(wherein -A- represents a repeating unit represented by the formula (I-1) or a repeating unit represented by the formula (1-2), Ar¹ represents the same meaning as described above, Ar² represents a di-valent aromatic amine residue, and W¹ and W² may be the same or mutually different and represent a substituent capable of participating in condensation polymerization.).

The present invention provides, in an eleven aspect, a method of producing the above-described copolymer having a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, a step of condensation-polymerizing a compound represented by W¹-Ar¹-W² with a compound represented by W¹-Ar²-W², or condensation-polymerizing a compound represented by W¹-Ar¹-W² with a compound represented by W¹-Ar²-W² and a compound having two substituents capable of participating in condensation polymerization, to synthesize a second compound, and a step of condensation-polymerizing this first compound with this second compound, to synthesize a copolymer having a block (A') and/or a block (A) and a block (B):
(wherein -A- represents a repeating unit represented by the formula (I-1) or a repeating unit represented by the formula (1-2), Ar¹ and Ar² represent the same meaning as described above, and W¹ and W² may be the same or mutually different and represent a substituent capable of participating in condensation polymerization.).

### Embodiments for Carrying Out the Invention

### <Block (A'), Block (A)>

The copolymer of the present invention has a block (A') composed of a repeating unit represented by the formula (I-1), and/or a block (A) containing a repeating unit represented by the formula (I-1) and a repeating unit represented by the formula (II), and preferably has a block (A) containing a repeating unit represented by the formula (I-1) and a repeating unit represented by the formula (II).

In the formula (I-1), X¹, X² and X³ may be the same or mutually different and represent an oxygen atom, a sulfur atom or C(R⁷)=C(R⁸)-, and R¹, R², R³, R⁴, R⁵, R⁶, R⁷ and R⁸ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group.

As the halogen atom, a fluorine atom, a chlorine atom, a bromine atom and an iodine atom are exemplified.

The alkyl group means an unsubstituted alkyl group or an alkyl group in which a hydrogen atom in the group is substituted by a halogen atom and the like, and may be linear or branched, or may also be a cycloalkyl group. The alkyl group has a carbon atom number of usually 1 to 20, preferably 1 to 15, more preferably 1 to 10. Examples of the alkyl group include a methyl group, an ethyl group, a propyl group, an isopropyl group, a butyl group, an isobutyl group, a s-butyl group, a t-butyl group, a pentyl group, an isoamyl group, a hexyl group, a cyclohexyl group, a heptyl group, an octyl group, a 2-ethylhexyl group, a nonyl group, a decyl group, a 3,7-dimethyloctyl group, a dodecyl group, a trifluoromethyl group, a pentafluoroethyl group, a perfluorobutyl group, a perfluorohexyl group, a perfluorooctyl group and the like.

The alkoxy group means an unsubstituted alkoxy group or an alkoxy group in which a hydrogen atom in the group is substituted by a halogen atom and the like, and may be linear or branched, or may also be a cycloalkoxy group. The alkoxy group has a carbon atom number of usually 1 to 20, preferably 1 to 15, more preferably 1 to 10. Examples of the alkoxy group include a methoxy group, an ethoxy group, a propyloxy group, an isopropyloxy group, a butoxy group, an isobutoxy group, a s-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a dodecyloxy group, a trifluoromethoxy group, a pentafluoroethoxy group, a perfluorobutoxy group, a perfluorohexyloxy group, a perfluorooctyloxy group, a methoxymethyloxy group, a 2-methoxyethyloxy group and the like.

The alkylthio group means an unsubstituted alkylthio group or an alkylthio group in which a hydrogen atom in the group is substituted by a halogen atom and the like, and may be linear or branched, or may also be a cycloalkylthio group. The alkylthio group has a carbon atom number of usually 1 to 20, preferably 1 to 15, more preferably 1 to 10. Examples of the alkylthio group include a methylthio group, an ethylthio group, a propylthio group, an isopropylthio group, a butylthio group, an isobutylthio group, a s-butylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a dodecylthio group, a trifluoromethylthio group and the like.

The aryl group is an atomic group remaining after removing from an aromatic hydrocarbon one hydrogen atom bonded to a carbon atom constituting the aromatic ring, and means an unsubstituted an aryl group or an aryl group in which a hydrogen atom in the group is substituted by a halogen atom, an alkoxy group, an alkyl group, a carbonyl group, a carboxyl group and the like. The number of the substituent may be singular or plural, and a plurality of substituents may be the same or mutually different. The aryl group includes also those having a condensed ring, and those having two or more independent benzene rings or condensed rings connected by a single bond or via a di-valent organic group, for example, an alkenylene group such as a vinylene group and the like. The aryl group has a carbon atom number of usually 6 to 60, preferably 7 to 48, more preferably 7 to 30. Examples of the aryl group include a phenyl group, C₁ to C₁₂ alkoxyphenyl groups (C₁ to C₁₂ means a carbon atom number of 1 to 12. The same shall apply hereinafter.), C₁ to C₁₂ alkylphenyl groups, a 1-naphthyl group, a 2-naphthyl group, a 1-anthracenyl group, a 2-anthracenyl group, a 9-anthracenyl group, a pentafluorophenyl group and the like, and of them, C₁ to C₁₂ alkoxyphenyl groups and C₁ to C₁₂ alkylphenyl groups are preferable.

Examples of the C₁ to C₁₂ alkoxyphenyl group include a methoxyphenyl group, an ethoxyphenyl group, a propyloxyphenyl group, an isopropyloxyphenyl group, a butyloxyphenyl group, an isobutyloxyphenyl group, a s-butyloxyphenyl group, a t-butyloxyphenyl group, a pentyloxyphenyl group, a hexyloxyphenyl group, an octyloxyphenyl group and the like.

Examples of the C₁ to C₁₂ alkylphenyl group include a methylphenyl group, an ethylphenyl group, a dimethylphenyl group, a propylphenyl group, a mesityl group, a methylethylphenyl group, an isopropylphenyl group, a butylphenyl group, an isobutylphenyl group, a s-butylphenyl group, a t-butylphenyl group, a pentylphenyl group, an isoamylphenyl group, a hexylphenyl group, a heptylphenyl group, an octylphenyl group, a nonylphenyl group, a decylphenyl group, a dodecylphenyl group and the like.

The aryloxy group means an unsubstituted aryloxy group or an aryloxy group in which a hydrogen atom in the group is substituted by a halogen atom, an alkoxy group, an alkyl group and the like. The aryloxy group has a carbon atom number of usually 6 to 60, preferably 7 to 48, more preferably 7 to 30. Examples of the aryloxy group include a phenoxy group, C₁ to C₁₂ alkoxyphenoxy groups, C₁ to C₁₂ alkylphenoxy groups, a 1-naphthyloxy group, a 2-naphthyloxy group, a pentafluorophenyloxy group and the like, and of them, C₁ to C₁₂ alkoxyphenoxy groups and C₁ to C₁₂ alkylphenoxy groups are preferable.

Examples of the C₁ to C₁₂ alkoxyphenoxy group include a methoxyphenoxy group, an ethoxyphenoxy group, a propyloxyphenoxy group, an isopropyloxyphenoxy group, a butyloxyphenoxy group, an isobutyloxyphenoxy group, a s-butyloxyphenoxy group, a t-butyloxyphenoxy group, a pentyloxyphenoxy group, a hexyloxyphenoxy group, an octyloxyphenoxy group and the like.

Examples of the C₁ to C₁₂ alkylphenoxy group include a methylphenoxy group, an ethylphenoxy group, a dimethylphenoxy group, a propylphenoxy group, a 1,3,5-trimethylphenoxy group, a methylethylphenoxy group, an isopropylphenoxy group, a butylphenoxy group, an isobutylphenoxy group, a s-butylphenoxy group, a t-butylphenoxy group, a pentylphenoxy group, an isoamylphenoxy group, a hexylphenoxy group, a heptylphenoxy group, an octylphenoxy group, a nonylphenoxy group, a decylphenoxy group, a dodecylphenoxy group and the like.

The arylthio group means an unsubstituted arylthio group or an arylthio group in which a hydrogen atom in the group is substituted by a halogen atom, an alkoxy group, an alkyl group and the like. The arylthio group has a carbon atom number of usually 6 to 60, preferably 7 to 48, more preferably 7 to 30. Examples of the arylthio group include a phenylthio group, C₁ to C₁₂ alkoxyphenylthio groups, C₁ to C₁₂ alkylphenylthio groups, a 1-naphthylthio group, a 2-naphthylthio group, a pentafluorophenylthio group and the like.

The arylalkyl group means an unsubstituted arylalkyl group or an arylalkyl group in which a hydrogen atom in the group is substituted by a halogen atom, an alkoxy group, an alkyl group and the like. The arylalkyl group has a carbon atom number of usually 7 to 60, preferably 7 to 48, more preferably 7 to 30. Examples of the arylalkyl group include phenyl C₁ to C₁₂ alkyl groups, C₁ to C₁₂ alkoxyphenyl C₁ to C₁ alkyl groups, C₁ to C₁₂ alkylphenyl C₁ to C₁₂ alkyl groups, 1-naphthyl C₁ to C₁₂ alkyl groups, 2-naphthyl C₁ to C₁₂ alkyl groups and the like. Here, examples of the C₁ to C₁₂ alkyl group include a methyl group, an ethyl group, a propyl group, an isopropyl group, a butyl group, an isobutyl group, a s-butyl group, a t-butyl group, a pentyl group, an isoamyl group, a hexyl group, a cyclohexyl group, a heptyl group, an octyl group, a nonyl group, a decyl group, a dodecyl group and the like.

The arylalkoxy group means an unsubstituted arylalkoxy group or an arylalkoxy group in which a hydrogen atom in the group is substituted by a halogen atom, an alkoxy group, an alkyl group and the like. The arylalkoxy group has a carbon atom number of usually 7 to 60, preferably 7 to 48, more preferably 7 to 30. Examples of the arylalkoxy group include phenyl C₁ to C₁₂ alkoxy groups, C₁ to C₁₂ alkoxyphenyl C₁ to C₁₂ alkoxy groups, C₁ to C₁₂ alkylphenyl C₁ to C₁₂ alkoxy groups, 1-naphthyl C₁ to C₁₂ alkoxy groups, 2-naphthyl C₁ to C₁₂ alkoxy groups and the like. Here, examples of the C₁ to C₁₂ alkoxy group include a methoxy group, an ethoxy group, a propyloxy group, an isopropyloxy group, a butoxy group, an isobutoxy group, a s-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a dodecyloxy group and the like.

The arylalkylthio group means an unsubstituted arylalkylthio group or an arylalkylthio group in which a hydrogen atom in the group is substituted by a halogen atom, an alkoxy group, an alkyl group and the like. The arylalkylthio group has a carbon atom number of usually 7 to 60, preferably 7 to 48, more preferably 7 to 30. Examples of the arylalkylthio group include phenyl C₁ to C₁₂ alkylthio groups, C₁ to C₁₂ alkoxyphenyl C₁ to C₁₂ alkylthio groups, C₁ to C₁₂ alkylphenyl C₁ to C₁₂ alkylthio groups, 1-naphthyl C₁ to C₁₂ alkylthio groups, 2-naphthyl C₁ to C₁₂ alkylthio groups and the like. Here, examples of the C₁ to C₁₂ alkylthio group include a methylthio group, an ethylthio group, a propylthio group, an isopropylthio group, a butylthio group, an isobutylthio group, a s-butylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a dodecylthio group and the like.

The arylalkenyl group means an unsubstituted arylalkenyl group or an arylalkenyl group in which a hydrogen atom in the group is substituted by a halogen atom, an alkoxy group, an alkyl group and the like. The arylalkenyl group has a carbon atom number of usually 8 to 60, preferably 8 to 48, more preferably 8 to 30. Examples of the arylalkenyl group include phenyl C₂ to C₁₂ alkenyl groups (C₂ to C₁₂ means a carbon atom number of 2 to 12. The same shall apply hereinafter.), C₁ to C₁₂ alkoxyphenyl C₂ to C₁₂ alkenyl groups, C₁ to C₁₂ alkylphenyl C₂ to C₁₂ alkenyl groups, 1-naphthyl C₂ to C₁₂ alkenyl groups, 2-naphthyl C₂ to C₁₂ alkenyl groups and the like, and of them, C₁ to C₁₂ alkoxyphenyl C₂ to C₁₂ alkenyl groups and C₁ to C₁₂ alkylphenyl C₂ to C₁₂ alkenyl groups are preferable.

Examples of the C₂ to C₁₂ alkenyl group include a vinyl group, a 1-propenyl group, a 2-propenyl group, a 1-butenyl group, a 2-butenyl group, a 1-pentenyl group, a 2-pentenyl group, a 1-hexenyl group, a 2-hexenyl group, a 1-octenyl group and the like.

The arylalkynyl group means an unsubstituted an arylalkynyl group or an arylalkynyl group in which a hydrogen atom in the group is substituted by a halogen atom, an alkoxy group, an alkyl group and the like. The arylalkynyl group has a carbon atom number of usually 8 to 60, preferably 8 to 48, more preferably 8 to 30. Examples of the arylalkynyl group include phenyl C₂ to C₁₂ alkynyl groups, C₁ to C₁₂ alkoxyphenyl C₂ to C₁₂ alkynyl groups, C₁ to C₁₂ alkylphenyl C₂ to C₁₂ alkynyl groups, 1-naphthyl C₂ to C₁₂ alkynyl groups, 2-naphthyl C₂ to C₁₂ alkynyl groups and the like, and of them, C₁ to C₁₂ alkoxyphenyl C₂ to C₁₂ alkynyl groups and C₁ to C₁₂ alkylphenyl C₂ to C₁₂ alkynyl groups are preferable.

Examples of the C₂ to C₁₂ alkynyl group include an ethynyl group, a 1-propynyl group, a 2-propynyl group, a 1-butynyl group, a 2-butynyl group, a 1-pentynyl group, a 2-pentynyl group, a 1-hexynyl group, a 2-hexynyl group, a 1-octynyl group and the like.

The mono-valent heterocyclic group is an atomic group remaining after removing from a heterocyclic compound one hydrogen atom, and means an unsubstituted mono-valent heterocyclic group or a mono-valent heterocyclic group in which a hydrogen atom in the group is substituted by a substituent such as an alkyl group and the like. The carbon atom number of the mono-valent heterocyclic group is usually 4 to 60, preferably 4 to 30, more preferably 4 to 20, not including the carbon atom number of the substituent. Here, the heterocyclic compound includes organic compounds having a cyclic structure in which elements constituting the ring include not only a carbon atom but also a hetero atom such as an oxygen atom, a sulfur atom, a nitrogen atom, a phosphorus atom, a boron atom, a silicon atom, a selenium atom, a tellurium atom, an arsenic atom and the like. The mono-valent heterocyclic group is preferably a heterocyclic group having an aromatic property. Examples of the mono-valent heterocyclic group include a thienyl group, C₁ to C₁₂ alkylthienyl groups, a pyrrolyl group, a furyl group, a pyridyl group, C₁ to C₁₂ alkylpyridyl groups, a pyridazinyl group, a pyrimidyl group, a pyrazinyl group, a triazinyl group, a quinolyl group, an isoquinolyl group and the like, and of them, a thienyl group, C₁ to C₁₂ alkylthienyl groups, a pyridyl group and C₁ to C₁₂ alkylpyridyl groups are preferable.

The heterocyclic thio group means a group in which a hydrogen atom of a mercapto group is substituted by a mono-valent heterocyclic group. Examples of the heterocyclic thio group include heteroaryl thio groups such as a pyridylthio group, a pyridazinylthio group, a pyrimidylthio group, a pyrazinylthio group, a triazinylthio group and the like; etc.

The amino group means an unsubstituted amino group or an amino group in which a hydrogen atom in the group is substituted by one or two groups selected from the group consisting of an alkyl group, an aryl group, an arylalkyl group and a mono-valent heterocyclic group (hereinafter, referred to as substituted amino group.). A hydrogen atom contained in the above-described alkyl group, aryl group, arylalkyl group and mono-valent heterocyclic group may be further substituted by a substituent selected from the group consisting of an alkyl group, an aryl group, an arylalkyl group and a mono-valent heterocyclic group (hereinafter, referred to as secondary substituent in some cases.). The carbon atom number of the substituted amino group is usually 1 to 60, preferably 2 to 48, more preferably 2 to 40, not including the carbon atom number of the secondary substituent. Examples of the substituted amino group include a methylamino group, a dimethylamino group, an ethylamino group, a diethylamino group, a propylamino group, a dipropylamino group, an isopropylamino group, a diisopropylamino group, a butylamino group, an isobutylamino group, a s-butylamino group, a t-butylamino group, a pentylamino group, a hexylamino group, a heptylamino group, an octylamino group, a 2-ethylhexylamino group, a nonylamino group, a decylamino group, a 3,7-dimethyloctylamino group, a dodecylamino group, a cyclopentylamino group, a dicyclopentylamino group, a cyclohexylamino group, a dicyclohexylamino group, a ditrifluoromethylamino group, a phenylamino group, a diphenylamino group, C₁ to C₁₂ alkoxyphenylamino groups, di(C₁ to C₁₂ alkoxyphenyl)amino groups, C₁ to C₁₂ alkylphenylamino groups, di(C₁ to C₁₂ alkylphenyl)amino groups, a 1-naphthylamino group, a 2-naphthylamino group, a pentafluorophenylamino group, a pyridylamino group, a pyridazinylamino group, a pyrimidylamino group, a pyrazinylamino group, a triazinylamino group, phenyl C₁ to C₁₂ alkylamino groups, C₁ to C₁₂ alkoxyphenyl C₁ to C₁₂ alkylamino groups, di(C₁ to C₁₂ alkoxyphenyl C₁ to C₁₂ alkyl)amino groups, C₁ to C₁₂ alkylphenyl C₁ to C₁₂ alkylamino groups, di(C₁ to C₁₂ alkylphenyl C₁ to C₁₂ alkyl)amino groups, 1-naphthyl-C₁ to C₁₂ alkylamino groups, 2-naphthyl-C₁ to C₁₂ alkylamino groups and the like.

The silyl group means an unsubstituted silyl group or a silyl group in which a hydrogen atom in the group is substituted by one, two or three groups selected from the group consisting of an alkyl group, an aryl group, an arylalkyl group and a mono-valent heterocyclic group (hereinafter, referred to as substituted silyl group.). A hydrogen atom contained in the above-described alkyl group, aryl group, arylalkyl group and mono-valent heterocyclic group may be substituted by a secondary substituent. The carbon atom number of the substituted silyl group is usually 1 to 60, preferably 3 to 48, more preferably 3 to 40, not including the carbon atom number of the secondary substituent. Examples of the substituted silyl group include a trimethylsilyl group, a triethylsilyl group, a tripropylsilyl group, a tri-isopropylsilyl group, a dimethyl-isopropylsilyl group, a diethyl-isopropylsilyl group, a t-butyldimethylsilyl group, a pentyldimethylsilyl group, a hexyldimethylsilyl group, a heptyldimethylsilyl group, an octyldimethylsilyl group, a 2-ethylhexyl-dimethylsilyl group, a nonyldimethylsilyl group, a decyldimethylsilyl group, a 3,7-dimethyloctyl-dimethylsilyl group, a dodecyldimethylsilyl group, phenyl C₁ to C₁₂ alkylsilyl groups, C₁ to C₁₂ alkoxyphenyl C₁ to C₁₂ alkylsilyl groups, C₁ to C₁₂ alkylphenyl C₁ to C₁₂ alkylsilyl groups, 1-naphthyl C₁ to C₁₂ alkylsilyl groups, 2-naphthyl C₁ to C₁₂ alkylsilyl groups, phenyl C₁ to C₁₂ alkyldimethylsilyl groups, a triphenylsilyl group, a tri-p-xylylsilyl group, a tribenzylsilyl group, a diphenylmethylsilyl group, a t-butyldiphenylsilyl group, a dimethylphenylsilyl group and the like.

The acyl group means an unsubstituted acyl group or an acyl group in which a hydrogen atom in the group is substituted by a halogen atom and the like. The carbon atom number of the acyl group is usually 2 to 20, preferably 2 to 18, more preferably 2 to 16. Examples of the acyl group include an acetyl group, a propionyl group, a butyryl group, an isobutyryl group, a pivaloyl group, a benzoyl group, a trifluoroacetyl group, a pentafluorobenzoyl group and the like.

The acyloxy group means an unsubstituted acyloxy group or an acyloxy group in which a hydrogen atom in the group is substituted by a halogen atom and the like. The carbon atom number of the acyloxy group is usually 2 to 20, preferably 2 to 18, more preferably 2 to 16. Examples of the acyloxy group include an acetoxy group, a propionyloxy group, a butyryloxy group, an isobutyryloxy group, a pivaloyloxy group, a benzoyloxy group, a trifluoroacetyloxy group, a pentafluorobenzoyloxy group and the like.

The imine residue means a residue obtained by removing one hydrogen atom from an imine compound having a structure represented by at least one of the formula: H-N=C< and the formula: -N=CH-. Examples of such an imine compound include aldimines, ketimines, and compounds in which a hydrogen atom bonded to a nitrogen atom in an aldimine is substituted by an alkyl group, an aryl group, an arylalkyl group, an arylalkenyl group, an arylalkynyl group and the like. The carbon atom number of the imine residue is usually 2 to 20, preferably 2 to 18, more preferably 2 to 16. Examples of the imine residue include groups represented by the general formula: -CR"=N-R "' or the general formula: -N=C(R"')₂ (wherein R" represents a hydrogen atom, an alkyl group, an aryl group, an arylalkyl group, an arylalkenyl group or an arylalkynyl group, R"' represents an alkyl group, an aryl group, an arylalkyl group, an arylalkenyl group or an arylalkynyl group, providing that when two R"'s are present, these may be the same or mutually different and two R"'s may be mutually connected and integrated to form a ring as a di-valent group, for example, an alkylene group having 2 to 18 carbon atoms such as an ethylene group, a trimethylene group, a tetramethylene group, a pentamethylene group, a hexamethylene group and the like.), and the like. Examples of the imine residue include groups represented by the following structural formulae, and the like. 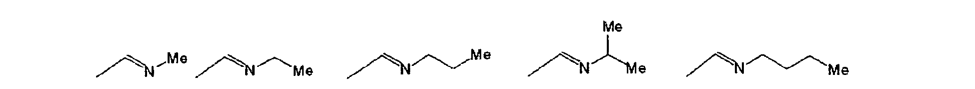 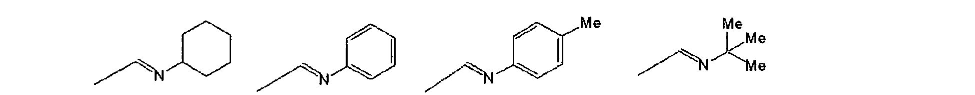 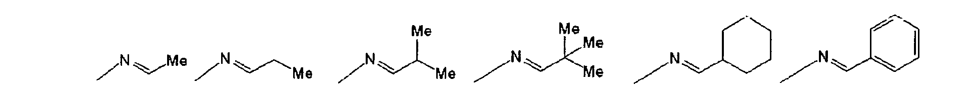 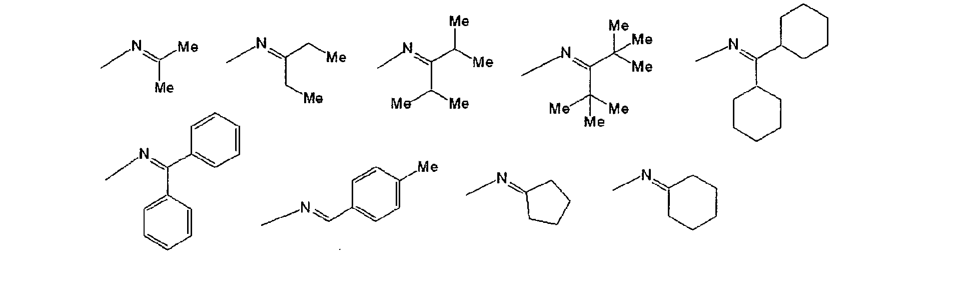 (wherein Me represents a methyl group.)

The amide group means an unsubstituted amide group or an amide group in which a hydrogen atom in the group is substituted by a halogen atom and the like. The carbon atom number of the amide group is usually 2 to 20, preferably 2 to 18, more preferably 2 to 16. Examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group, a dipentafluorobenzamide group and the like.

The acid imide group means a residue obtained by removing from an acid imide a hydrogen atom bonded to its nitrogen atom. The carbon atom number of the acid imide group is usually 4 to 20, preferably 4 to 18, more preferably 4 to 16. Examples of the acid imide group include groups shown below and the like. 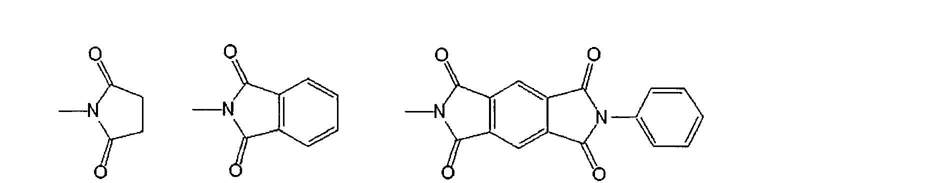 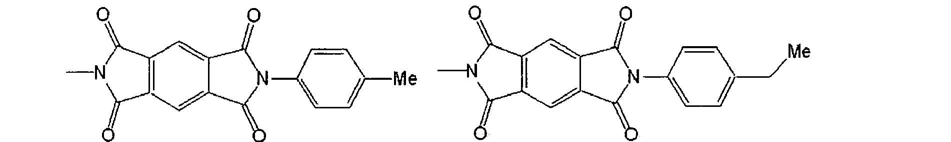 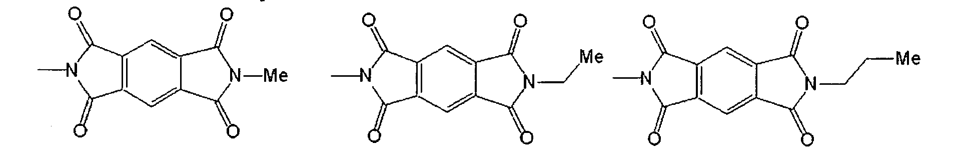 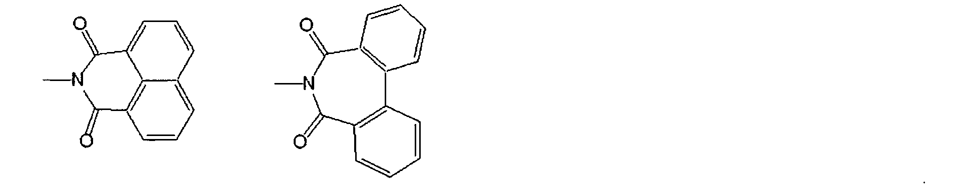 (wherein Me represents a methyl group.).

The carboxyl group means an unsubstituted carboxyl group or a carboxyl group in which a hydrogen atom in the group is substituted by a substituent such as an alkyl group, an aryl group, an arylalkyl group, a mono-valent heterocyclic group and the like (hereinafter, referred to as a substituted carboxyl group). The substituent may have a secondary substituent. The carbon atom number of the substituted carboxyl group is usually 1 to 60, preferably 2 to 48, more preferably 2 to 45, not including the carbon atom number of the secondary substituent. Examples of the substituted carboxyl group include a methoxycarbonyl group, an ethoxycarbonyl group, a propoxycarbonyl group, an isopropoxycarbonyl group, a butoxycarbonyl group, an isobutoxycarbonyl group, a s-butoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, a pyridyloxycarbonyl group and the like.

R¹, R², R³, R⁴, R⁵ and R⁶ in the formula (I-1) represent preferably a hydrogen atom, an alkyl group, an alkoxy group, an alkylthio group, an aryl group, an aryloxy group, an arylthio group or a heterocyclic thio group, more preferably a hydrogen atom, an alkyl group, an alkoxy group, an aryl group or an aryloxy group, further preferably a hydrogen atom, an alkyl group or an aryl groups, from the standpoint of easiness of synthesis of a raw material monomer.

m and n in the formula (I-1) may be the same or mutually different, and represent 2 or 3. It is preferable and m and n are identical and it is more preferable that m and n represent 2, from the standpoint of easiness of synthesis of a raw material monomer.

X¹, X² and X³ represent preferably an oxygen atom or a sulfur atom, more preferably a sulfur atom, for light emission of a polymer light emitting device using the copolymer of the present invention for a longer period of time.

Examples of the repeating unit represented by the formula (I-1) include repeating units represented by the formulae (I-1-1) to (I-1-46), and the like. 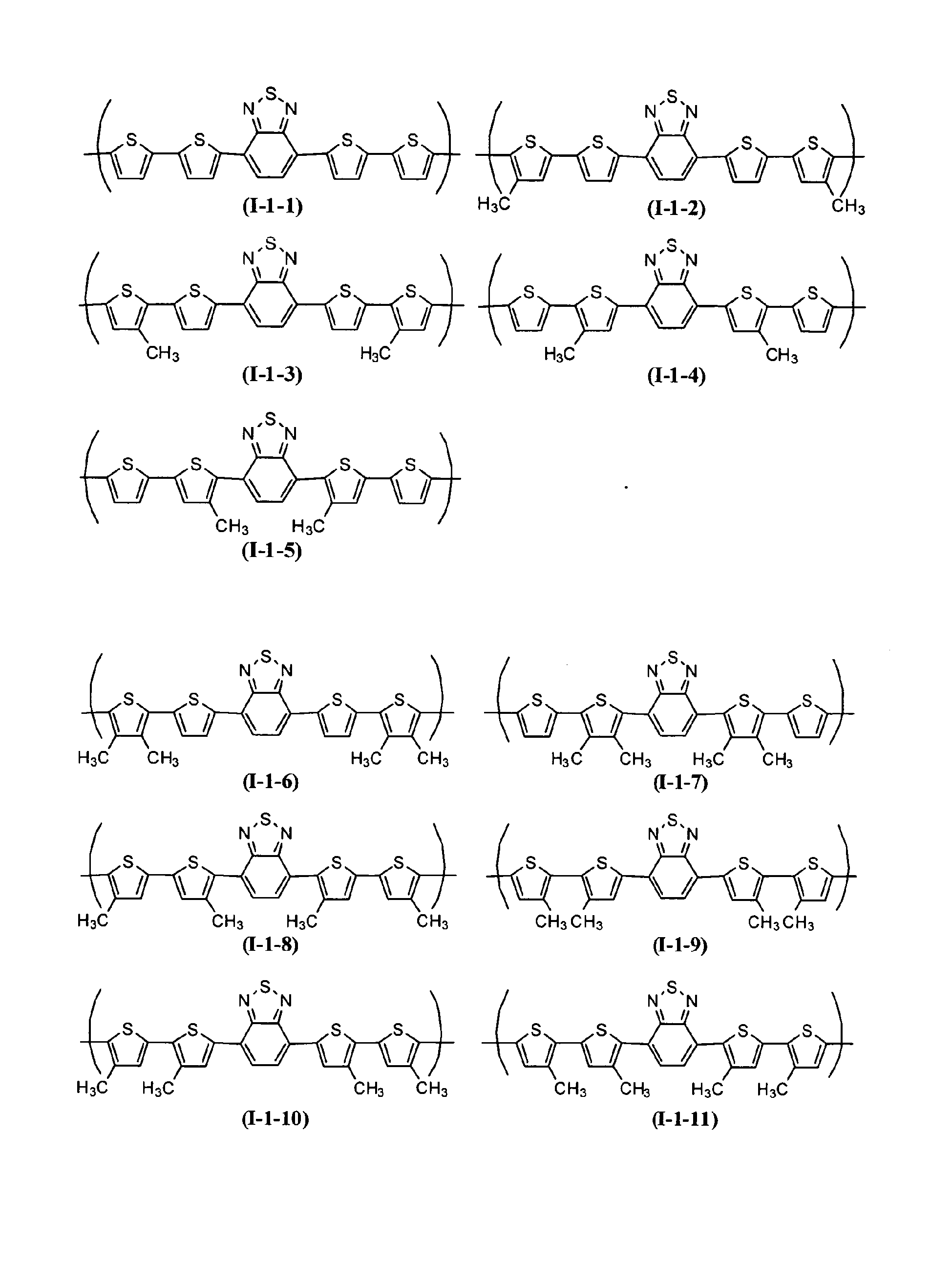 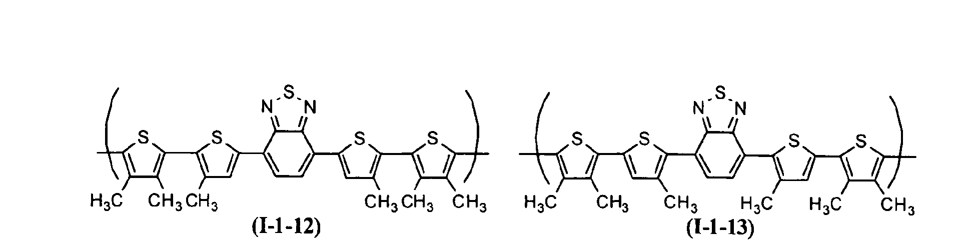 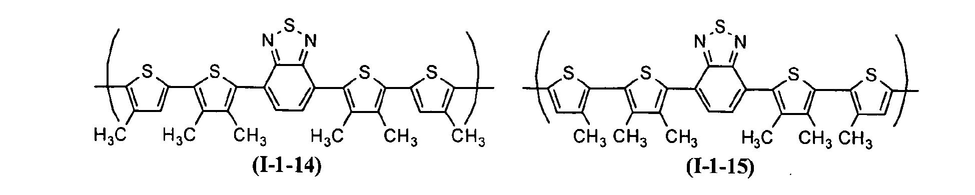 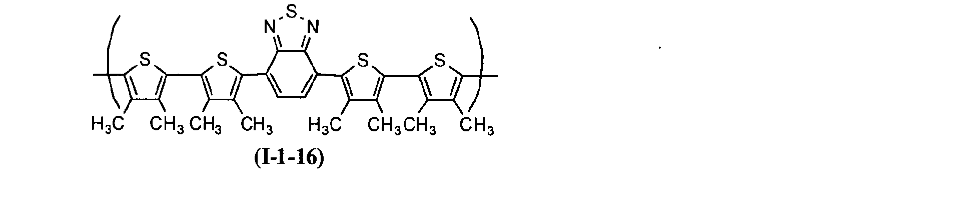 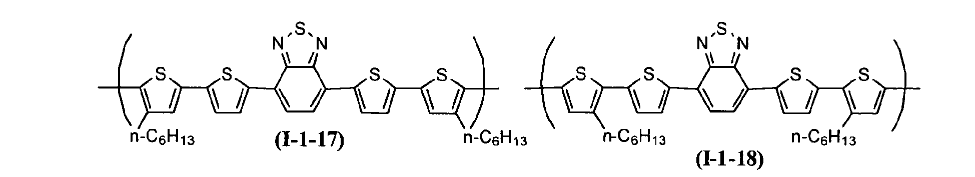 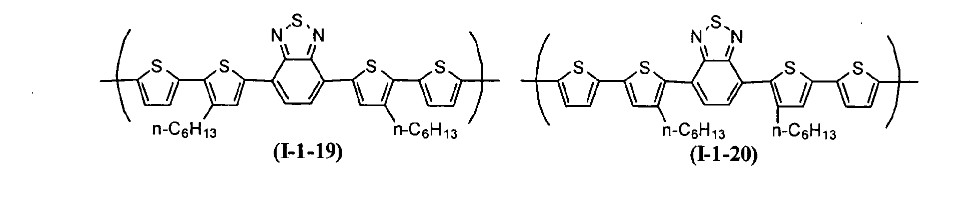 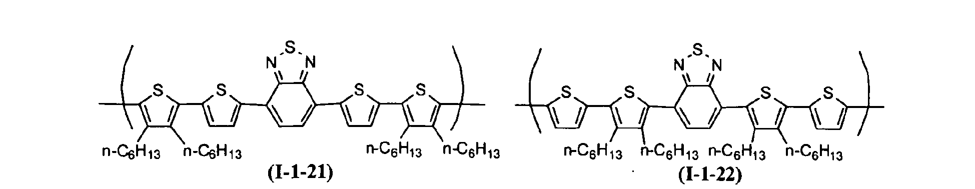 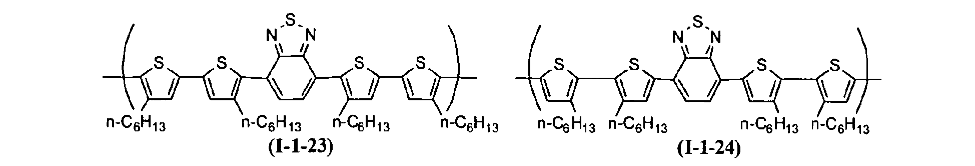 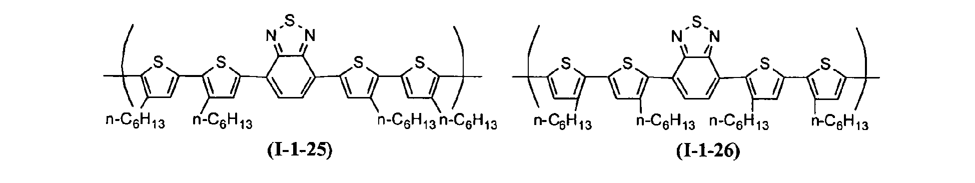 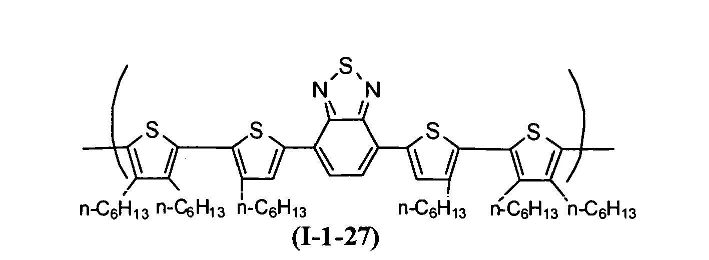 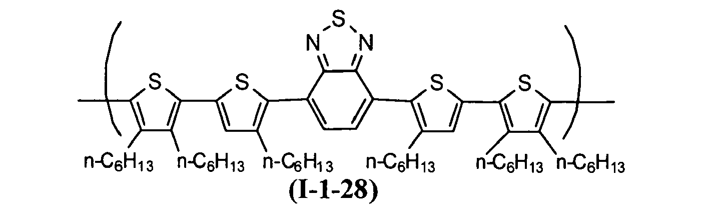 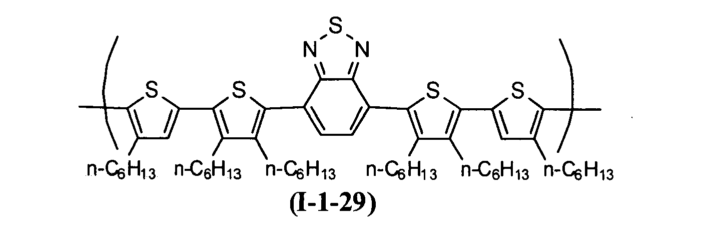 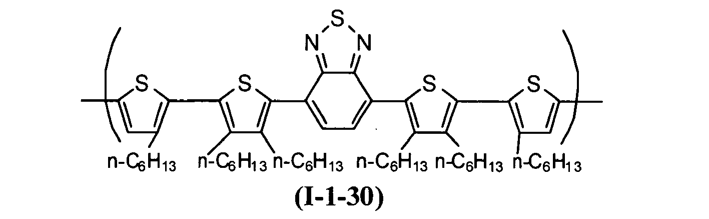 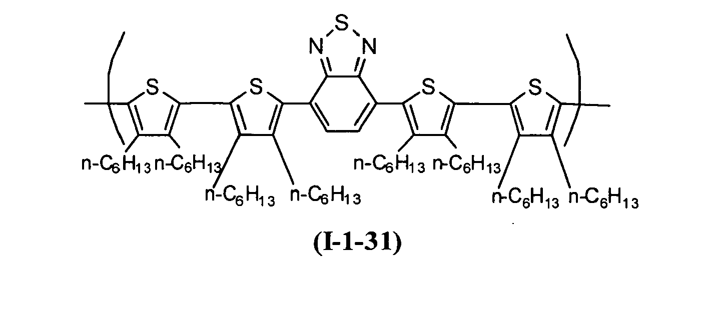 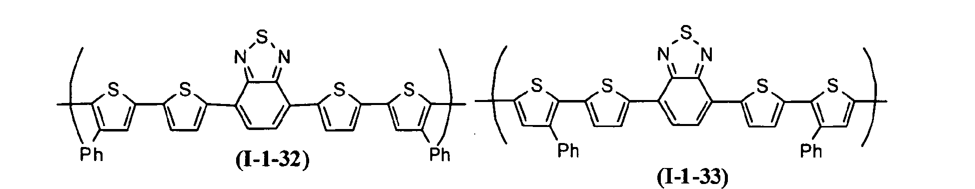 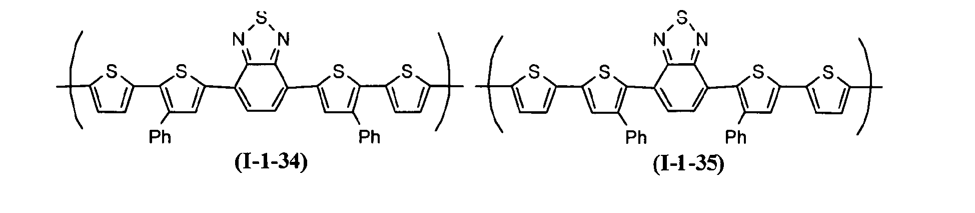 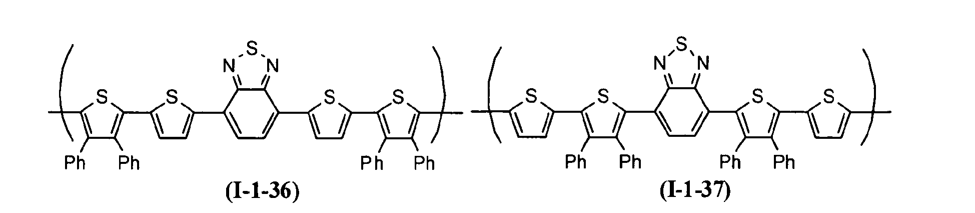 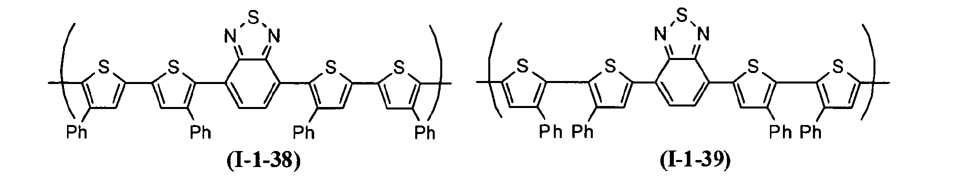 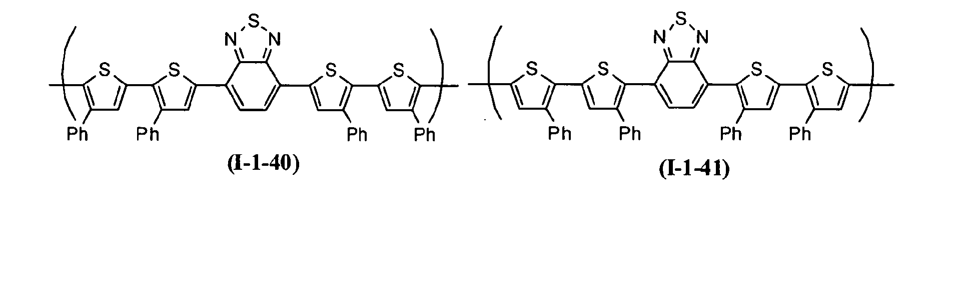 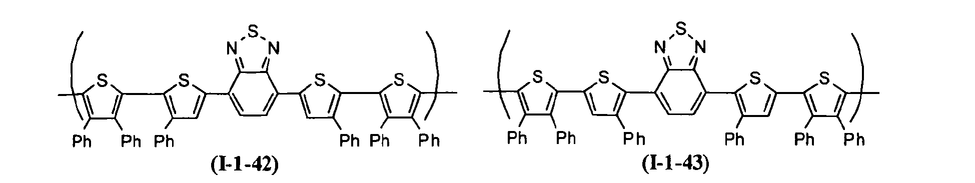 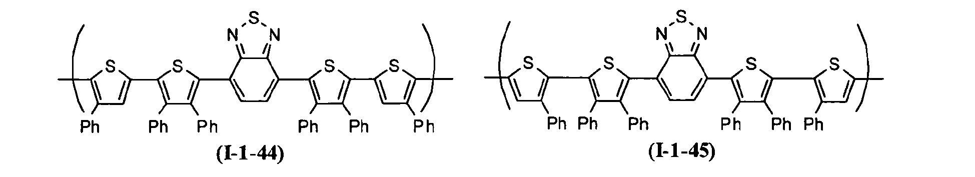 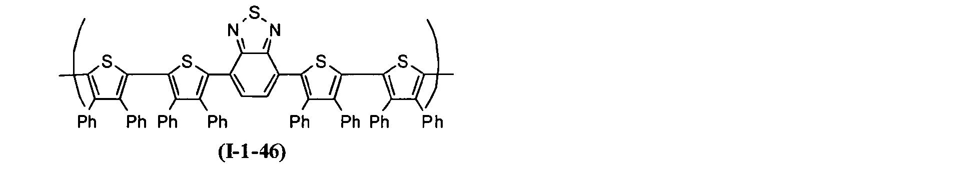 (In the formulae (I-1-32) to (I-1-46), Ph represents a phenyl group.).

The copolymer of the present invention may contain in the block (A) one or two or more repeating units represented by the formula (I-1) and one or two or more repeating units represented by the formula (II), respectively. The copolymer of the present invention may contain in the block (A') one or two or more repeating units represented by the formula (I-1).

The arylene group represented by Ar¹ is an atomic group remaining after removing from an aromatic hydrocarbon two hydrogen atoms bonded to a carbon atom constituting the aromatic ring, and means an unsubstituted arylene group or a substituted arylene group. The arylene group includes also those having a condensed ring, and those having two or more independent benzene rings or condensed rings connected by a single bond or via a di-valent organic group, for example, an alkenylene group such as a vinylene group and the like. The substituent in the substituted arylene group is preferably a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, from the standpoint of the solubility and fluorescence property of the copolymer, easiness of synthesis of the copolymer, the heat resistance of a polymer light emitting device, and the like. Examples of the alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclic thio group, amino group, silyl group, acyl group, acyloxy group, imine residue, amide group, acid imide group and carboxyl group include the same groups as explained for R¹. The halogen atom includes the same halogen atoms as explained for R¹.

The carbon atom number of a portion of the arylene group excluding the substituent is usually 6 to 60, preferably 6 to 20, more preferably 6 to 18. The total carbon atom number of the arylene group including the substituent is 6 to 100, preferably 6 to 80, more preferably 6 to 70.

The arylene group includes a phenylene group (the following formulae 1 to 3), a naphthalene-diyl group (the following formulae 4 to 13), an anthracene-diyl group (the following formulae 14 to 19), a biphenyl-diyl group (the following formulae 20 to 25), a ter-phenyl-diyl group (the following formulae 26 to 28), a fluorene-diyl group (the following formulae 36 to 38), a benzofluorene-diyl group (the following formulae 39 to 46), and other di-valent condensed poly-cyclic aromatic hydrocarbon groups (the following formulae 29 to 35), and the like.

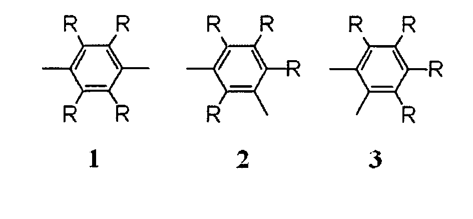

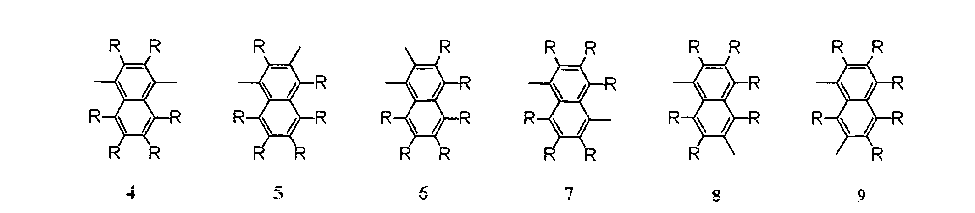

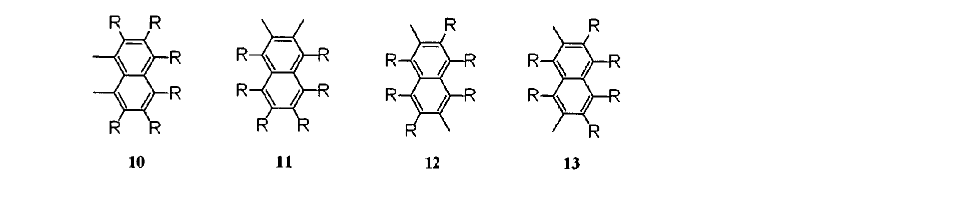

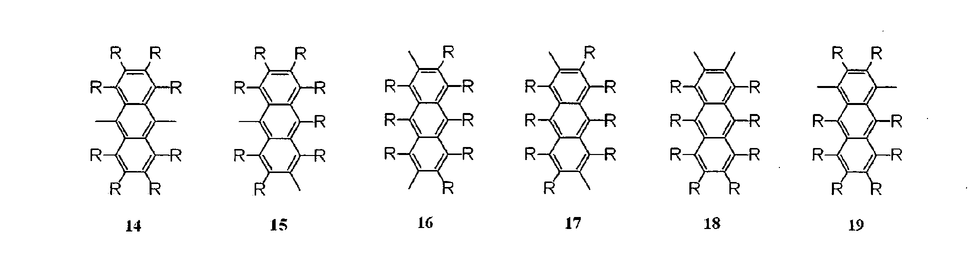

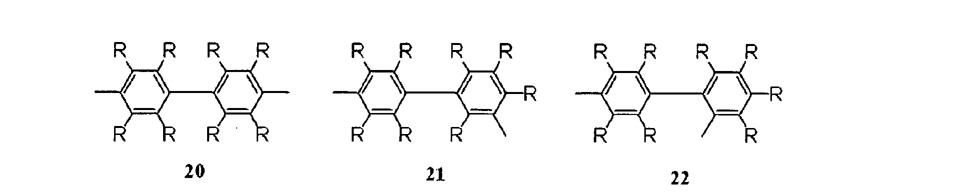

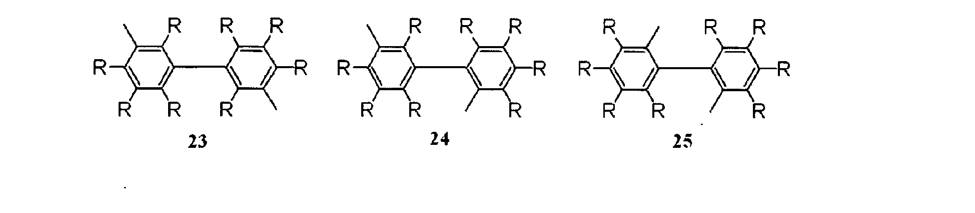

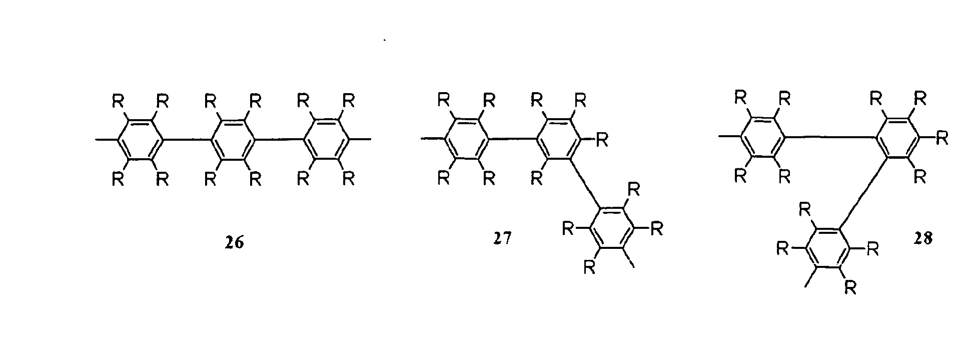

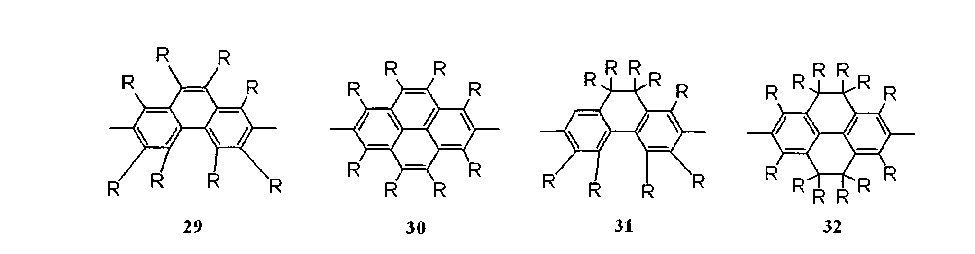

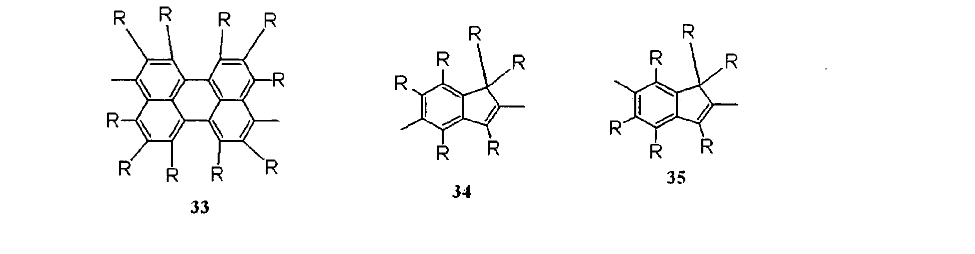

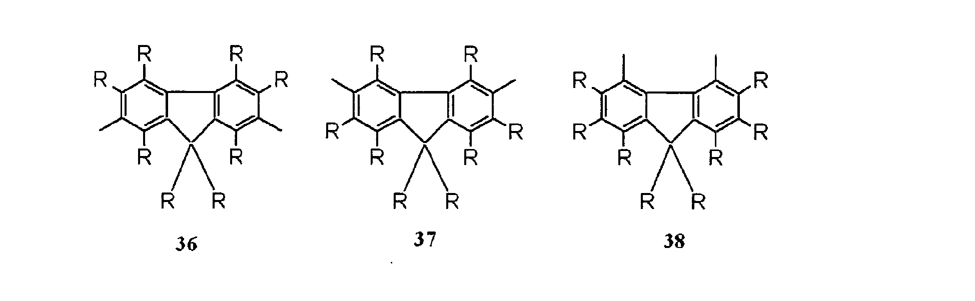

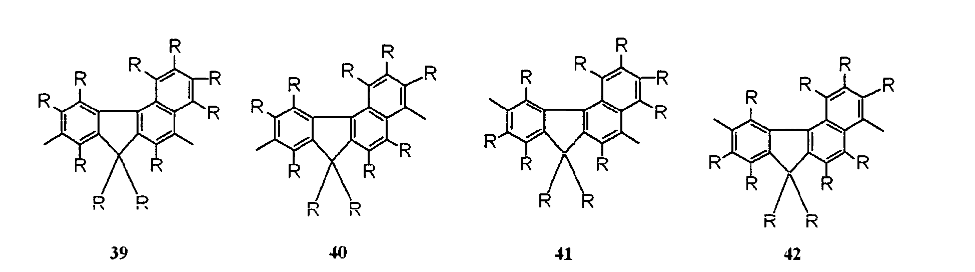

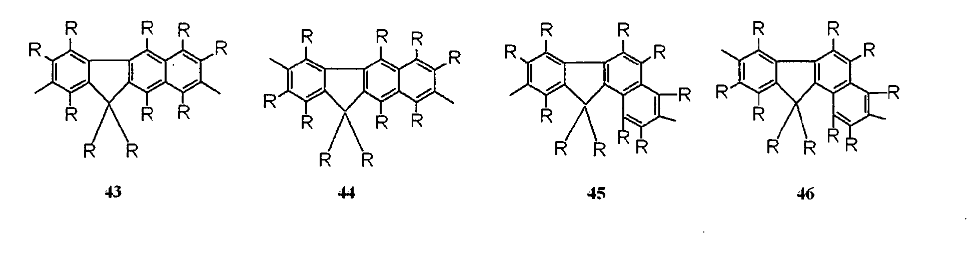

In the above-described formulae 1 to 46, R represents a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group. Examples of the alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclic thio group, amino group, silyl group, acyl group, acyloxy group, imine residue, amide group, acid imide group and carboxyl group include the same groups as explained for R¹. The halogen atom includes the same halogen atoms as explained for R¹.

Ar¹ in the formula (II) is preferably a group represented by the formula (IV), for light emission of a polymer light emitting device using the copolymer of the present invention for a longer period of time. 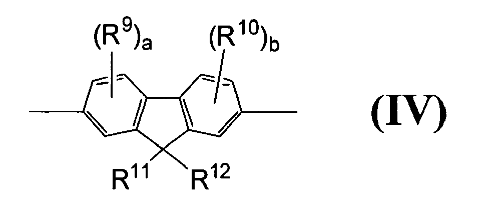 (wherein R⁹ and R¹⁰ may be the same or mutually different and represent a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, R¹¹ and R¹² may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, and a and b may be the same or mutually different and represent an integer of 0 to 3. When there exist a plurality of R⁹s, these may be the same or mutually different. When there exist a plurality of R¹⁰s, these may be the same or mutually different.)

The alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclic thio group, amino group, silyl group, acyl group, acyloxy group, imine residue, amide group, acid imide group and carboxyl group represented by R⁹, R¹⁰, R¹¹ and R¹² in the formula (IV) include the same groups as explained for R¹. The halogen atom includes the same halogen atoms as explained for R¹.

R⁹ and R¹⁰ in the formula (IV) represent preferably an aryl group or an alkyl group, for light emission of a polymer light emitting device using the copolymer of the present invention for a longer period of time.
a and b in the formula (IV) represent preferably 0 or 1, more preferably 0, from the standpoint of easiness of synthesis of a raw material monomer.

R¹¹ and R¹² in the formula (IV) represent preferably an alkyl group or an aryl group, from the standpoint of easiness of synthesis of a raw material monomer.

Examples of the group represented by the formula (IV) include groups represented by the following the formulae (IV-1) to (IV-15), and the like.

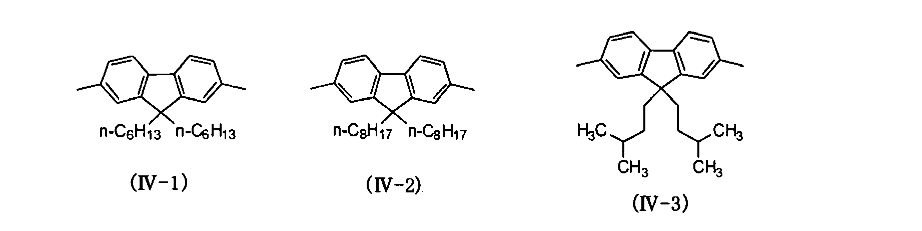

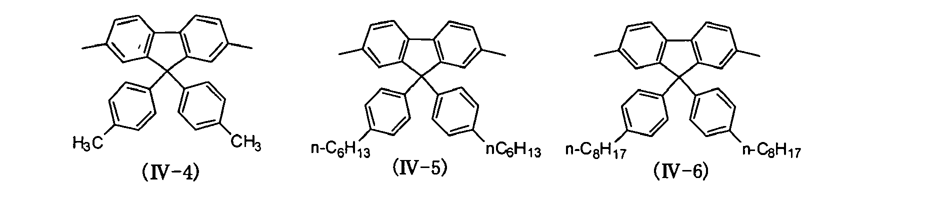

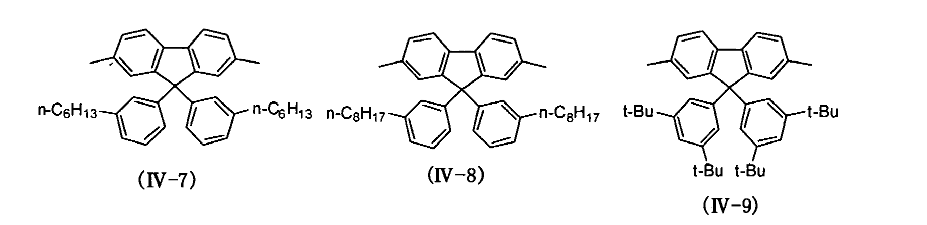

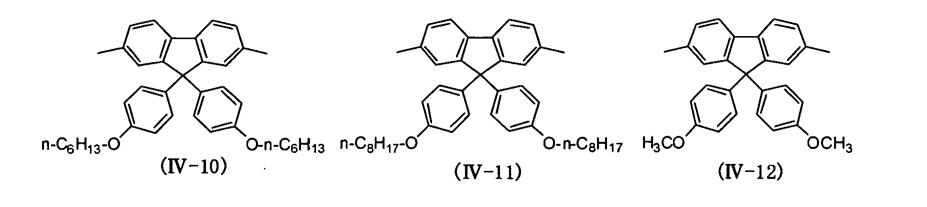

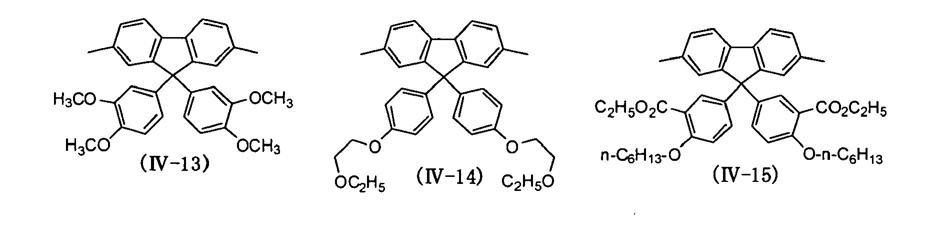

The block (A) which can be contained in the copolymer of the present invention further contains preferably a repeating unit represented by the formula (I-2), more preferably two or more repeating units represented by the formula (I-2). 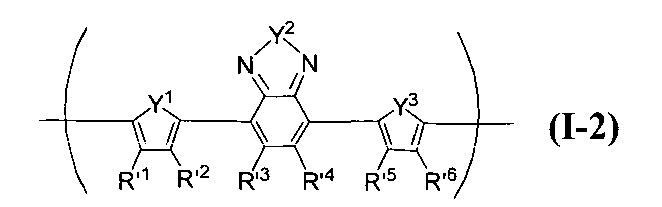 (wherein Y¹, Y² and Y³ may be the same or mutually different and represent an oxygen atom, a sulfur atom or -C(R'⁷)=C(R'⁸)-, and R'¹, R'², R'³, R'⁴, R'⁵, R'⁶, R'¹ and R'⁸ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group.).

The alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclic thio group, amino group, silyl group, acyl group, acyloxy group, imine residue, amide group, acid imide group and carboxyl group represented by R'¹, R'², R'³, R'⁴, R'⁵, R'⁶, R'⁷ and R'⁸ in the formula (1-2) include the same groups as explained for R¹. The halogen atom includes the same halogen atoms as explained for R¹.

R'¹, R,², R'³, R'⁴, R'⁵ and R'⁶ in the formula (1-2) may be the same or mutually different and represent preferably a hydrogen atom, an alkyl group, an alkoxy group, an alkylthio group, an aryl group, an aryloxy group, an arylthio group or a heterocyclic thio group, more preferably a hydrogen atom, an alkyl group, an alkoxy group, an aryl group or an aryloxy group, further preferably a hydrogen atom, an alkyl group or an aryl group, from the standpoint of easiness of synthesis of a raw material monomer.

Y¹ , Y² and Y³ in the formula (1-2) represent preferably an oxygen atom or a sulfur atom, more preferably a sulfur atom, for light emission of a polymer light emitting device using the copolymer of the present invention for a longer period of time.

Examples of the repeating unit represented by the formula (I-2) include repeating units represented by the formulae (I-2-1) to (I-2-8), and the like.

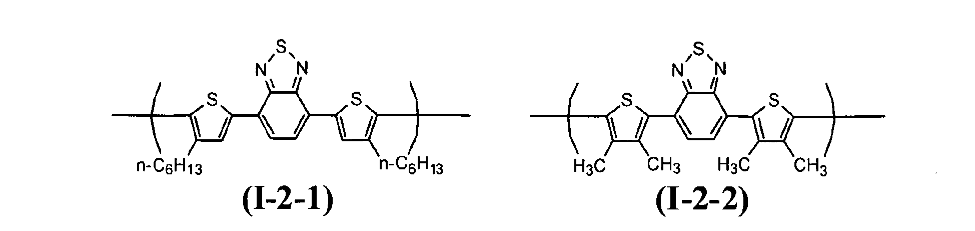

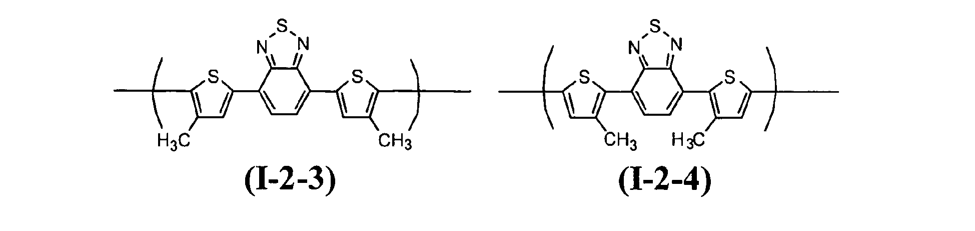

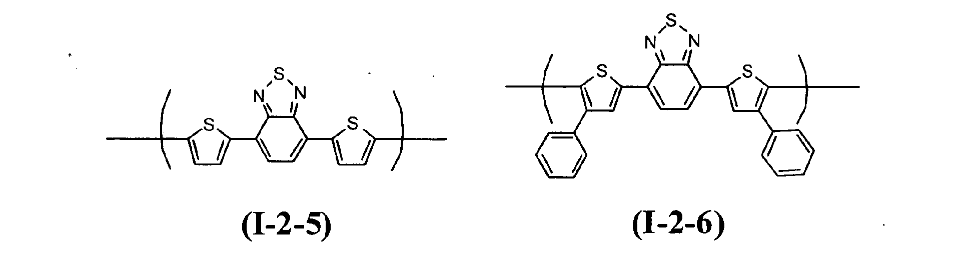

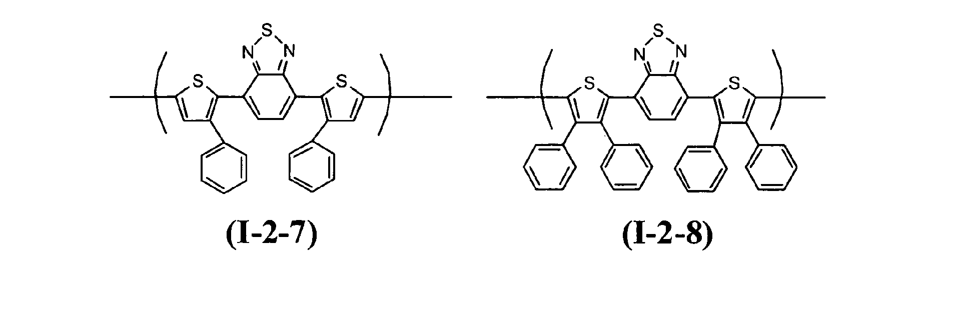

When the block (A) contains two repeating units represented by the formula (I-2), examples of the combination thereof include a combination of a repeating unit represented by the formula (I-2-1) with a repeating unit represented by the formula (I-2-5), a combination of a repeating unit represented by the formula (I-2-3) with a repeating unit represented by the formula (I-2-5), a combination of a repeating unit represented by the formula (I-2-4) with a repeating unit represented by the formula (I-2-5), a combination of a repeating unit represented by the formula (I-2-6) with a repeating unit represented by the formula (I-2-5), a combination of a repeating unit represented by the formula (I-2-1) with a repeating unit represented by the formula (I-2-3), a combination of a repeating unit represented by the formula (I-2-1) with a repeating unit represented by the formula (I-2-6), a combination of a repeating unit represented by the formula (I-2-3) with a repeating unit represented by the formula (I-2-6), a combination of a repeating unit represented by the formula (I-2-4) with a repeating unit represented by the formula (I-2-7), and the like.

The amount of a repeating unit represented by the formula (I-1) is preferably 0.1 to 40 mol, the amount of a repeating unit represented by the formula (I-2) is preferably 10 to 50 mol, and the amount of a repeating unit represented by the formula (II) is preferably 10 to 70 mol, when the amount of all repeating units in the block (A) is 100 mol.

### <Block (B) >

The copolymer of the present invention preferably has a block (B) containing a repeating unit represented by the formula (II) and a repeating unit represented by the formula (III), from the standpoint of high solubility, from the standpoint of easier fabrication of a film and from the standpoint of light emission of a polymer light emitting device using the copolymer for a longer period of time. The block (B) may contain two or more repeating units represented by the formula (III).

-(Ar²)- (III)

(wherein Ar² represents a di-valent aromatic amine residue.).

The di-valent aromatic amine residue denotes an atomic group remaining after removing from an aromatic amine two hydrogen atoms bonded to a carbon atom constituting the aromatic ring, and means an unsubstituted di-valent aromatic amine residue or a substituted di-valent aromatic amine residue. The substituent in the substituted di-valent aromatic amine residue includes a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group. The alkyl groups, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclic thio group, amino group, silyl group, acyl group, acyloxy group, imine residue, amide group, acid imide group and carboxyl group include the same groups as explained for R¹. The halogen atom includes the same halogen atoms as explained for R¹. The carbon atom number of the di-valent aromatic amine residue is usually 5 to 100, preferably 15 to 80, more preferably 15 to 60, not including the carbon atom number of the substituent.

Examples of the di-valent aromatic amine residue include groups represented by the following formulae 401 to 412, and the like.

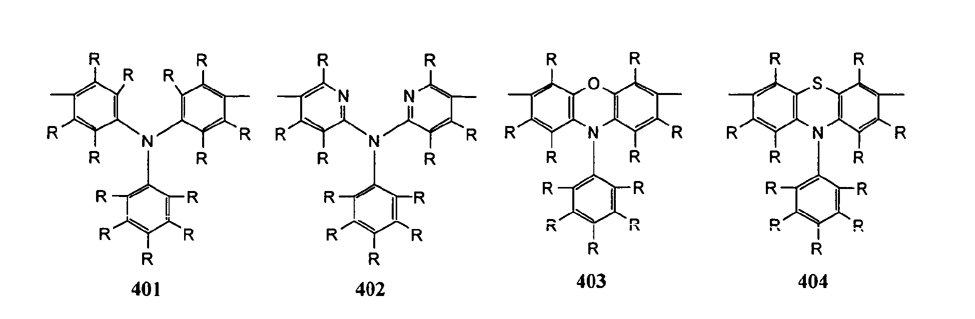

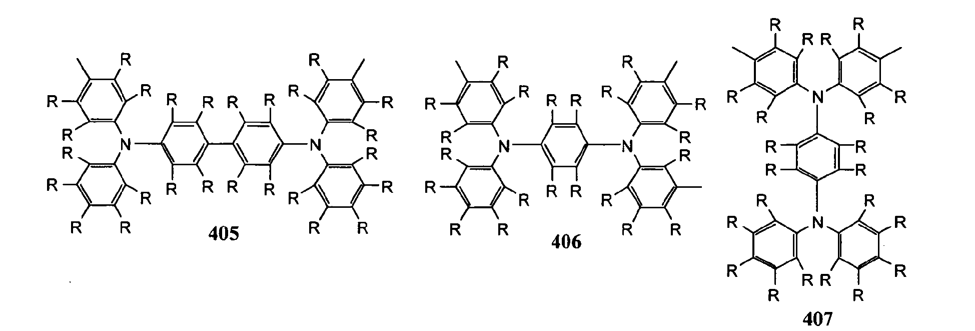

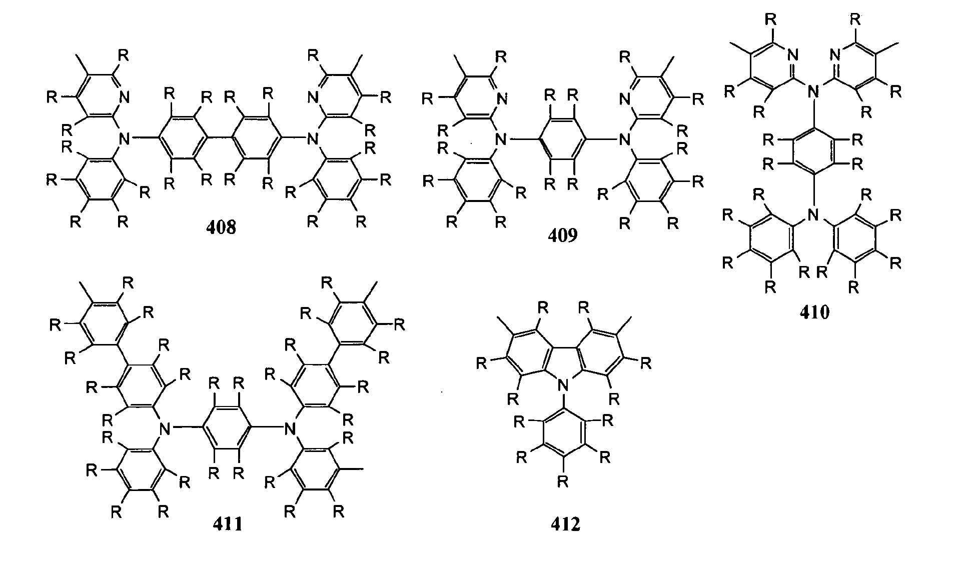

(In the formulae 401 to 412, R represents the same meaning as described above. A plurality of Rs may be the same or mutually different.).

Ar² in the formula (III) is preferably a group represented by the formula (V-1), a group represented by the formula (V-2) or a group represented by the formula (V-3), from the standpoint of light emission of a polymer light emitting device for a longer period of time and from the standpoint of light emission with high luminance in driving at low voltage. 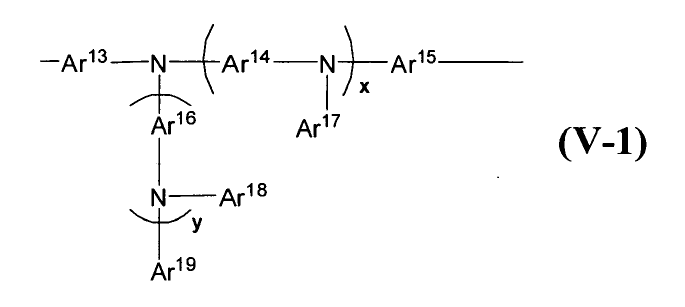 (wherein Ar¹³, Ar¹⁴, Ar¹⁵ and Ar¹⁶ may be the same or mutually different and represent an arylene group or a di-valent heterocyclic group. Ar¹⁷, Ar¹⁸ and Ar¹⁹ may be the same or mutually different and represent an aryl group or a mono-valent heterocyclic group. x and y may be the same or mutually different and represent 0 or 1, providing that 0≤x+y≤1.) 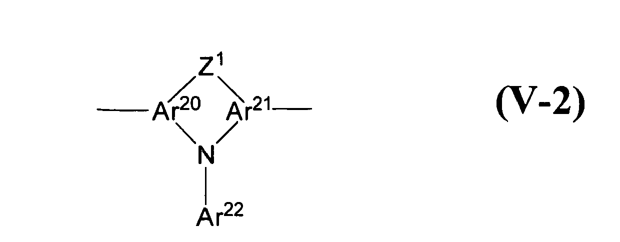 (wherein Ar²⁰ and Ar²¹ may be the same or mutually different and represent a tri-valent aromatic hydrocarbon group or a tri-valent heterocyclic group. Ar²² represents an aryl group or a mono-valent heterocyclic group. Z¹ represents an oxygen atom, a sulfur atom, -C(R^{z1})=C(R^{z2})-, -C(R^{z3})(R^{z4})-, -N(R ^{Z5})- or a direct bond (a single bond directly connecting Ar²⁰ and Ar²¹) . R^{z1} , R^{z2}, R^{z3}, R^{z4} and R^{Z5} may be the same or mutually different and represent a hydrogen atom, a halogen atom, an alkyl group, an aryl group or a mono-valent heterocyclic group.) 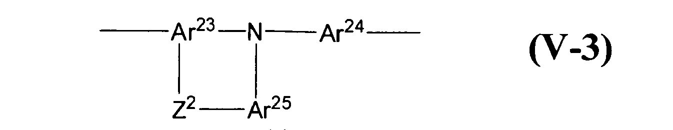 (wherein Ar²³ represents a tri-valent aromatic hydrocarbon group or a tri-valent heterocyclic group. Ar²⁴ and Ar²⁵ may be the same or mutually different and represent an arylene group or a di-valent heterocyclic group. Z² represents an oxygen atom, a sulfur atom, -C(R^{z6})=C(R^{z7})-, -C(R^{z8}) (R^{z9})-, -N(R^{z10})- or a direct bond (a single bond directly connecting Ar²³ and Ar²⁵) . R^{z6}, R^{z7}, R^{z8}, R^{z9} and R^{z10} may be the same or mutually different and represent a hydrogen atom, a halogen atom, an alkyl group, an aryl group or a mono-valent heterocyclic group.).

The arylene group represented by Ar¹³, Ar¹⁴, Ar¹⁵, Ar¹⁶, Ar²⁴ and Ar²⁵ in the formulae (V-1) to (V-3) includes the same groups as explained for Ar¹.

The di-valent heterocyclic group represented by Ar¹³, Ar¹⁴, Ar¹⁵ , Ar¹⁶, Ar²⁴ and Ar²⁵ in the formulae (V-1) to (V-3) denotes an atomic group remaining after removing from a heterocyclic compound two hydrogen atoms, and means an unsubstituted di-valent heterocyclic group or a di-valent heterocyclic group in which a hydrogen atom in the group is substituted by a substituent such as an alkyl group and the like. Examples of the di-valent heterocyclic group include a thiophene-diyl group, a C₁ to C₁₂ alkylthiophene-diyl group, a pyrrole-diyl group, a N-C₁ to C₁₂ alkylpyrrole-diyl group, a furane-diyl group, a pyridine-diyl group, a C₁ to C₁₂ alkylpyridine-diyl group, a pyridazine-diyl group, a piperidine-diyl group, a pyrimidine-diyl group, a triazine-diyl group, a quinoline-diyl group, an isoquinoline-diyl group, a quinoxaline-diyl group and the like.

The aryl group and the mono-valent heterocyclic group represented by Ar¹⁷, Ar¹⁸, Ar¹⁹ and Ar²² in the formulae (V-1) to (V-3) include the same groups as explained for R¹.

The tri-valent aromatic hydrocarbon group represented by Ar²⁰, Ar²¹ and Ar²³ in the formulae (V-2) and (V-3) means an atomic group remaining after removing from an unsubstituted or substituted aromatic hydrocarbon three hydrogen atoms bonded to a carbon atom constituting the aromatic ring. Examples of the tri-valent aromatic hydrocarbon group include a benzene-triyl group, a naphthalene-triyl group, an anthracene-triyl group, a biphenyl-triyl group, a terphenyl-triyl group, a fluorene-triyl group, a benzofluorene-triyl group and the like.

The tri-valent heterocyclic group represented by Ar²⁰, Ar²¹ and Ar²³ in the formulae (V-2) and (V-3) denotes an atomic group remaining after removing from a heterocyclic compound three hydrogen atoms, and means an unsubstituted tri-valent heterocyclic group or a tri-valent heterocyclic group in which a hydrogen atom in the group is substituted by a substituent such as an alkyl group and the like. Examples of the tri-valent heterocyclic group include a thiophene-triyl group, a C₁ to C₁₂ alkylthiophene-triyl group, a pyrrole-triyl group, a N-C₁ to C₁₂ alkylpyrroletriyl group, a furane-triyl group, a pyridine-triyl group, a C₁ to C₁₂ alkylpyridine-triyl group, a pyridazine-triyl group, a piperidine-triyl group, a pyrimidine-triyl group, a quinoline-triyl group, an isoquinoline-triyl group, a quinoxaline-triyl group and the like.

The alkyl group, aryl group and mono-valent heterocyclic group represented by R^{z1}, R^{z2}, R^{z3}, R^{z4}, R^{z5}, R^{z6}, R^{z7}, R^{z8}, R^{z9} and R^{z10} in the formulae (V-2) and (V-3) include the same groups as the groups explained for R¹.

The halogen atom represented by R^{z1}, R^{z2}, R^{z3} R^{z4} R^{z5}, R^{z6}, R^{z7}, R^{z8}, R^{z9} and R^{z10} in the formulae (V-2) and (V-3) include the same atoms as explained for R¹.

It is preferable that Z¹ and N bond to adjacent atoms constituting the Ar²⁰ ring and Z¹ and N bond to adjacent atoms constituting the Ar²¹ ring in the formula (V-2).

It is preferable that Z² and N bond to adjacent atoms constituting the Ar²³ ring and Z² and N bond to adjacent atoms constituting the Ar²⁵ ring in the formula (V-2).

Z¹ in the formula (V-2) represents preferably an oxygen atom, a sulfur atom or -N(R^{z5})-, for reinforcing the functions of hole injection and hole transportation in a polymer light emitting device using the copolymer of the present invention.

Z² in the formula (V-3) represents preferably an oxygen atom, a sulfur atom or -N(R^{z10})-, for reinforcing the functions of hole injection and hole transportation in a polymer light emitting device using the copolymer of the present invention.

Examples of the group represented by the formula (V-1), the group represented by the formula (V-2) or the group represented by the formula (V-3) include groups represented by the following formulae 421 to 458, and the like.

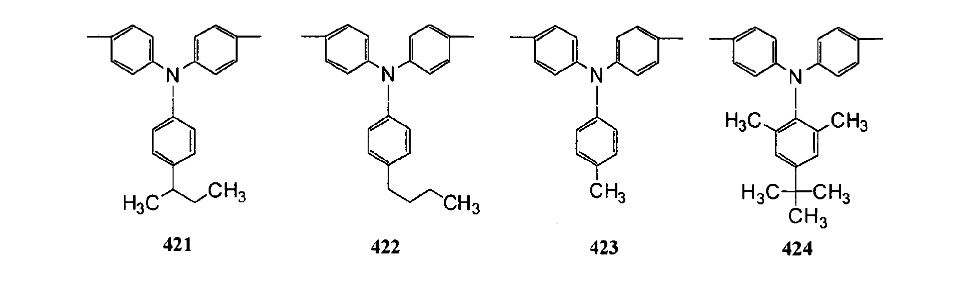

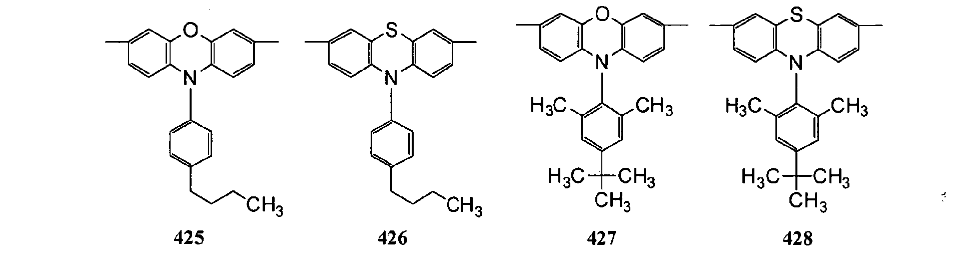

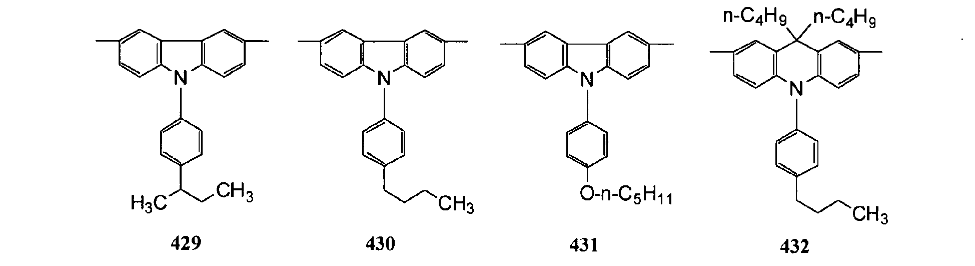

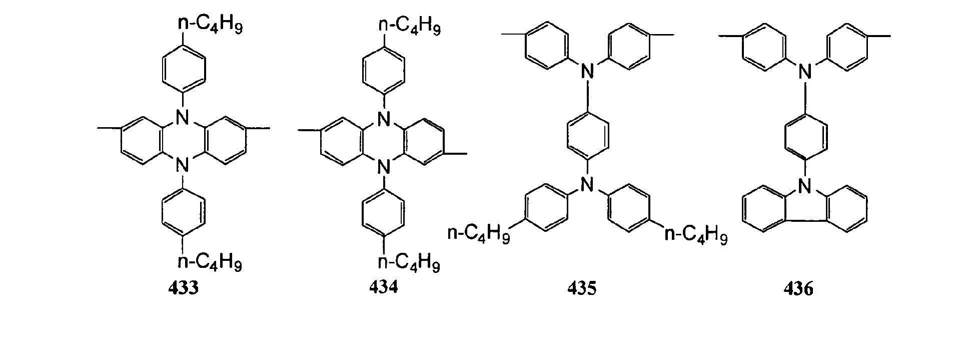

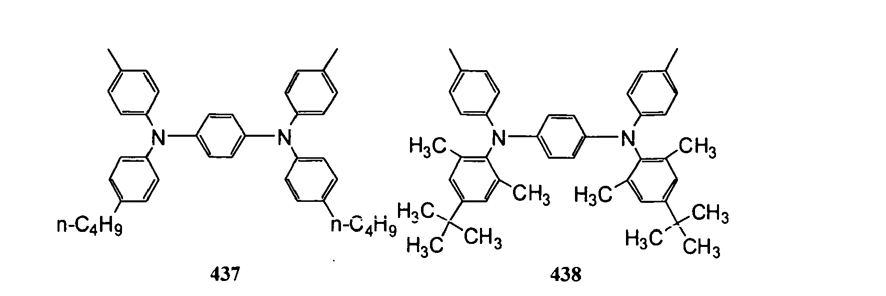

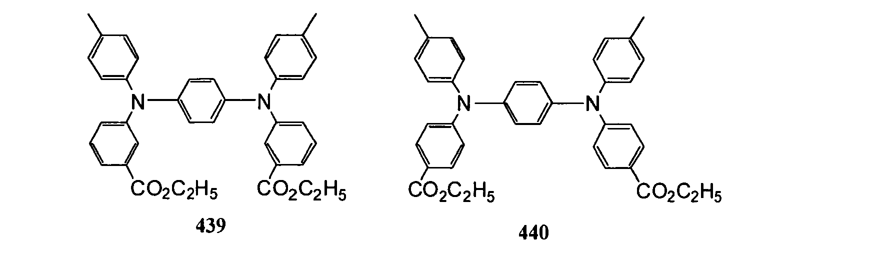

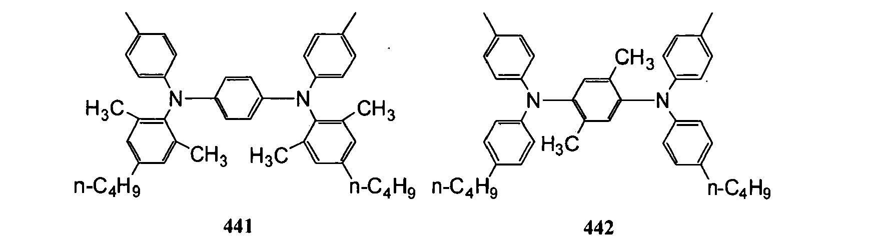

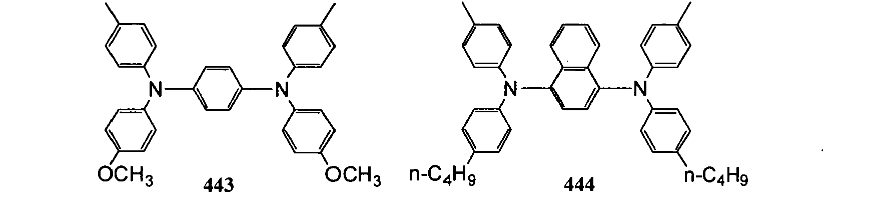

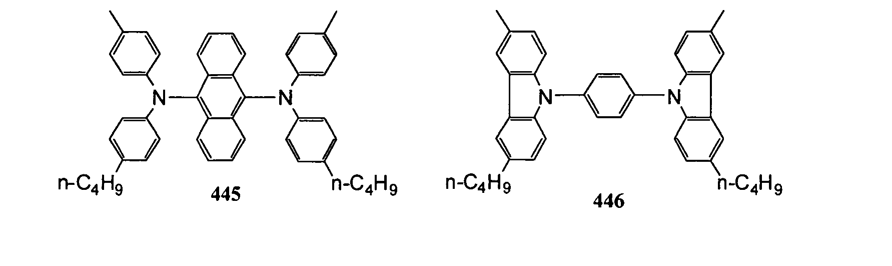

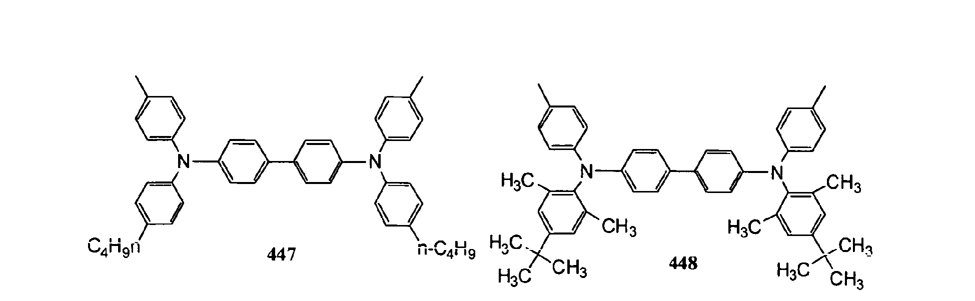

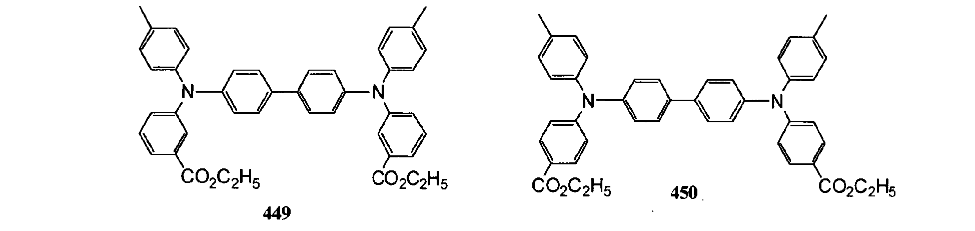

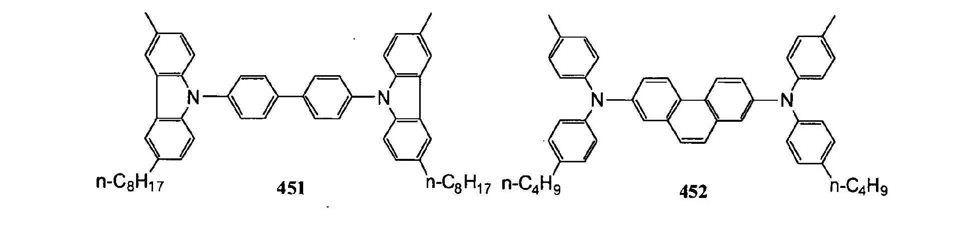

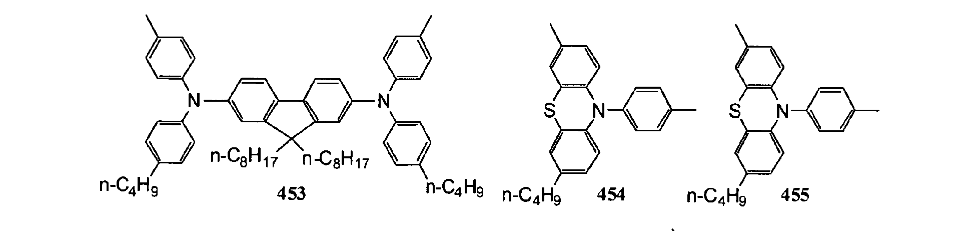

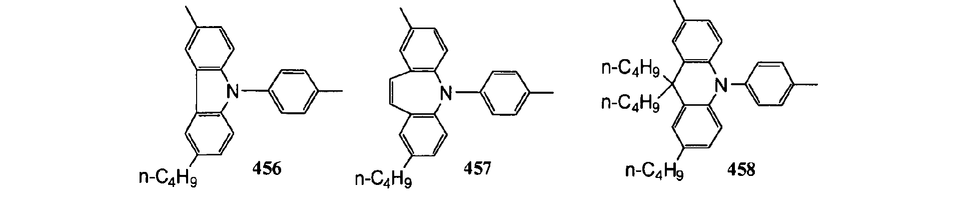

The block (B) may contain one or two or more repeating units represented by the formula (III), and for effecting hole injection and hole transportation in the copolymer, it is preferable that the block (B) contains two repeating units represented by the formula (III). Examples of the repeating unit combination when the block (B) contains two repeating units represented by the formula (III) include a combination of a repeating unit represented by the formula 401 with a repeating unit represented by the formula 403, a combination of a repeating unit represented by the formula 401 with a repeating unit represented by the formula 404, a combination of a repeating unit represented by the formula 401 with a repeating unit represented by the formula 405, a combination of a repeating unit represented by the formula 401 with a repeating unit represented by the formula 406, a combination of a repeating unit represented by the formula 401 with a repeating unit represented by the formula 407, a combination of a repeating unit represented by the formula 401 with a repeating unit represented by the formula 411, a combination of a repeating unit represented by the formula 403 with a repeating unit represented by the formula 404, a combination of a repeating unit represented by the formula 403 with a repeating unit represented by the formula 405, a combination of a repeating unit represented by the formula 403 with a repeating unit represented by the formula 406, a combination of a repeating unit represented by the formula 403 with a repeating unit represented by the formula 407, a combination of a repeating unit represented by the formula 403 with a repeating unit represented by the formula 411, a combination of a repeating unit represented by the formula 404 with a repeating unit represented by the formula 405, a combination of a repeating unit represented by the formula 404 with a repeating unit represented by the formula 406, a combination of a repeating unit represented by the formula 404 with a repeating unit represented by the formula 407, a combination of a repeating unit represented by the formula 404 with a repeating unit represented by the formula 411, a combination of a repeating unit represented by the formula 405 with a repeating unit represented by the formula 406, a combination of a repeating unit represented by the formula 405 with a repeating unit represented by the formula 407, a combination of a repeating unit represented by the formula 405 with a repeating unit represented by the formula 411, a combination of a repeating unit represented by the formula 406 with a repeating unit represented by the formula 407, a combination of a repeating unit represented by the formula 406 with a repeating unit represented by the formula 411 and a combination of a repeating unit represented by the formula 407 with a repeating unit represented by the formula 411, preferably a combination of a repeating unit represented by the formula 401 with a repeating unit represented by the formula 403, a combination of a repeating unit represented by the formula 401 with a repeating unit represented by the formula 405, a combination of a repeating unit represented by the formula 401 with a repeating unit represented by the formula 406, a combination of a repeating unit represented by the formula 401 with a repeating unit represented by the formula 407, a combination of a repeating unit represented by the formula 403 with a repeating unit represented by the formula 405, a combination of a repeating unit represented by the formula 403 with a repeating unit represented by the formula 406, a combination of a repeating unit represented by the formula 403 with a repeating unit represented by the formula 407, a combination of a repeating unit represented by the formula 405 with a repeating unit represented by the formula 406, a combination of a repeating unit represented by the formula 405 with a repeating unit represented by the formula 407 and a combination of a repeating unit represented by the formula 406 with a repeating unit represented by the formula 407, more preferably a combination of a repeating unit represented by the formula 401 with a repeating unit represented by the formula 403, a combination of a repeating unit represented by the formula 401 with a repeating unit represented by the formula 405, a combination of a repeating unit represented by the formula 401 with a repeating unit represented by the formula 406, a combination of a repeating unit represented by the formula 403 with a repeating unit represented by the formula 405, a combination of a repeating unit represented by the formula 403 with a repeating unit represented by the formula 406 and a combination of a repeating unit represented by the formula 405 with a repeating unit represented by the formula 406.

The amount of a repeating unit represented by the formula (II) is preferably 40 to 90 mol and the amount of a repeating unit represented by the formula (III) is preferably 10 to 60 mol, when the amount of all repeating units in the block (B) is 100 mol.

### <Other repeating units>

The copolymer of the present invention may be a copolymer containing a repeating unit other than repeating units represented by the formulae (I-1), (I-2), (II) and (III).

The repeating unit other than repeating units represented by the formulae (I-1), (I-2), (II) and (III) includes preferably repeating units represented by the following the formula (C), for adjusting charge transportability. For the copolymer containing a repeating unit represented by the formula (C), it is preferable that a repeating unit represented by the following the formula (C) is contained in the block (A). 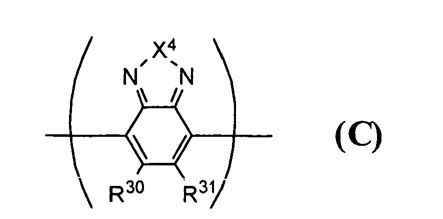 (wherein R³⁰ and R³¹ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, and X⁴ represents an oxygen atom, a sulfur atom or C(R⁷)=C(R⁸)- (wherein R⁷ and R⁸ represent the same meaning as described above.).).

The alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclic thio group, amino group, silyl group, acyl group, acyloxy group, imine residue, amide group, acid imide group and carboxyl group represented by R³⁰ and R³¹ in the formula (C) include the same groups as explained for R¹. The halogen atom includes the same halogen atoms as explained for R¹.

R³⁰ and R³¹ in the formula (C) may be the same or mutually different and represent preferably a hydrogen atom, an alkyl group, an alkoxy group, an alkylthio group, an aryl group, an aryloxy group, an arylthio group or a heterocyclic thio group, more preferably a hydrogen atom, an alkyl group, an alkoxy group, an aryl group or an aryloxy group, further preferably a hydrogen atom, an alkyl group or an aryl group, from the standpoint of easiness of synthesis of a raw material monomer.

X⁴ in the formula (C) represents preferably a sulfur atom or C(R⁷)=C(R⁸)-, more preferably a sulfur atom, for light emission of a polymer light emitting device using the copolymer of the present invention for a longer period of time.

The copolymer of the present invention shows light emission for a longer period of time when a polymer light emitting device using the copolymer of the present invention is fabricated, than a copolymer containing no repeating unit represented by the formula (I-1) or a random copolymer having a repeating unit represented by the formula (I-1).

### <Copolymer>

The total content ratio of repeating units represented by the formula (I-1) is preferably in the range of 0.02 to 50 mol%, more preferably 0.5 to 40 mol%, the total content ratio of repeating units represented by the formula (I-2) is preferably in the range of 0.5 to 50 mol%, more preferably 5 to 50 mol%, the total content ratio of repeating units represented by the formula (II) is preferably in the range of 10 mol% to 90 mol%, more preferably 20 to 80 mol%, and the total content ratio of repeating units represented by the formula (III) is preferably in the range of 0.1 to 60 mol%, more preferably 5 to 50 mol%, with respect to the total amount of all repeating units in the copolymer of the present invention. When the copolymer of the present invention contains a repeating unit other than repeating units represented by the above-described formulae (I-1), (I-2), (II) and (III), for example, a repeating unit represented by the formula (C), the content ratio of this repeating unit is preferably in the range of 1 to 50 mol%, more preferably 5 to 40 mol%, with respect to the total amount of all repeating units in the copolymer.

When the copolymer of the present invention is used as a light emitting material of a polymer light emitting device, the total content ratio of repeating units represented by the formula (I-1) is more preferably 0.5 to 40 mol%, particularly preferably 1 to 30 mol%, with respect to the sum of all repeating units in the copolymer, for obtaining a polymer light emitting device having a long life and showing light emission at a long wavelength.

The copolymer of the present invention has a polystyrene-equivalent number average molecular weight of preferably 1×10³ to 1×10⁷, more preferably 1×10⁴~1×10⁷, from the standpoint of the life property of a polymer light emitting device.

The copolymer of the present invention has a polystyrene-equivalent weight average molecular weight of preferably 1×10³ to 1×10⁷, more preferably 1×10⁴~1×10⁷, from the standpoint of the life property of a polymer light emitting device.

In the copolymer of the present invention, the block (A) has a polystyrene-equivalent number average molecular weight of preferably 1×10³ to 1×10⁵, more preferably 2×10³ to 1×10⁵, from the standpoint of the life property of a polymer light emitting device.

In the copolymer of the present invention, the block (A) has a polystyrene-equivalent weight average molecular weight of preferably 1×10³ to 1×10⁵, more preferably 1×10⁴ to 1×10⁵, from the standpoint of the life property of a polymer light emitting device.

In the present invention, the polystyrene-equivalent number average molecular weight and weight average molecular weight can be measured using size exclusion chromatography (SEC).

In the copolymer of the present invention, the value represented by the formula (VI):

[A] / [B] (VI)

(wherein [A] represents a maximum number among the number of blocks (A) and the number of blocks (A') contained in the copolymer (when the numbers of both blocks are identical, its number), and [B] represents the number of blocks (B) contained in the copolymer) is preferably 0.1 or more and 10 or less, more preferably 0.5 or more and 8 or less, from the standpoint of the life property of a device.

In the copolymer of the present invention, the value represented by the formula (VII):

[C]/[D] (VII)

(wherein [C] represents a maximum number among the polystyrene-equivalent weight average molecular weight of the block (A) and the polystyrene-equivalent weight average molecular weight of the block (A') (when the weight average molecular weights of both blocks are identical, its weight average molecular weight), and [D] represents the polystyrene-equivalent weight average molecular weight of the copolymer) is preferably 0.01 or more and 0.8 or less, more preferably 0.05 or more and 0.5 or less, from the standpoint of the life property of a device,

If a polymerization active group remains intact at the molecule chain end of the copolymer of the present invention, there is a possibility of reduction in the light emitting property and the life when fabricated into a device, thus, the end may be protected with a stable protective group. As the protective group, those having a conjugated bond continuing to a conjugated structure of the main chain are preferable, and for example, there are mentioned those having structures connecting to an aryl group or a heterocyclic group via a carbon-carbon bond. Specifically, substituents described as Chemical Formula 10 in JP-A No. 9-45478, and the like are exemplified.

As the good solvent for the copolymer of the present invention, exemplified are chloroform, methylene chloride, dichloroethane, tetrahydrofuran, toluene, xylene, mesitylene, tetralin, decalin and n-butylbenzene. Depending on the structure and the molecular weight of the copolymer of the present invention, the copolymer can be dissolved usually in an amount of 0.1 wt% or more in these solvents.

The copolymer of the present invention includes the following copolymers (AB1 to AB36) combining the following blocks (A) and blocks (B).

### (Copolymer AB1)

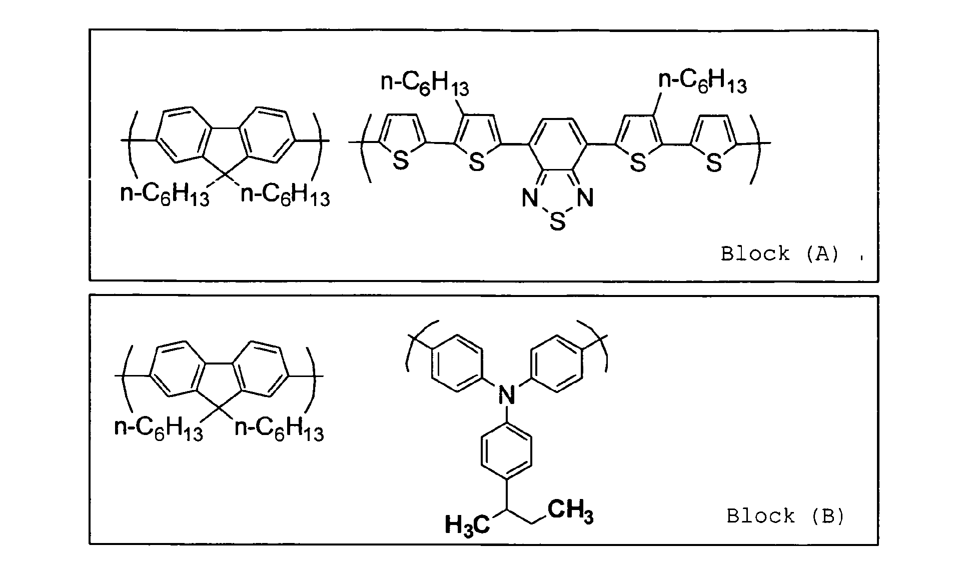

### (Copolymer AB2)

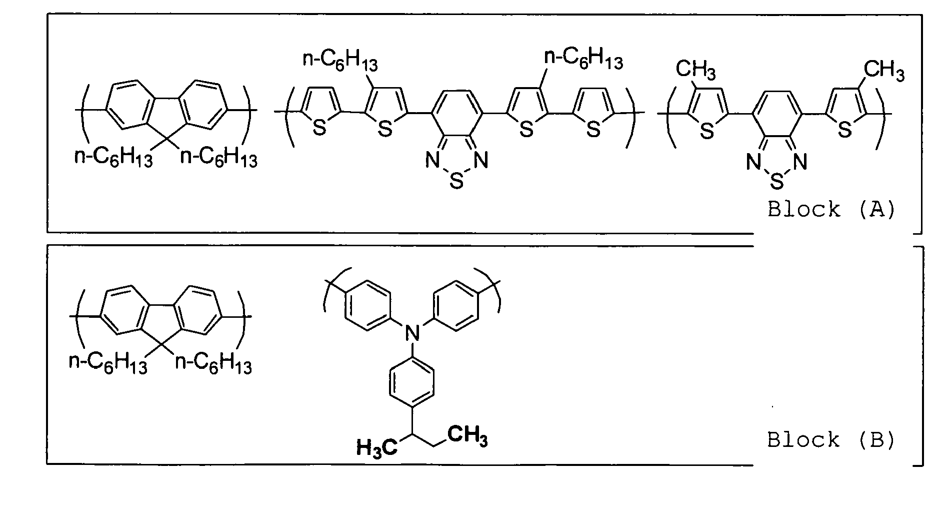

### (Copolymer AB3)

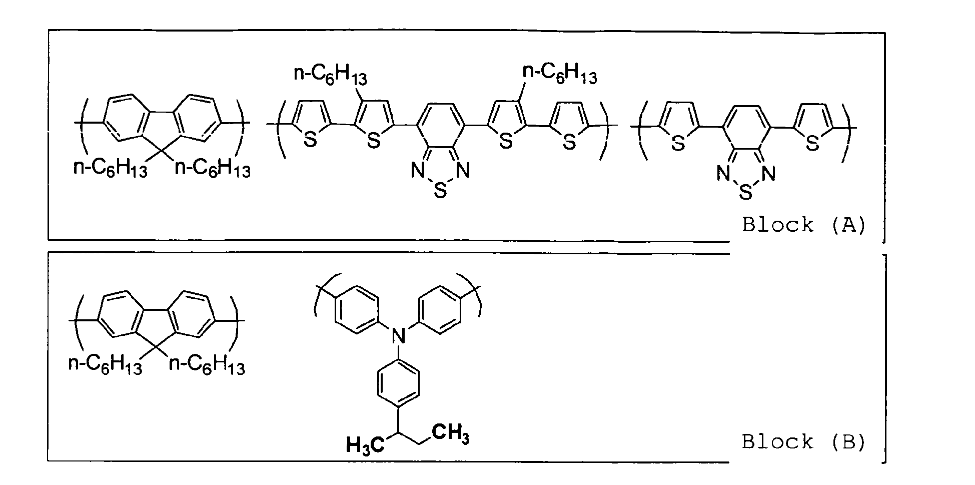

### (Copolymer AB4)

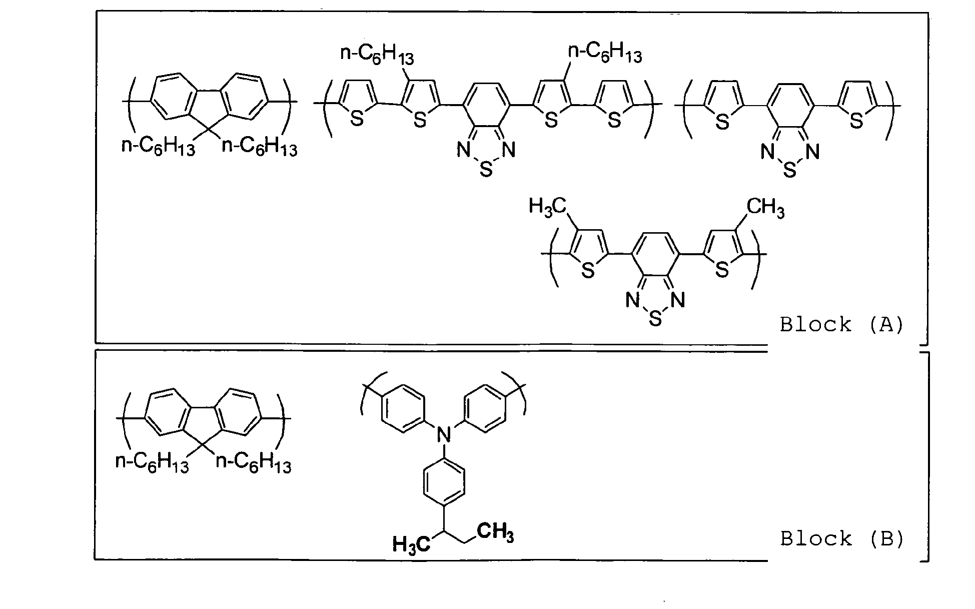

### (Copolymer AB5)

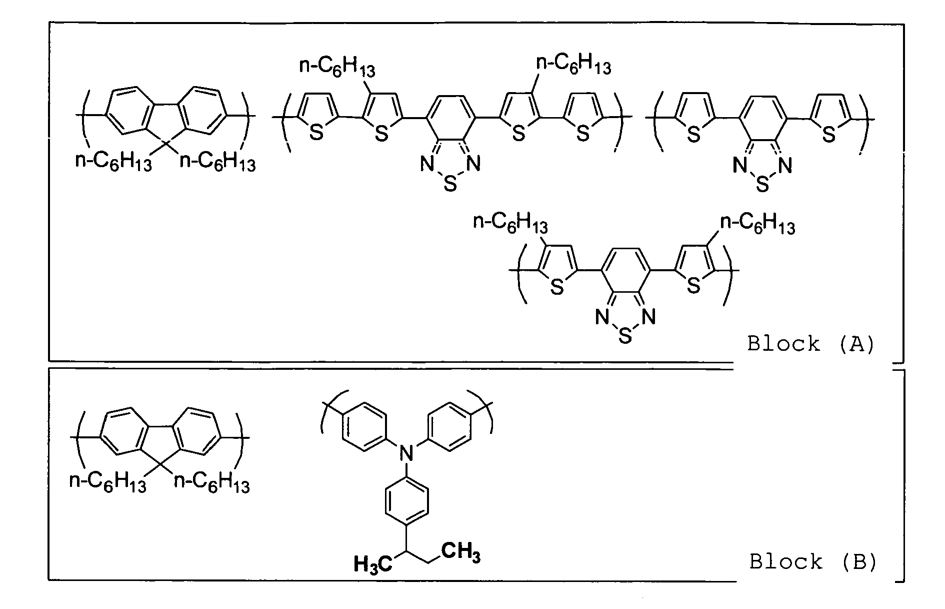

### (Copolymer AB6)

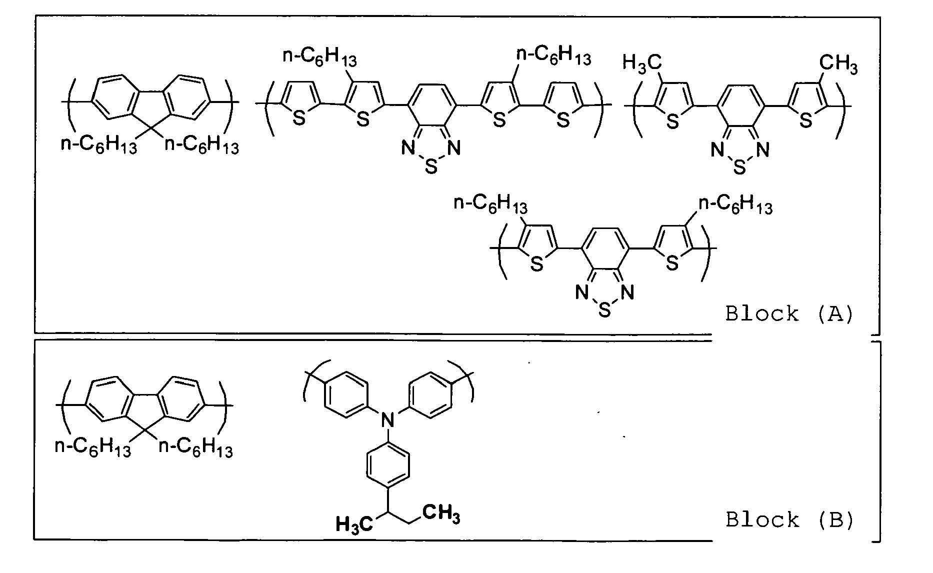

### (Copolymer AB7)

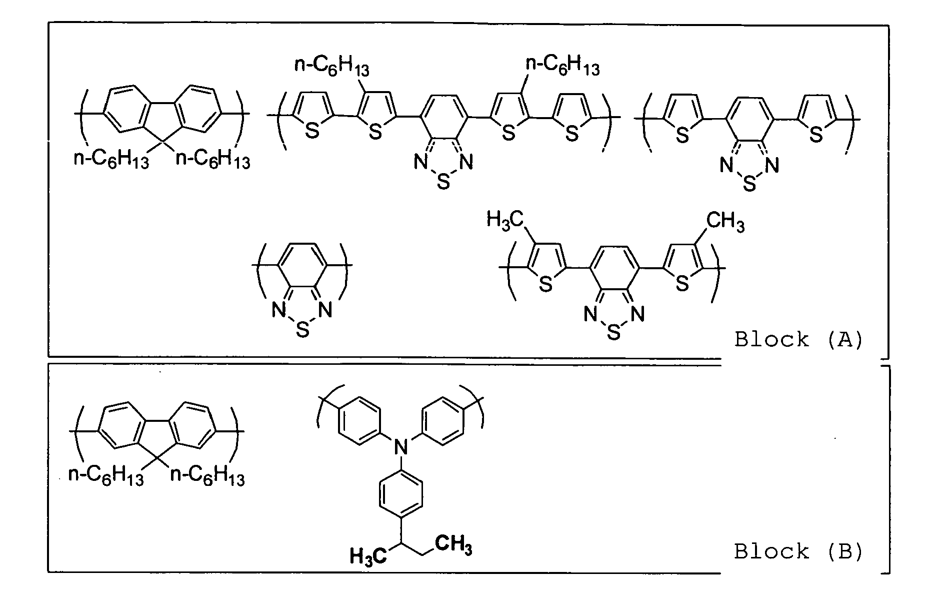

### (Copolymer AB8)

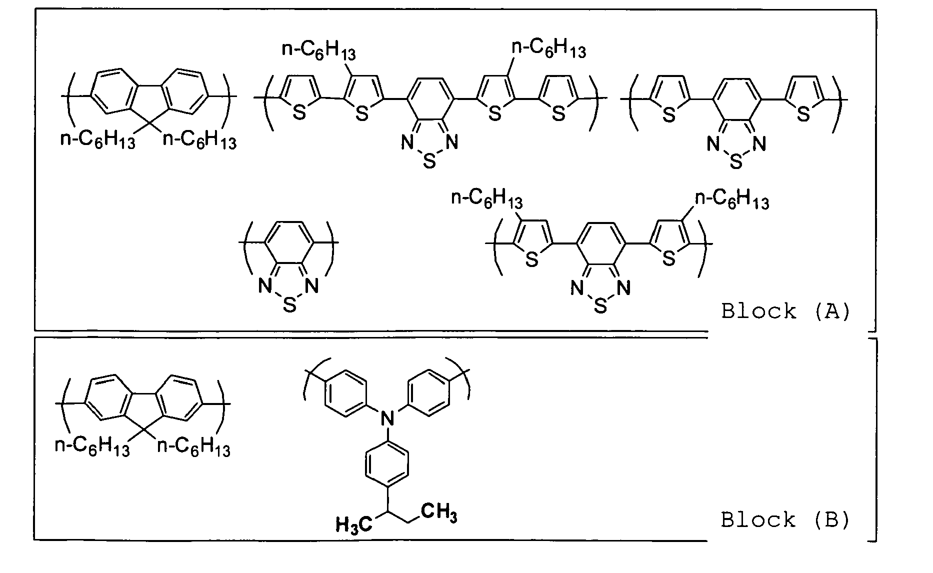

### (Copolymer AB9)

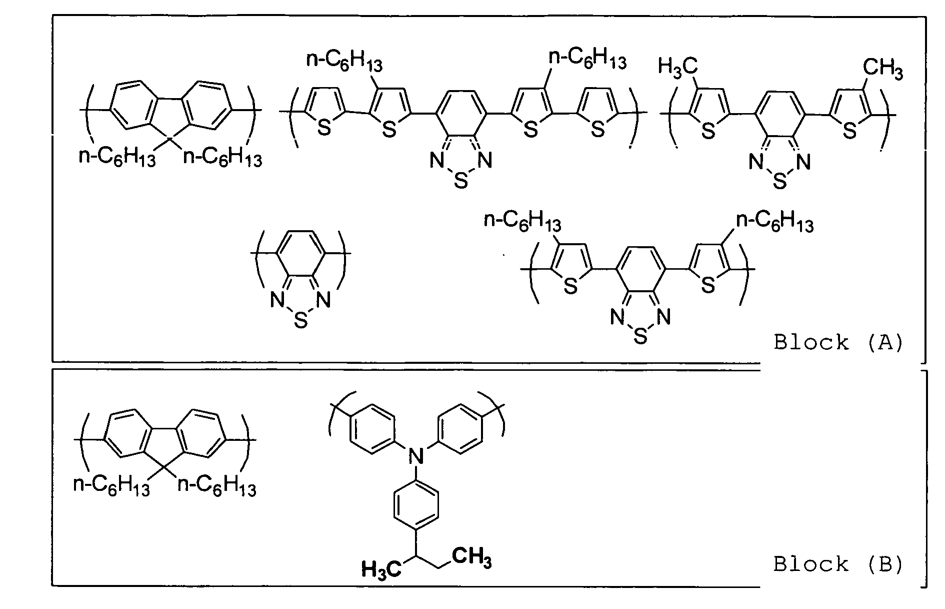

### (Copolymer AB10)

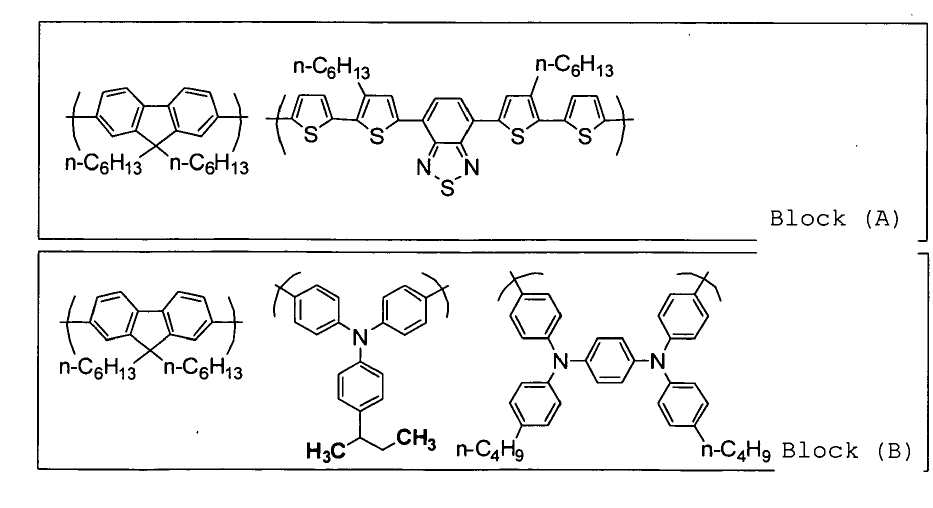

### (Copolymer AB11)

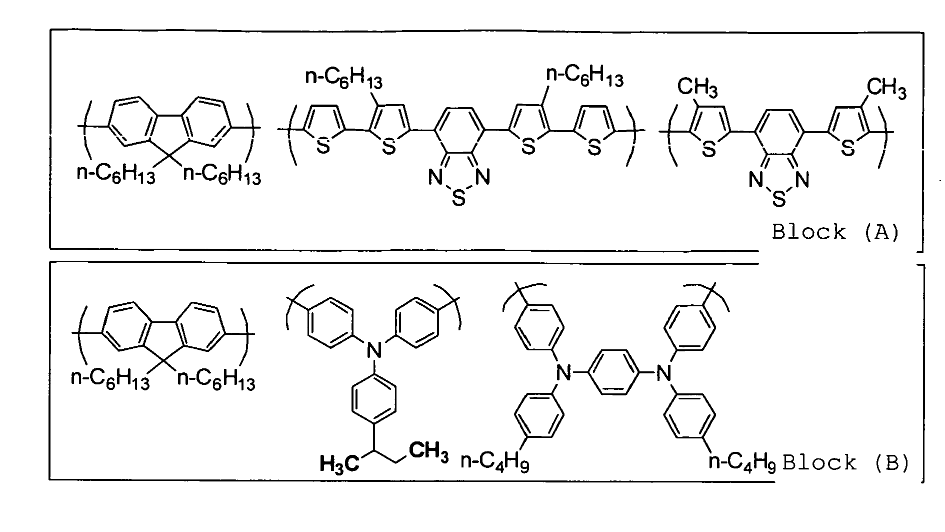

### (Copolymer AB12)

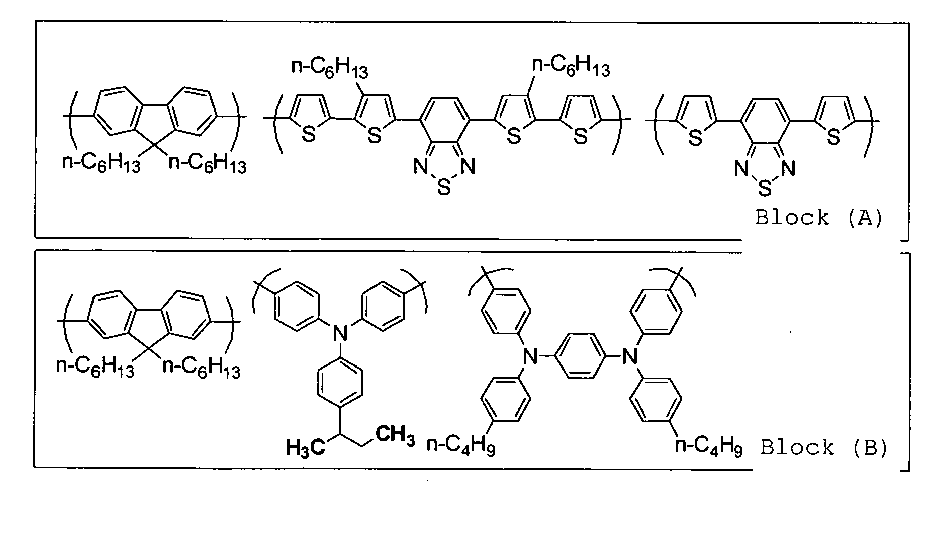

### (Copolymer AB13)

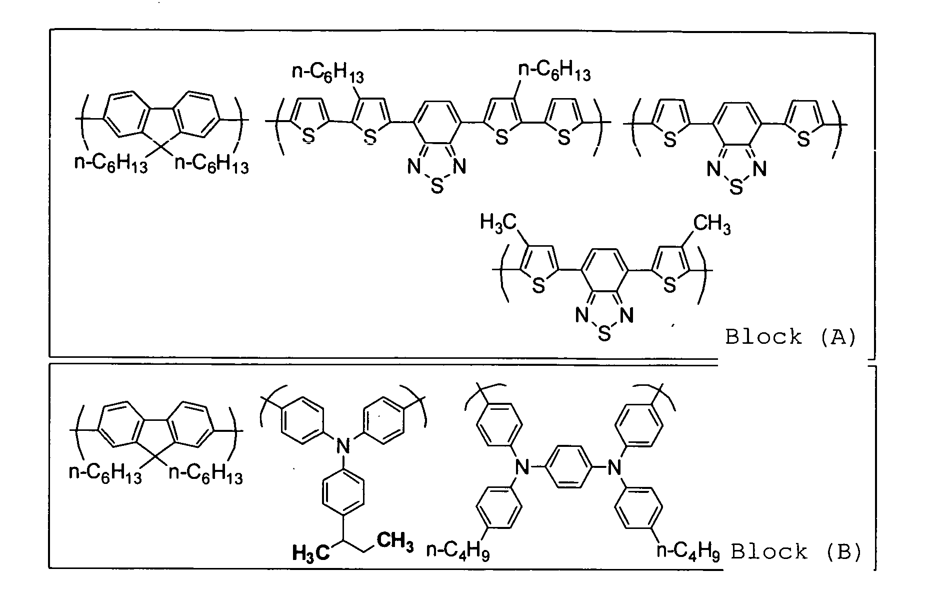

### (Copolymer AB14)

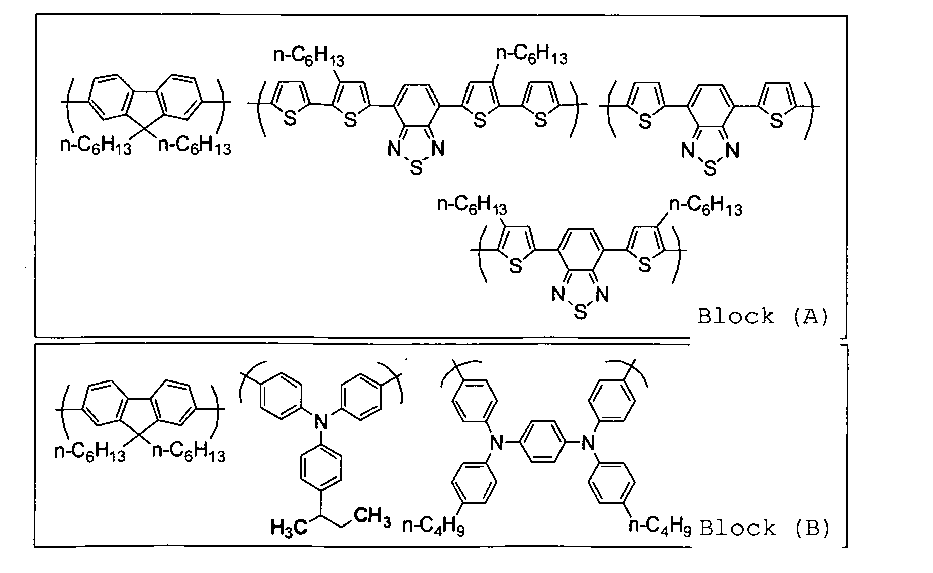

### (Copolymer AB15)

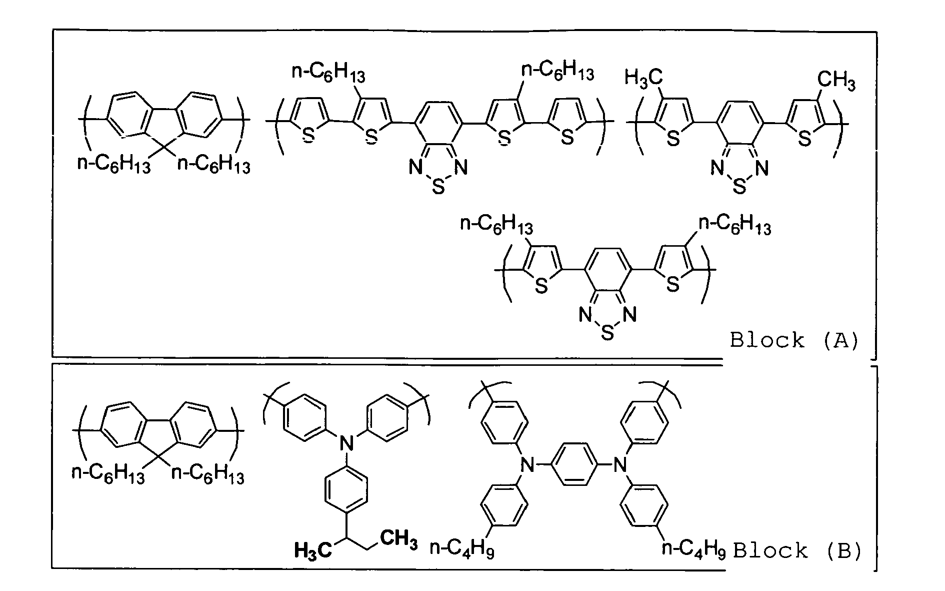

### (Copolymer AB16)

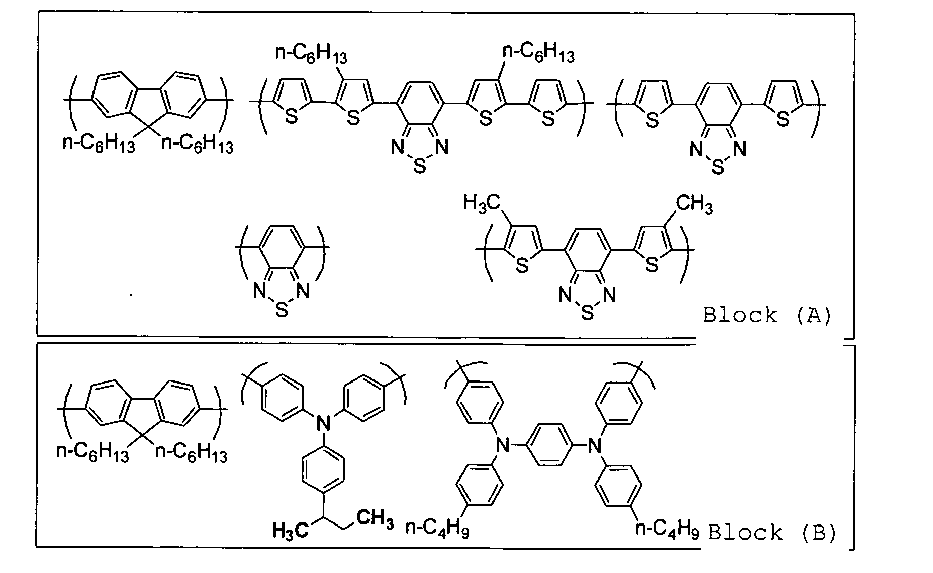

### (Copolymer AB17)

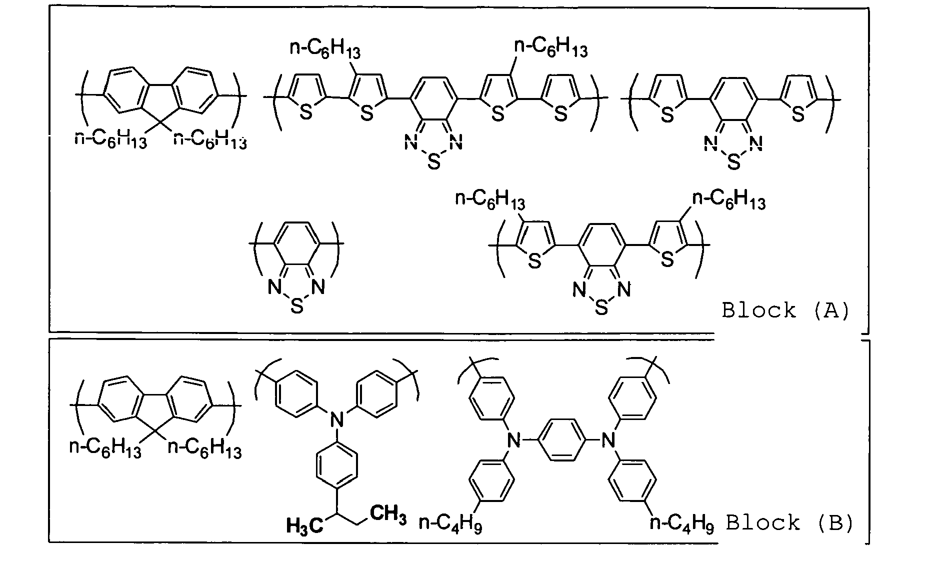

### (Copolymer AB18)

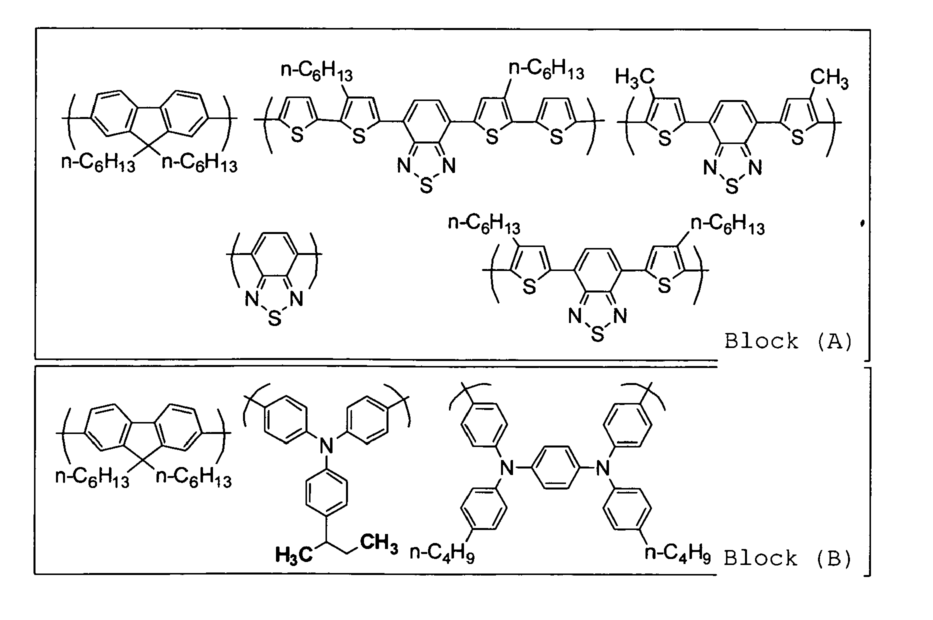

### (Copolymer AB19)

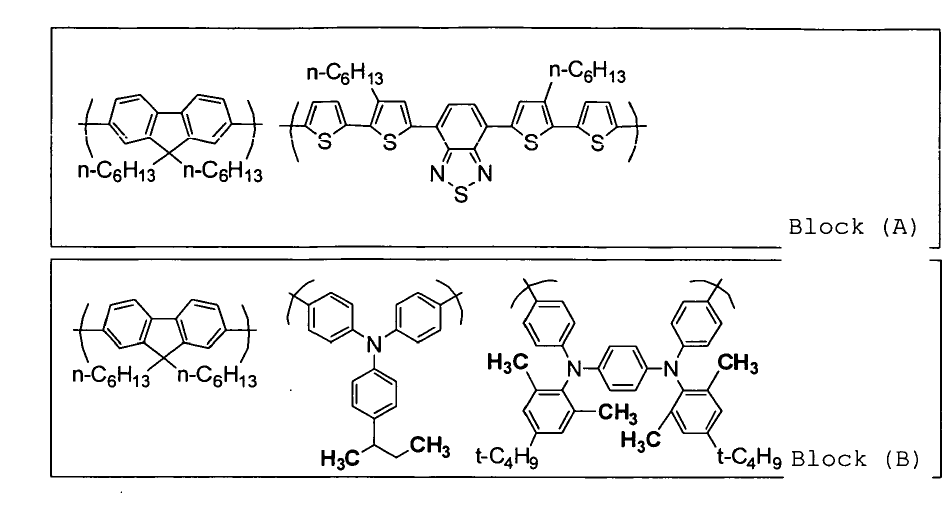

### (Copolymer AB20)

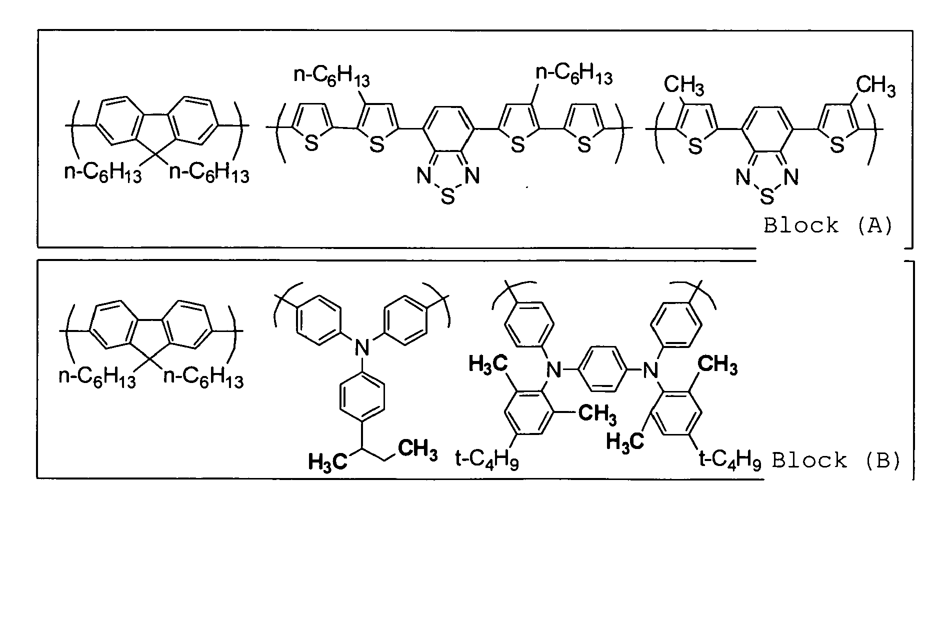

### (Copolymer AB21)

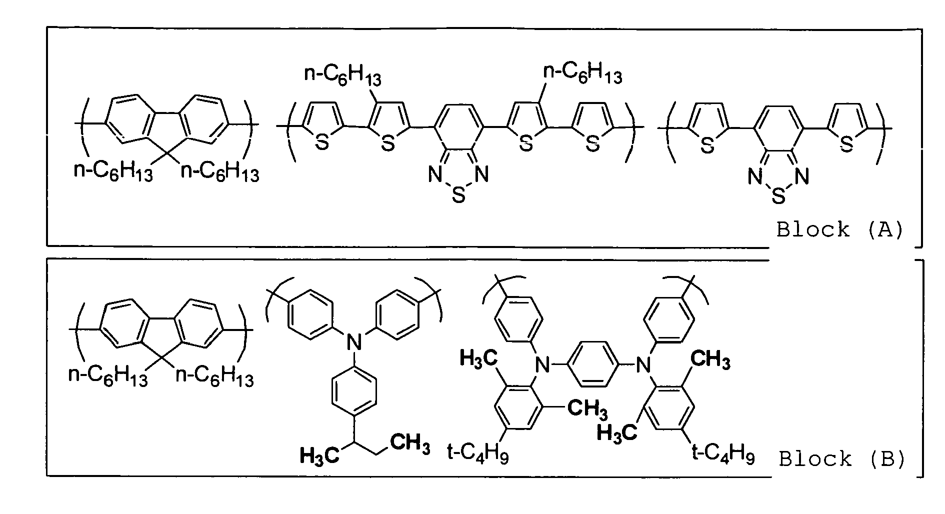

### (Copolymer AB22)

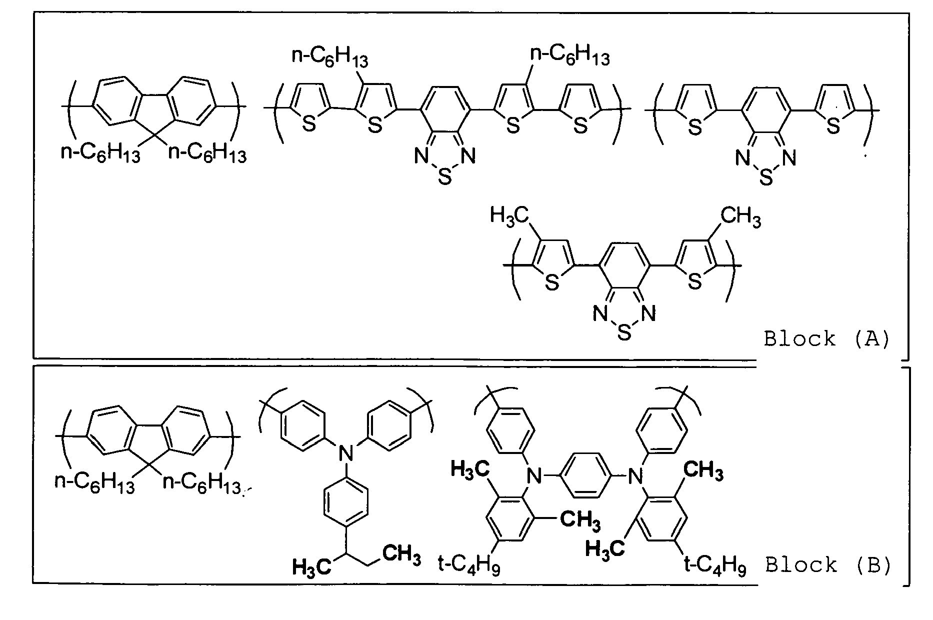

### (Copolymer AB23)

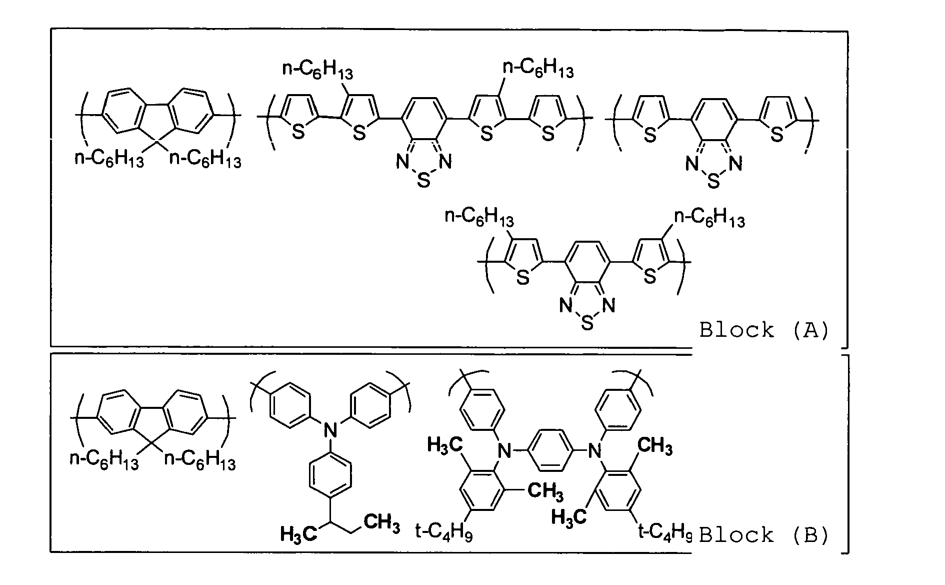

### (Copolymer AB24)

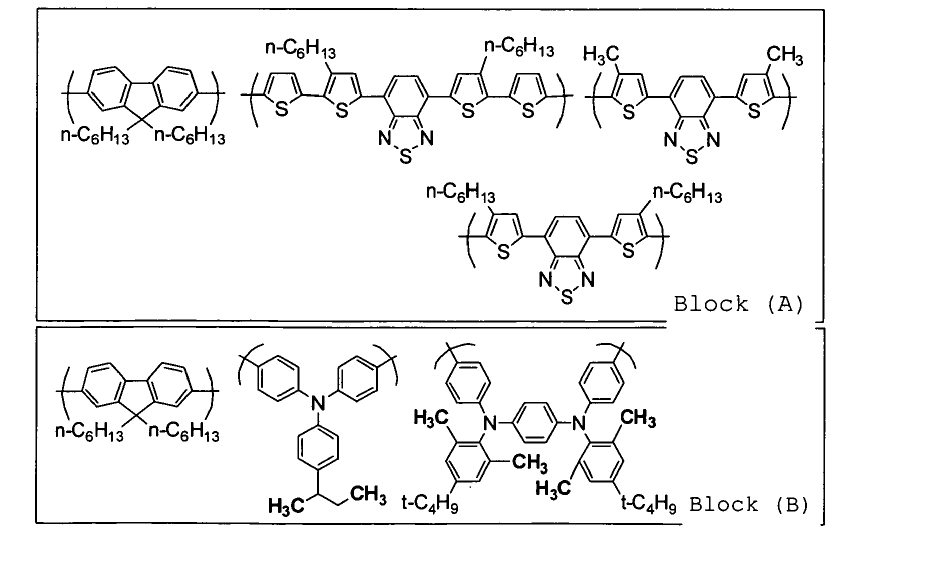

### (Copolymer AB25)

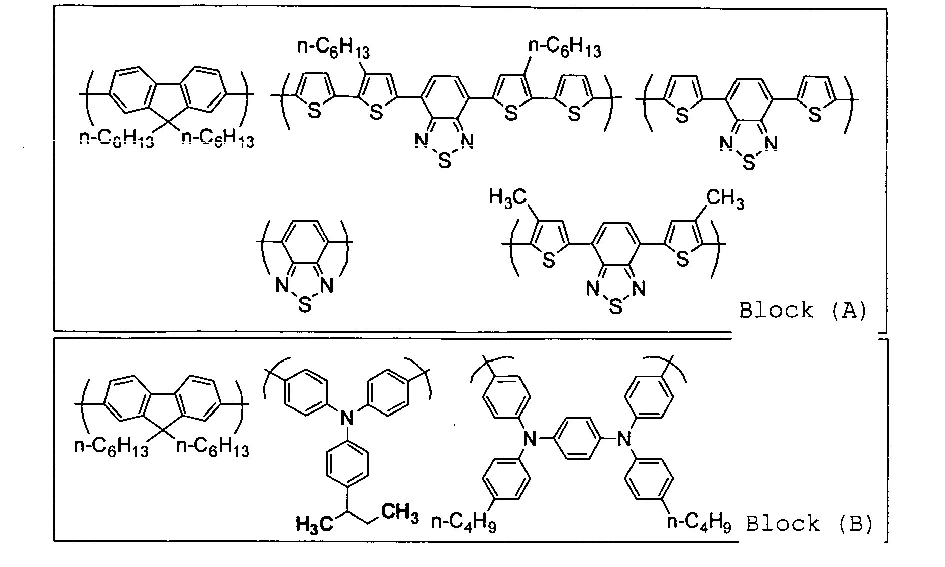

### (Copolymer AB26)

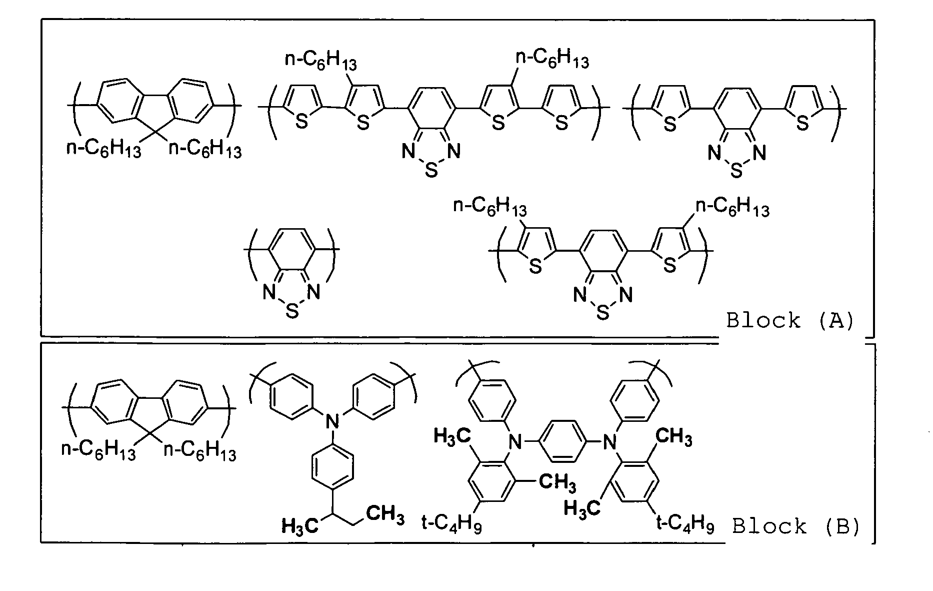

### (Copolymer AB27)

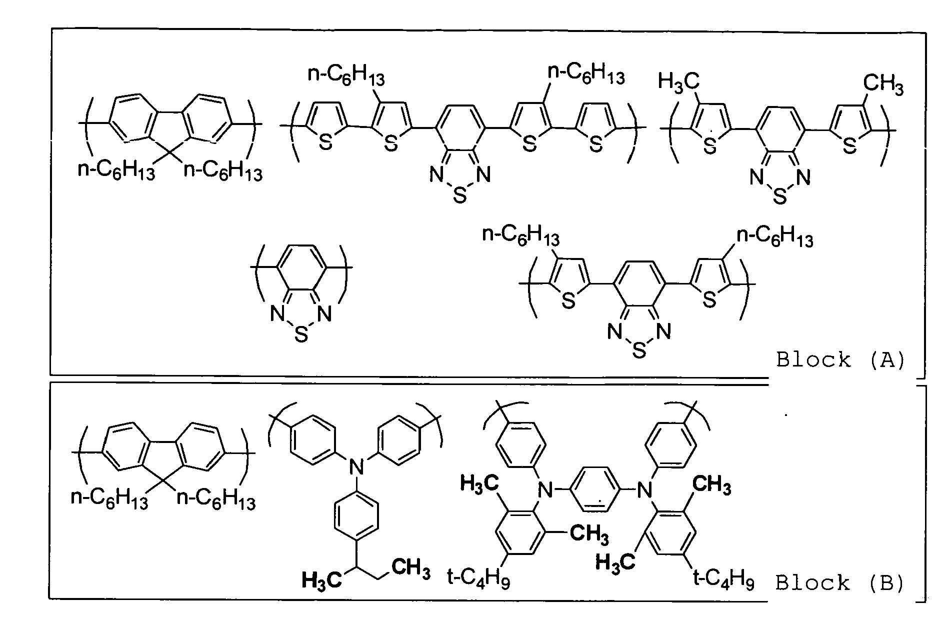

### (Copolymer AB28)

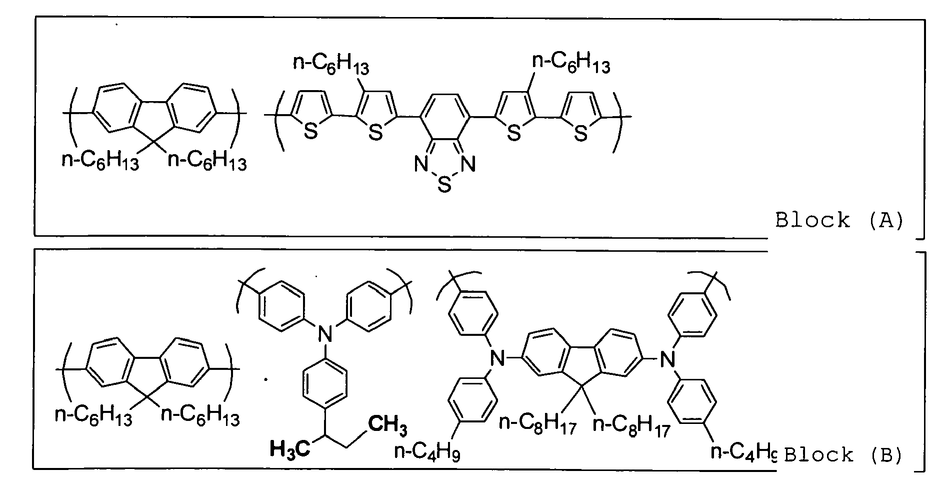

### (Copolymer AB29)

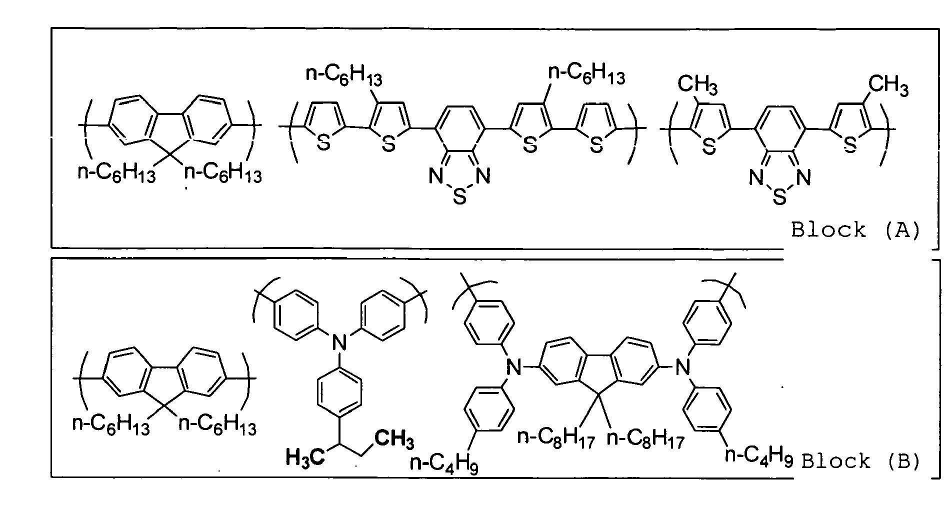

### (Copolymer AB30)

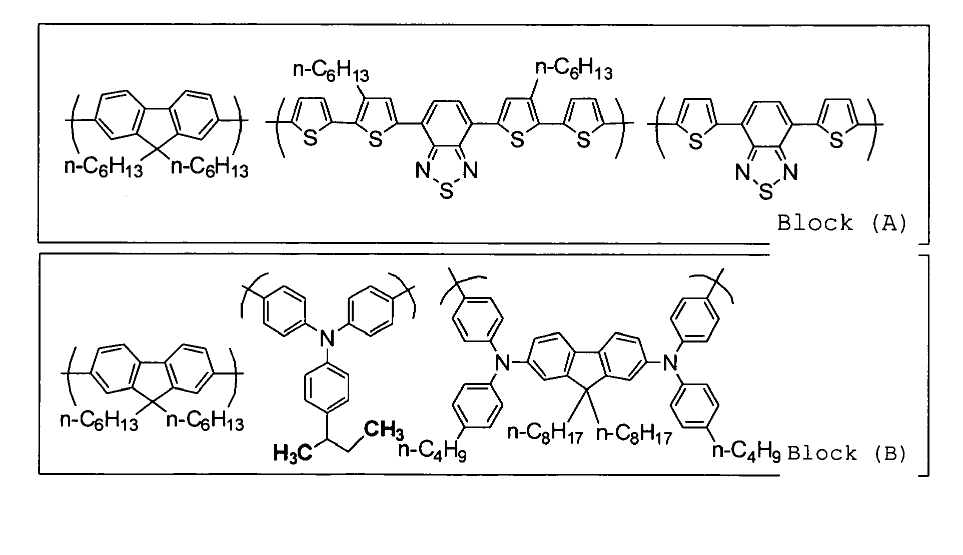

### (Copolymer AB31)

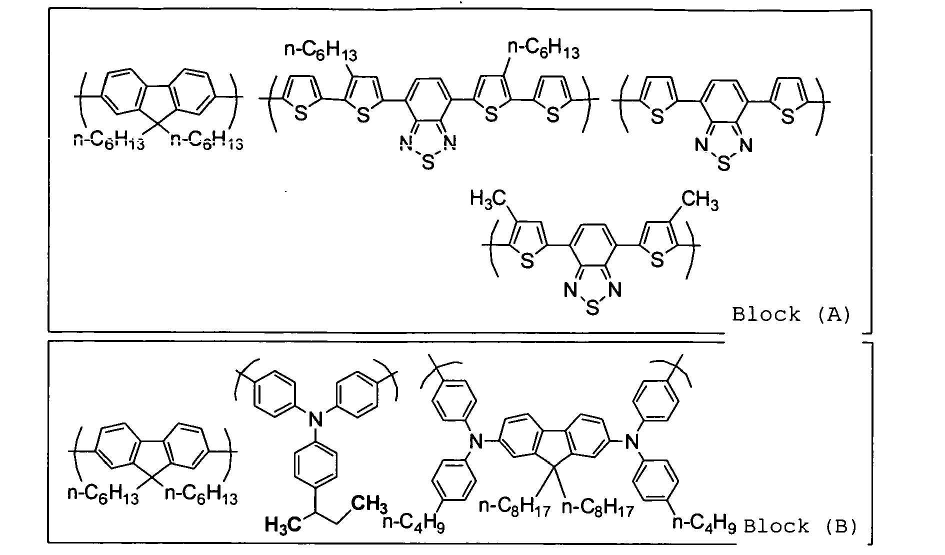

### (Copolymer AB32)

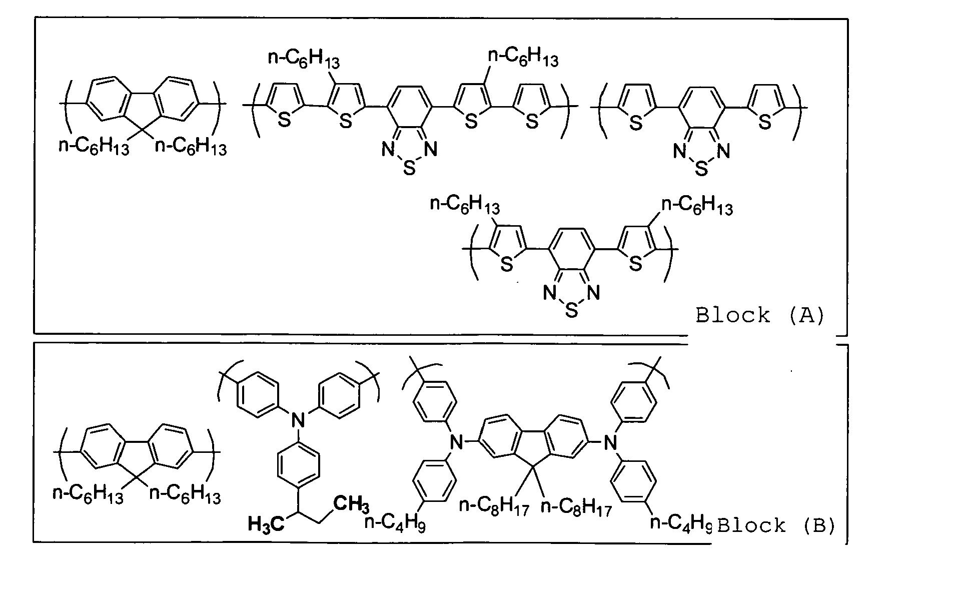

### (Copolymer AB33)

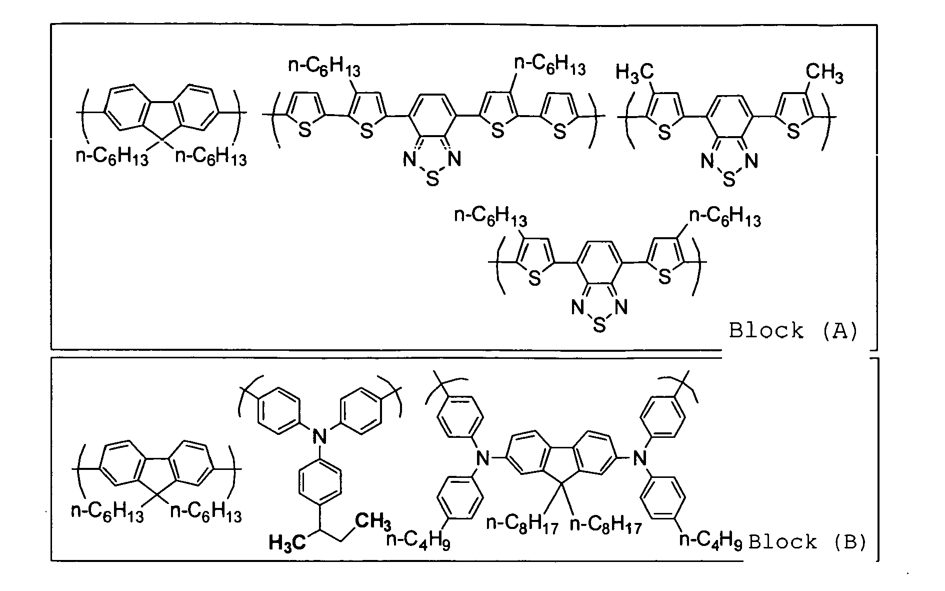

### (Copolymer AB34)

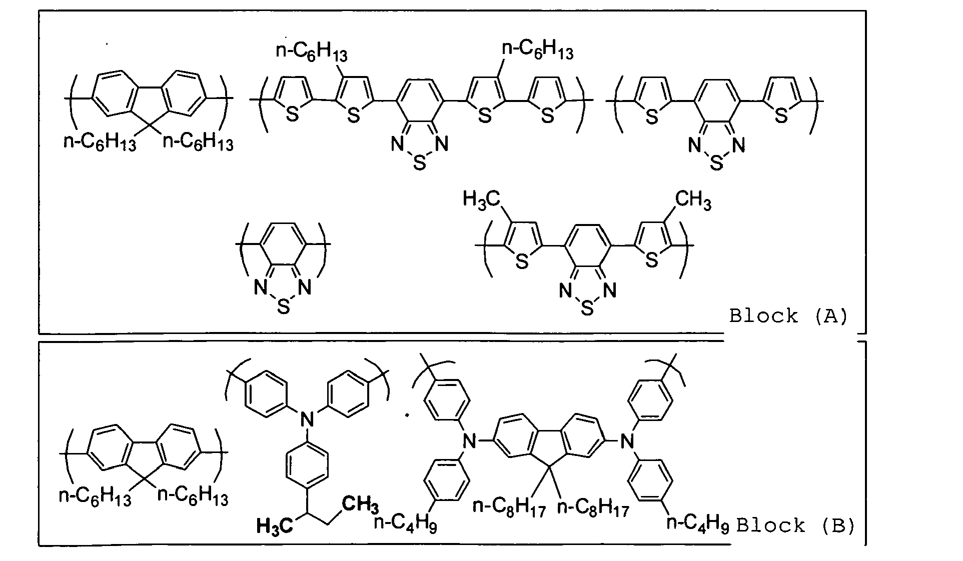

### (Copolymer AB35)

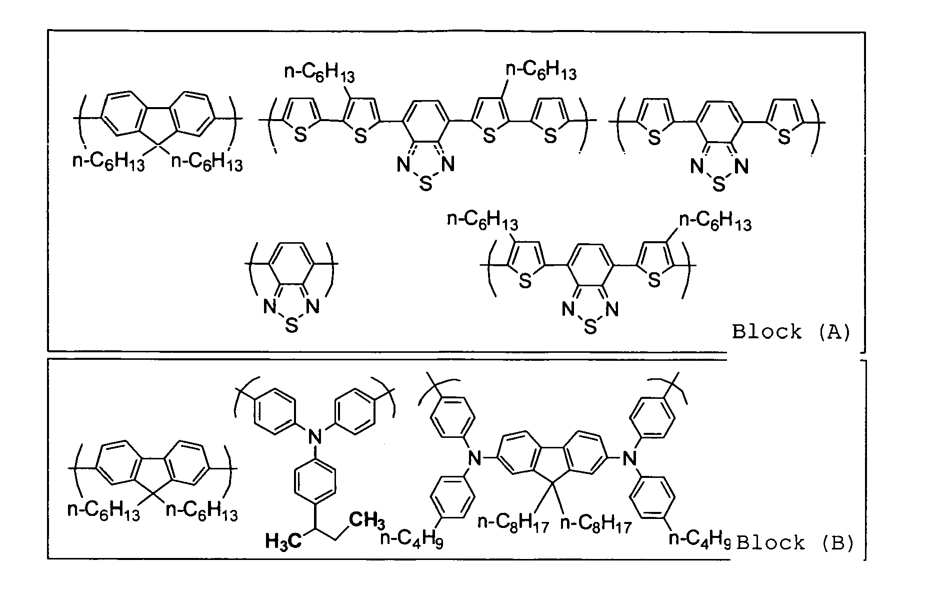

### (Copolymer AB36)

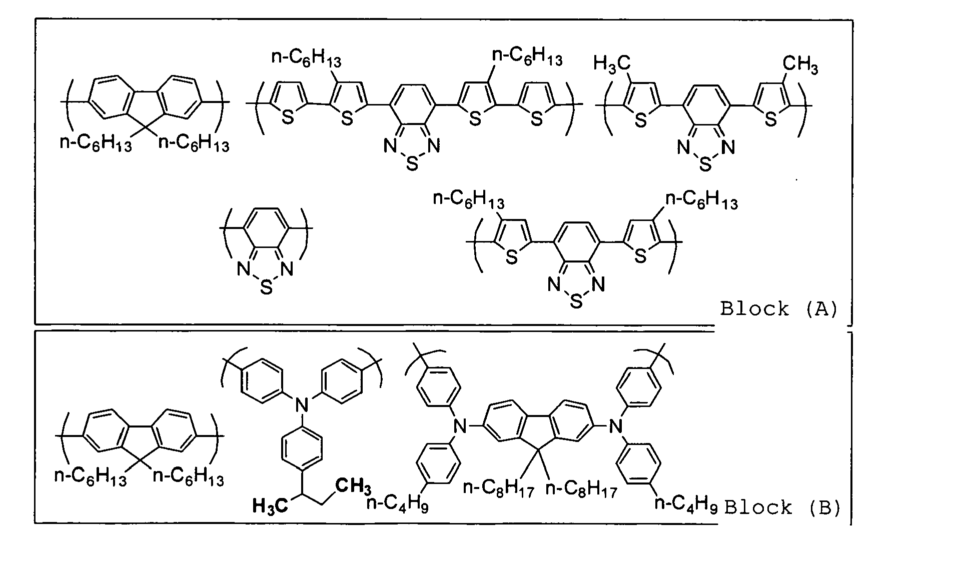

### <Production method of copolymer>

Next, the method of producing the copolymer of the present invention will be explained.

The method of producing the copolymer of the present invention (a copolymer having blocks) includes, for example, a method in which a block (A) having a high molecular weight is synthesized, and a monomer constituting a block (B) is added to this and polymerized, and a method in which a block (A) having a high molecular weight and a block (B) having a high molecular weight are previously synthesized separately, and these are combined and polymerized.

In the latter method, the block (A) and the block (B) may be directly bonded to form a copolymer, alternatively, in addition to the block (A) and the block (B), a compound acting as a group for connecting the block (A) and the block (B) (connecting group) may be added, or a separate block may be added, to obtain a copolymer having a further increased molecular weight.

Examples of the method of producing the copolymer of the present invention will be explained further in detail.

Among the production methods of the present invention, the following production methods (i) to (v) are preferable, and the production methods (i) to (iii) are more preferable. In the following methods (i) to (v), -A-represents a repeating unit represented by the formula (I-1) or a repeating unit represented by the formula (I-2), Ar¹ represents the same meaning as described above, and W¹ and W² may be the same or mutually different and represent a substituent capable of participating in condensation polymerization.
(i) A method of producing the copolymer having a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, and a step of condensation-polymerizing this first compound with a compound having two substituents capable of participating in condensation polymerization, to synthesize a copolymer having a block (A') and/or a block (A).
(ii) A method of producing the copolymer having a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, and a step of condensation-polymerizing this first compound with a compound represented by W¹-Ar¹-W² and a compound represented by W¹-Ar²-W², or condensation-polymerizing this first compound with a compound represented by W¹-Ar¹-W², a compound represented by W¹-Ar²-W² and a compound having two substituents capable of participating in condensation polymerization, to synthesize a copolymer having a block (A') and/or a block (A) and a block (B).
(iii) A method of producing the copolymer having a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, a step of condensation-polymerizing a compound represented by W¹-Ar¹-W² with a compound represented by W¹-Ar²-W², or condensation-polymerizing a compound represented by W¹-Ar¹-W² with a compound represented by W¹-Ar²-W² and a compound having two substituents capable of participating in condensation polymerization (condensation polymerization may be carried out in the presence of other compound), to synthesize a second compound, and a step of condensation-polymerizing this first compound and this second compound (condensation polymerization may be carried out in the presence of a compound having two substituents capable of participating in condensation polymerization), to synthesize a copolymer having a block (A')and/or a block (A) and a block (B) (iv) A method of producing the copolymer having a step of condensation-polymerizing a compound having two substituents capable of participating in condensation polymerization, to synthesize a first compound, and a step of condensation-polymerizing this first compound with only a compound represented by W¹-A-W², or with a compound represented by W¹-A-W² and a compound represented by W¹-Ar¹-W² (condensation polymerization may be carried out in the presence of a compound having two substituents capable of participating in condensation polymerization), to synthesize a copolymer having a block (A') and/or a block (A).
(v) A method of producing the copolymer having a step of condensation-polymerizing a compound represented by W¹-Ar¹-W² with a compound represented by W¹-Ar²-W² (condensation polymerization may be carried out in the presence of a compound having two substituents capable of participating in condensation polymerization), to synthesize a first compound, and a step of condensation-polymerizing this first compound with only a compound represented by W¹-A-W², or with a compound represented by W¹-A-W² and a compound represented by W¹-Ar¹-W² (condensation polymerization may be carried out in the presence of a compound having two substituents capable of participating in condensation polymerization), to synthesize a copolymer having a block (A') and/or a block (A) and a block (B).

The molecular weights of the block (A) and the block (B) can be adjusted by selection and regulation of the stoichiometric amount of a monomer to be subjected to polymerization, the kind of a catalyst, the amount of a catalyst, addition of a base or an acid, the reaction temperature, the kind of a solvent, the concentration of a solution, and the like.

The compound having two substituents capable of participating in condensation polymerization is a compound for introducing a repeating unit other than repeating units represented by the formulae (I-1), (I-2), (II) and (III) into the copolymer of the present invention. Examples of this compound include compounds represented by the following formula (D). This compound becomes a repeating unit represented by the above-described formula (C) after condensation polymerization. 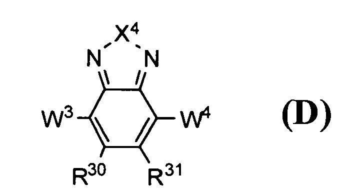 (wherein R³⁰, R³¹ and X⁴ represent the same meaning as described above, and W³ and W⁴ represent each independently a substituent capable of participating in condensation polymerization.).

In the method of producing the copolymer of the present invention, the substituents capable of participating in condensation polymerization (W¹, W², W³ and W⁴) include a halogen atom, an alkylsulfo group, an arylsulfo group, an arylalkylsulfo group, a borate residue, a sulfoniummethyl group, a phosphoniummethyl group, a phosphonatemethyl group, a methyl monohalide group, - B(OH)₂, a formyl group, a cyano group, a vinyl group and the like.

Exemplified as the alkylsulfo group are a methanesulfo group, an ethanesulfo group, a trifluoromethanesulfo group and the like.

Exemplified as the arylsulfo group are a benzenesulfo group, a p-toluenesulfo group and the like.

Exemplified as the arylalkylsulfo group are a benzylsulfo group and the like.

As the borate residue, groups represented by the following formulae are exemplified. 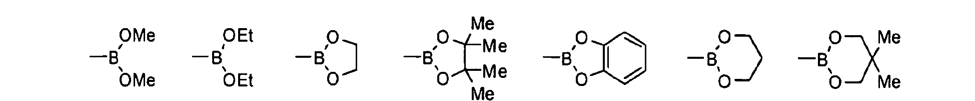 (wherein Me represents a methyl group and Et represents an ethyl group.).

As the sulfoniummethyl group, groups represented by the following formulae are exemplified.

-CH₂ S⁺Me₂X⁻, -CH₂ S⁺ Ph₂ X⁻

(wherein X represents a halogen atom, Me represents a methyl group, and Ph represents a phenyl group).

As the phosphoniummethyl group, groups represented by the following formula are exemplified.

-CH₂ P⁺ Ph₃ X⁻

(wherein, X represents a halogen atom, an Ph represents a phenyl group).

As the phosphonatemethyl group, groups represented by the following formula are exemplified.

-CH₂ P (=O) (OR')₂

(wherein R' represents an alkyl group, an aryl group or an arylalkyl group).

As the methyl mono-halide group, a methyl fluoride group, a methyl chloride group, a methyl bromide group and a methyl iodide group are exemplified.

Preferable substituents as the substituent capable of participating in condensation polymerization vary depending on the kind of the polymerization reaction, and, for example, include preferably a halogen atom, an alkylsulfo group, an arylsulfo group and an arylsulfonate group in the case of use of a 0-valent nickel complex (Ni(0) complex) such as in the Yamamoto coupling reaction and the like, and include preferably an alkylsulfo group, a halogen atom, a borate residue and -B(OH)₂ in the case of use of a nickel catalyst or a palladium catalyst such as in the Suzuki coupling reaction and the like.

Production of the copolymer of the present invention can be carried out, for example, by dissolving a raw material monomer compound in an organic solvent, using an alkali and a suitable solvent, at a temperature of not lower than the melting point and not higher than the boiling point of the organic solvent. For the method of producing the copolymer of the present invention, a reference can be made of methods described in "Organic Reactions", Volume 14, page 270-490, John Wiley & Sons, Inc., 1965; "Organic Syntheses", Collective Volume VI, page 407-411, John Wiley & Sons, Inc., 1988; Chemical Review (Chem. Rev.), Volume 95, page 2457 (1995); Journal of Organometallic Chemistry (J. Organomet. Chem.), Volume 576, page 147 (1999); Macromolecular Chemistry Macromolecular Symposium (Makromol. Chem., Macromol.Symp.), Volume 12th, page 229 (1987), and a method described in WO 2003/007395.

In the method of producing the copolymer of the present invention, known condensation reactions can be used, depending on the substituent capable of participating in condensation polymerization. As the condensation reaction, exemplified are a method of polymerization of a suitable monomer by the Suzuki coupling reaction, a method of polymerization thereof by the Grignard reaction, a method of polymerization thereof with a zero-valent nickel complex, a method of polymerization thereof with an oxidizer such as FeCl₃ and the like, a method of electrochemical oxidation polymerization thereof, a method by decomposition of an intermediate polymer having a suitable leaving group, and the like, and of them, a method of polymerization by the Suzuki coupling reaction, a method of polymerization by the Grignard reaction and a method of polymerization with a zero-valent nickel complex are preferable from the standpoint of easiness of control of the structure of the copolymer.

Among the production methods of the copolymer of the present invention, one preferable embodiment is a production method in which the substituents capable of participating in condensation polymerization are each independently selected from the group consisting of a halogen atom, an alkylsulfo group, an arylsulfo group and an arylalkylsulfo group, and the condensation polymerization is carried out in the present of a zero-valent nickel complex.

The raw material monomer compounds include, for example, dihalogenated compounds, bis(alkyl sulfonate) compounds, bis(aryl sulfonate) compounds, bis(arylalkyl sulfonate) compounds; halogen-alkyl sulfonate compounds, halogen-aryl sulfonate compounds, halogen-arylalkyl sulfonate compounds, alkyl sulfonate-aryl sulfonate compounds, alkyl sulfonate-arylalkyl sulfonate compounds, and aryl sulfonate-arylalkyl sulfonate compounds.

The production method of the copolymer of the present invention includes preferably a method in which a copolymer having a controlled sequence is produced by using, for example, a halogen-alkyl sulfonate compound, a halogen-aryl sulfonate compound, a halogen-arylalkyl sulfonate compound, an alkyl sulfonate-aryl sulfonate compound, an alkyl sulfonate-arylalkyl sulfonate compound, or an aryl sulfonate-arylalkyl sulfonate compound as the raw material monomer compound.

Among the production methods of the copolymer of the present invention, another preferable embodiment is a production method in which the substituents capable of participating in condensation polymerization are selected each independently from the group consisting of a halogen atom, an alkylsulfo group, an arylsulfo group, an arylalkylsulfo group, -B(OH)₂ and a borate residue, and the ratio (K/J) of the sum (J) of mole numbers of a halogen atom, an alkylsulfo group, an arylsulfo group and an arylalkylsulfo group to the sum (K) of mole numbers of - B(OH)₂ and a borate residue, in all raw material monomer compounds, is substantially 1 (usually, in the range of 0.7 to 1.2), and condensation polymerization is carried out using a nickel catalyst or a palladium catalyst.

As combinations of raw material monomer compounds, there are mentioned combinations of a dihalogenated compound, a bis(alkyl sulfonate) compound, a bis(aryl sulfonate) compound or a bis(arylalkyl sufonate) compound with a diboronic acid compound or a diborate compound.

In the case of use of a solvent in condensation polymerization, it is preferable that this solvent is subjected to a sufficient deoxygenation treatment, for in general suppressing side reactions, though varying depending on the reaction and compounds to be used. It is preferable that condensation polymerization is progressed under an inert atmosphere such as argon, nitrogen and the like. The above-described solvent is preferably subjected to a dehydration treatment. However, this is not applicable to the case of a reaction in a two-phase system with water such as in the Suzuki coupling reaction, and the like.

Exemplified as the solvent are saturated hydrocarbons such as pentane, hexane, heptane, octane, cyclohexane, decalin and the like, aromatic hydrocarbons such as benzene, toluene, ethylbenzene, n-butylbenzene, xylene, mesitylene, tetralin and the like, halogenated saturated hydrocarbons such as carbon tetrachloride, chloroform, dichloromethane, chlorobutane, bromobutane, chloropentane, bromopentane, chlorohexane, bromohexane, chlorocyclohexane, bromocyclohexane and the like, halogenated aromatic hydrocarbons such as chlorobenzene, dichlorobenzene, trichlorobenzene and the like, alcohols such as methanol, ethanol, propanol, isopropanol, butanol, t-butyl alcohol and the like, carboxylic acids such as formic acid, acetic acid, propionic acid and the like, ethers such as dimethyl ether, diethyl ether, methyl t-butyl ether, tetrahydrofuran, tetrahydropyran, dioxane and the like, amines such as trimethylamine, triethylamine, N,N,N',N'-tetramethylethylenediamine, pyridine and the like, and amides such as N,N-dimethylformamide, N,N-dimethylacetamide, N,N-diethylacetamide, N-methylmorpholine oxide and the like. These solvents may be used singly or in admixture. Of them, ethers are preferable, and tetrahydrofuran and diethyl ether are further preferable, in the Yamamoto coupling reaction, and the like. A two-phase system of an aromatic hydrocarbon and water is preferable, and toluene, ethylbenzene, xylene and mesitylene are further preferable, in a two-phase reaction system with water such as the Suzuki coupling reaction, and the like.

In condensation polymerization, an alkali or a suitable catalyst may be added for progressing the reaction. These may be advantageously selected depending on the reaction to be used. As the alkali or catalyst, those which are sufficiently dissolved in the solvent used in the reaction are preferable. Examples of the alkali include inorganic bases such as potassium carbonate, sodium carbonate, cesium carbonate and the like; organic bases such as triethylamine and the like; and inorganic salts such as cesium fluoride and the like. Examples of the catalyst include palladium[tetrakis(triphenylphosphine)] and palladium acetates. As the method of mixing an alkali or a catalyst, there is exemplified a method in which a solution of an alkali or a catalyst is added slowly to a reaction solution under an inert atmosphere such as argon, nitrogen and the like while stirring the solution, or reversely, the reaction solution is slowly added to a solution of an alkali or a catalyst.

When the copolymer of the present invention is used in a polymer light emitting device such as a polymer eletroluminescent (EL) device and the like, the purity of the copolymer exerts an influence on the device performances such as a light emitting property and the like, thus, it is preferable to purify the monomer compound before polymerization by a method such as distillation, sublimation purification, re-crystallization and the like, then, to polymerize the monomer. Further, after polymerization, the resultant copolymer is preferably subjected to a purification treatment such as a demineralizing treatment, a metal removing treatment, precipitation purification, chromatographic fractionation and the like.

### <Composition>

The copolymer of the present invention can be used as a light emitting material, a hole transporting material and an electron transporting material of a polymer light emitting device, and for improving the property of the polymer light emitting device, at least one material selected from the group consisting of a light emitting material, a hole transporting material and an electron transporting material other than the copolymer can be combined to give a composition to be used.

The composition of the present invention contains the above-described copolymer and at least one material selected from the group consisting of a light emitting material, a hole transporting material and an electron transporting material. The above-described copolymer is not included in the light emitting material, hole transporting material and electron transporting material. The composition may contain two or more of the above-described copolymers. The composition may contain two or more light emitting materials, may contain two or more hole transporting materials, may contain two or more electron transporting materials, may contain a light emitting material and a hole transporting material, may contain a light emitting material and an electron transporting material, and may contain a hole transporting material and an electron transporting material.

The above-described light emitting material includes low molecular weight fluorescent materials, and examples thereof include naphthalene derivatives, anthracene, anthracene derivatives, pyrene, pyrene derivatives, perylene, perylene derivatives; dyes such as polymethine dyes, xanthene dyes, coumarine dyes, cyanine dyes and the like; metal complexes having 8-hydroxyquinoline as a ligand; metal complexes having a 8-hydroxyquinoline derivative as a ligand; other fluorescent metal complexes, aromatic amines, tetraphenylcyclopentadiene, tetraphenylcyclopentadiene derivatives, tetraphenylcyclobutadiene, tetraphenylcyclobutadiene derivatives, and low molecular weight fluorescent materials such as stilbene, silicon-containing aromatic, oxazole, furoxane, thiazole, tetraarylmethane, thiadiazole, pyrazole, metacyclophane, acetylene and the like. In addition to these light emitting materials, those described in JP-A No. 57-51781, JP-A NO. 59-194393 and the like are also mentioned. These light emitting materials may be used singly or in combination of two or more.

Examples of the above-described hole transporting material include polyvinylcarbazole and derivatives thereof, polysilane and derivatives thereof, polysiloxane derivatives having an aromatic amine in the side chain or the main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylenevinylene) and derivatives thereof, poly(2,5-thienylenevinylene) and derivatives thereof, and the like. These hole transporting materials may be used singly or in combination of two or more.

Examples of the above-described electron transporting material include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinoline derivatives; metal complexes of 8-hydroxyquinoline and derivatives thereof; polyquinoline and derivatives thereof, polyquinoxaline and derivatives thereof, polyfluorene and derivatives thereof, and the like. These electron transporting materials may be used singly or in combination of two or more.

When the composition of the present invention contains the above-described light emitting material, it is usual that the proportion of the light emitting material in the composition is preferably 1 wt% to 80 wt%, more preferably 5 wt% to 60 wt% with respect to the total weight of the composition.

When the composition of the present invention contains the above-described hole transporting material, it is usual that the proportion of the hole transporting material in the composition is preferably 1 wt% to 80 wt%, more preferably 5 wt% to 60 wt% with respect to the total weight of the composition.

When the composition of the present invention contains the above-described electron transporting material, it is usual that the proportion of the electron transporting material in the composition is preferably 1 wt% to 80 wt%, more preferably 5 wt% to 60 wt% with respect to the total weight of the composition.

It is preferable that the composition containing the copolymer of the present invention and a solvent is liquid in fabrication of a device, and typically, it is preferable that the composition is liquid under normal pressure (namely, 1 atm) at 25°C. The composition is called, in general, an ink, an ink composition, a solution or the like in some cases. The composition is useful for fabrication of a light emitting device such as a polymer light emitting device or the like.

Whe the composition of the present invention contains a solvent, it is usual that the proportion of the solvent in the composition is preferably 1 wt% to 99.9 wt%, more preferably 60 wt% to 99.9 wt%, further preferably 90 wt% to 99.8 wt% with respect to the total weight of the composition.

In the case of film formation using the above-described composition containing the copolymer of the present invention and a solvent in fabricating a polymer light emitting device, it may be advantageous to only remove a solvent by drying after application of the composition, and also in the case of mixing of the above-described light emitting material, hole transporting material and charge transporting material, the same means can be applied, that is, this method is advantageous for production. In drying, drying may be effected under heating at about 50 to 150°C, alternatively, drying may be carried out under a reduced pressure of about 10⁻³ Pa.

As the film formation method using the above-described composition, application methods such as a spin coat method, a casting method, a micro gravure coat method, a gravure coat method, a bar coat method, a roll coat method, a wire bar coat method, a dip coat method, a slit coat method, a capillary coat method, a spray coat method, a screen printing method, a flexo printing method, an offset printing method, an inkjet print method, a nozzle coat method and the like can be used. Printing methods such as a screen printing method, a flexo printing method, an offset printing method, an inkjet printing method and the like are preferable since pattern formation and multi-color separate painting are easy.

Though the viscosity of the above-described composition varies depending on the printing method, the viscosity at 25°C is preferably in the range of 0.5 to 500 mPa•s, and when a liquid composition passes through a discharge apparatus such as in an inkjet print method and the like, the viscosity at 25°C is preferably in the range of 0.5 to 20 mPa•s, for preventing clogging and flying curving in discharging.

As the solvent contained in the above-described composition, those capable of dissolving or dispersing components other than the solvent in the composition are preferable. Exemplified as the solvent are chlorine-containing solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene, trimethylbenzene, mesitylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, methyl benzoate, ethylcellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexane diol and the like and derivatives thereof, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide, and the like. These solvents may be used singly or in combination of two or more. Among the above-described solvents, an organic solvent having a structure containing a benzene ring and having a melting point of 0°C or lower and a boiling point of 100°C or higher is preferably contained from the standpoint of viscosity, film formability and the like.

Regarding the kind of the solvent, aromatic hydrocarbon solvents, aliphatic hydrocarbon solvents, ester solvents and ketone solvents are preferable from the standpoint of solubility of components other than the solvent in the liquid composition into the solvent, uniformity in film formation, viscosity property and the like, and specifically, toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone, dicyclohexyl ketone and bicyclohexyl methyl benzoate are preferable, and it is more preferable to contain at least one of xylene, anisole, mesitylene, cyclohexylbenzene and bicyclohexyl methyl benzoate.

The number of the solvent to be contained in the above-described composition is preferably 2 or more, more preferably 2 to 3, and further preferably 2 from the standpoint of film formability and from the standpoint of device properties and the like.

When two solvents are contained in the above-described composition, one of them may be solid at 25°C. From the standpoint of film formability, it is preferable that one solvent has a boiling point of 180°C or higher and another solvent has a boiling point of lower than 180°C, and it is more preferable that one solvent has a boiling point of 200°C or higher and another solvent has a boiling point of lower than 180°C. From the standpoint of viscosity, it is preferable that 0.2 wt% or more of components excepting solvents from the liquid composition are dissolved at 60°C in solvents, and it is preferable that 0.2 wt% or more of components excepting solvents from the liquid composition are dissolved at 25°C in one of two solvents.

When three solvents are contained in the liquid composition, one or two of them may be solid at 25°C. From the standpoint of film formability, it is preferable that at least one of three solvents has a boiling point of 180°C or higher and at least one solvent has a boiling point of 180°C or lower, and it is more preferable that at least one of three solvents has a boiling point of 200°C or higher and 300°C or lower and at least one solvent has a boiling point of 180°C or lower. From the standpoint of viscosity, it is preferable that 0.2 wt% or more of components excepting solvents from the liquid composition are dissolved at 60°C in two of three solvents, and it is preferable that 0.2 wt% or more of components excepting solvents from the liquid composition are dissolved at 25°C in one of three solvents.

When two or more solvents are contained in the above-described composition, the content of a solvent having the highest boiling point is preferably 40 to 90 wt%, more preferably 50 to 90 wt%, and further preferably 65 to 85 wt% with respect to the weight of all solvents contained in the liquid composition, from the standpoint of viscosity and film formability.

The composition of the present invention may also contain a stabilizer, an additive for adjusting viscosity and/or surface tension, an antioxidant and the like as other optional components in addition to the above-described copolymer, solvent, light emitting material, hole transporting material and electron transporting material. These optional components may be used singly or in combination of two or more.

Examples of the stabilizer which may be contained in the composition of the present invention include phenol antioxidants, phosphorus antioxidants and the like.

Examples of the additive for adjusting viscosity and/or surface tension which may be contained in the composition of the present invention include a high molecular weight compound and a poor solvent for enhancing viscosity (thickening agent), a low molecular weight compound for lowering viscosity, a surfactant for lowering surface tension, and combinations thereof.

As the above-described high molecular weight compound, those not disturbing light emission and charge transportation may be permissible, and when the composition contains a solvent, those which are usually soluble in the solvent are mentioned. As the high molecular weight compound, for example, polystyrene of high molecular weight, polymethyl methacrylate of high molecular weight, and the like can be used. The above-described high molecular weight compound has a polystyrene-equivalent weight average molecular weight of preferably 500000 or more, more preferably 1000000 or more. Also a poor solvent can be used as the thickening agent.

As the antioxidant which may be contained in the composition of the present invention, those not disturbing light emission and charge transportation may be permissible, and when the composition contains a solvent, those which are usually soluble in the solvent are mentioned.

As the antioxidant, phenol antioxidants, phosphorus antioxidants and the like are exemplified. By use of the antioxidant, the preservation stability of the above-described copolymer and solvent can be improved.

### <Film>

The film of the present invention will be illustrated. This film is obtained by using the above-described copolymer. As the kind of the film, a luminous film and a conductive film are exemplified. The film may contain a material selected from the group consisting of a light emitting material, a hole transporting material and a electron transporting material, in addition to the copolymer of the present invention.

The luminous film of the present invention contains the copolymer of the present invention. The luminous film may further contain a light emitting material, a hole transporting material or an electron transporting material, or a combination of two or more of them. Specific examples of these light emitting material, hole transporting material and electron transporting material are as described above. The luminous film has a light emission quantum yield of preferably 50% or more, more preferably 60% or more and further preferably 70% or more from the standpoint of the luminance and light emission voltage of a device and the like.

The conductive film preferably has a surface resistance of 1 KΩ/□ or less. By doping the film with a Lewis acid, an ionic compound or the like, electric conductivity can be enhanced. The surface resistance is more preferably 100 KΩ/□ or less, further preferably 10 KΩ/□ or less.

### <Polymer light emitting device>

Next, the polymer light emitting device of the present invention will be described.

The polymer light emitting device of the present invention has an anode, a cathode, and an organic layer containing the above-described copolymer and disposed between the anode and the cathode. The above-described organic layer may further contain a light emitting layer, a hole transporting layer, an electron transporting material, or a combination of two or more of them. Specific examples of these light emitting material, hole transporting material and electron transporting material are as described above. In the polymer light emitting device of the present invention, it is preferable that the above-described organic layer is a light emitting layer.

The polymer light emitting device of the present invention includes (1) a polymer light emitting device having an electron transporting layer disposed between a cathode and a light emitting layer, (2) a polymer light emitting device having a hole transporting layer disposed between an anode and a light emitting layer, (3) a polymer light emitting device having an electron transporting layer disposed between a cathode and a light emitting layer and having a hole transporting layer disposed between an anode and a light emitting layer; and the like.

More specifically, the following structures a) to d) are exemplified.
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode (wherein, "/" means adjacent lamination of layers; the same shall apply hereinafter.)

Here, the light emitting layer is a layer having a function of emitting light, the hole transporting layer is a layer having a function of transporting holes, and the electron transporting layer is a layer having a function of transporting electrons. The electron transporting layer and the hole transporting layer are collectively called a charge transporting layer. Two or more light emitting layers, two or more hole transporting layers and two or more electron transporting layers may be independently used.

As the method of film formation of a light emitting layer, methods of film formation from a solution are exemplified.

For film formation from a solution, application methods such as a spin coat method, a casting method, a micro gravure coat method, a gravure coat method, a bar coat method, a roll coat method, a wire bar coat method, a dip coat method, a slit coat method, a capillary coat method, a spray coat method, a screen printing method, a flexo printing method, an offset printing method, an inkjet print method, a nozzle coat method and the like can be used. Printing methods such as a screen printing method, a flexo printing method, an offset printing method, an inkjet printing method and the like are preferable since pattern formation and multi-color separate painting are easy.

In the case of film formation from a solution using the copolymer of the present invention in fabricating a polymer light emitting device, it may be advantageous to only remove a solvent by drying after application of this solution, and also in the case of mixing of the above-described light emitting material, hole transporting material and charge transporting material, the same means can be applied, that is, this method is advantageous for production.

The thickness of a light emitting layer shows an optimum value varying depending on a material to be used, and may be advantageously selected so as to give appropriate values of driving voltage and light emission efficiency, and is, for example 1 nm to 1 µm, preferably 2 nm to 500 nm, and further preferably 5 nm to 200 nm.

In the polymer light emitting device of the present invention, a light emitting material other than the above-described copolymer may be mixed and used in a light emitting layer. In the polymer light emitting device of the present invention, a light emitting layer containing a light emitting material other than the above-described copolymer may be laminated with a light emitting layer containing the above-described copolymer.

As the light emitting material other than the above-described copolymer, known materials can be used. As the compounds of low molecular weight, for example, naphthalene derivatives, anthracene and derivatives thereof, perylene and derivatives thereof, dyes such as polymethines, xanthenes, coumarins and cyanines, metal complexes of 8-hydroxyquinoline and derivatives thereof, aromatic amines, tetraphenylcyclopentadiene and derivatives thereof, tetraphenylbutadiene and derivatives thereof, and the like can be used. As the light emitting material, those described in JP-A Nos. 57-51781 and 59-194393 can also be used.

When the polymer light emitting device of the present invention has a hole transporting layer, exemplified as the hole transporting material to be used are polyvinylcarbazole and its derivatives, polysilane and its derivatives, polysiloxane derivatives having an aromatic amine on the side chain or main chain, pyrazoline derivatives, arylamine derivatives, stilbene derivatives, triphenyldiamine derivatives, polyaniline and its derivatives, polythiophene and its derivatives, polypyrrole and its derivatives, poly(p-phenylenevinylene) and its derivatives, poly(2,5-thienylenevinylene) and its derivatives, and the like. As the hole transporting material, those described in JP-A Nos. 63-70257, 63-175860, 2-135359, 2-135361, 2-209988, 3-37992 and 3-152184 can also be used.

Among them, preferable as the hole transporting material used in a hole transporting layer are high molecular weight hole transporting materials such as polyvinylcarbazole and its derivatives, polysilane and its derivatives, polysiloxane derivatives having an aromatic amine compound group on the side chain or main chain, polyaniline and its derivatives, polythiophene and its derivatives, poly(p-phenylenevinylene) and its derivatives, poly(2,5-thienylenevinylene) and its derivatives, and the like, and further preferable are polyvinylcarbazole and its derivatives, polysilane and its derivatives, and polysiloxane derivatives having an aromatic amine on the side chain or main chain. In the case of a low molecular weight hole transporting material, it is preferable that the hole transporting material is dispersed in a polymer binder in use.

Polyvinylcarbazole and its derivative are obtained, for example, from a vinyl monomer by cation polymerization or radical polymerization.

As the polysilane and its derivative, compounds described in Chemical Review (Chem. Rev.), vol. 89, p. 1359 (1989) and GB Patent No. 2300196 publication are exemplified. Also as the synthesis method, methods described in them can be used, and particularly, the Kipping method is suitably used.

In the polysiloxane derivative, the siloxane skeleton structure shows little hole transportability, thus, those having a structure of the above-mentioned low molecular weight hole transporting material on the side chain or main chain are suitably used. Particularly, those having an aromatic amine showing hole transportability on the side chain or main chain are exemplified.

Regarding the film formation method of a hole transporting layer, in the case of a low molecular weight hole transporting material, a method of film formation from a mixed solution with a polymer binder is exemplified, and in the case of a high molecular weight hole transporting material, a method of film formation from a solution is exemplified.

The solvent to be used for film formation from a solution may be advantageously one which dissolves a hole transporting material. Exemplified as the solvent are chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

As the film formation method from a solution, there can be used application methods such as a spin coat method, a casting method, a micro gravure coat method, a gravure coat method, a bar coat method, a roll coat method, a wire bar coat method, a dip coat method, a slit coat method, a capillary coat method, a spray coat method, a screen printing method, a flexo printing method, an offset printing method, an inkjet print method, a nozzle coat method and the like. Printing methods such as a screen printing method, a flexo printing method, an offset printing method, an inkjet printing method and the like are preferable since pattern formation and multi-color separate painting are easy.

As the polymer binder to be mixed, those not extremely disturbing charge transportation are preferable, and those showing no strong absorption against visible light are suitably used. Exemplified as the polymer binder are polycarbonate, polyacrylate, polymethyl acrylate, polymethyl methacrylate, polystyrene, polyvinyl chloride, polysiloxane and the like.

Regarding the thickness of a hole transporting layer, the optimum value varies depending on a material to be used, and it may be advantageously selected so that the driving voltage and light emission efficiency become optimum, and a thickness at least causing no formation of pin holes is necessary, and when the thickness is too large, the driving voltage of a device increases undesirably. Therefore, the thickness of the hole transporting layer is for example 1 nm to 1 µm, preferably 2 nm to 500 nm, and further preferably 5 nm to 200 nm.

When the polymer light emitting device of the present invention has an electron transporting layer, known compounds can be used as the electron transporting material to be used, and exemplified are oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and the like. As the electron transporting material, those described in JP-A Nos. 63-70257, 63-175860, 2-135359, 2-135361, 2-209988, 3-37992 and 3-152184, and the like can also be used.

Of them, oxadiazole derivatives, benzoquinone and its derivatives, anthraquinone and its derivatives, metal complexes of 8-hydroxyquinoline and its derivatives, polyquinoline and its derivatives, polyquinoxaline and its derivatives, polyfluorene and its derivatives are preferable, and 2-(4-biphenylyl)-5-(4-t-butylphenyl)-1,3,4-oxadiazole, benzoqinone, anthraquinone, tris(8-quinolinol)aluminum and polyquinoline are further preferable.

A the film formation method of an electron transporting layer, a vacuum vapor-deposition method from a powder and a method of film formation from a solution or melted state are exemplified in the case of an electron transporting material of low molecular weight, and a method of film formation from a solution or melted state is exemplified in the case of an electron transporting material of high molecular weight, respectively. In film formation from a solution or melted state, a polymer binder may also be used together.

The solvent to be used for film formation from a solution may be advantageously one which dissolves an electron transporting material and/or a polymer binder. Exemplified as the solvent are chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

As the film formation method from a solution or melted state, application methods such as a spin coat method, a casting method, a micro gravure coat method, a gravure coat method, a bar coat method, a roll coat method, a wire bar coat method, a dip coat method, a slit coat method, a capillary coat method, a spray coat method, a screen printing method, a flexo printing method, an offset printing method, an inkjet printing method, a nozzle coat method and the like can be used. Printing methods such as a screen printing method, a flexo printing method, an offset printing method, an inkjet printing method and the like are preferable since pattern formation and multi-color separate painting are easy.

As the polymer binder to be mixed, those not extremely disturbing charge transportation are preferable, and those showing no strong absorption against visible light are suitably used. Exemplified as the polymer binder are poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride, polysiloxane and the like.

Regarding the thickness of an electron transporting layer, the optimum value varies depending on a material to be used, and it may be advantageously selected so that the driving voltage and light emission efficiency become optimum, and a thickness at least causing no formation of pin holes is necessary, and when the thickness is too large, the driving voltage of a device increases undesirably. Therefore, the thickness of the electron transporting layer is for example 1 nm to 1 µm, preferably 2 nm to 500 nm, and further preferably 5 nm to 200 nm.

Among charge transporting layers disposed adjacent to an electrode, those having a function of improving charge injection efficiency from an electrode and having an effect of lowering the driving voltage of a device are, in particular, called a charge injection layer (hole injection layer, electron injection layer) in some cases.

Further, for improving close adherence with an electrode or improving charge injection from an electron, the above-mentioned charge injection layer or insulation layer may be disposed adjacent to the electrode, alternatively, for improving close adherence of an interface or preventing mixing, a thin buffer layer may be inserted into an interface of a charge transporting layer and a light emitting layer.

The order and number of layers to be laminated, and the thickness of each layer may be appropriately selected in view of light emission efficiency and device life.

In the present invention, the polymer light emitting device carrying a charge injection layer (electron injection layer, hole injection layer) includes polymer light emitting devices having a charge injection layer disposed adjacent to one of an anode and a cathode or adjacent to both electrodes.

For example, the following structures e) to p) are mentioned specifically.
e) anode/charge injection layer/light emitting layer/cathode
f) anode/light emitting layer/charge injection layer/cathode
g) anode/charge injection layer/light emitting layer/charge injection layer/cathode
h) anode/charge injection layer/hole transporting layer/light emitting layer/cathode
i) anode/hole transporting layer/light emitting layer/charge injection layer/cathode
j) anode/charge injection layer/hole transporting layer/light emitting layer/charge injection layer/cathode
k) anode/charge injection layer/light emitting layer/charge transporting layer/cathode
l) anode/light emitting layer/electron transporting layer/charge injection layer/cathode
m) anode/charge injection layer/light emitting layer/electron transporting layer/charge injection layer/cathode
n) anode/charge injection layer/hole transporting layer/light emitting layer/charge transporting layer/cathode
o) anode/hole transporting layer/light emitting layer/electron transporting layer/charge injection layer/cathode
p) anode/charge injection layer/hole transporting layer/light emitting layer/electron transporting layer/charge injection layer/cathode

As the charge injection layer, exemplified are a layer containing an electric conductive polymer, a layer disposed between an anode and a hole transporting layer and containing a material having ionization potential of a value between an anode material and a hole transporting material contained in a hole transporting layer, and a layer disposed between a cathode and an electron transporting layer and containing a material having electron affinity of a value between a cathode material and an electron transporting material contained in an electron transporting layer.

When the above-mentioned charge injection layer contains an electric conductive polymer, the electric conductivity of the electric conductive polymer is preferably 10⁻⁵ S/cm or more and 10³ S/cm or less, and for decreasing leak current between light emission picture elements, more preferably 10⁻⁵ S/cm or more and 10² S/cm or less, and further preferably 10⁻⁵ S/cm or more and 10¹ S/cm or less. Usually, for controlling the electric conductivity of the electric conductive polymer to 10⁻⁵ S/cm or more and 10³ S/cm or less, the electric conductive polymer is doped with a suitable amount of ions.

As the kind of ions to be doped, an anion is used in the case of a hole injection layer and a cation is used in the case of an electron injection layer. Examples of the anion include a polystyrenesulfonic ion, an alkylbenzenesulfonic ion, a camphorsulfonic ion and the like, and examples of the cation include a lithium ion, a sodium ion, a potassium ion, a tetrabutylammonium ion and the like.

The thickness of the charge injection layer is usually 1 nm to 100 nm, preferably 2 nm to 50 nm.

The material to be used in the charge injection layer may be appropriately selected depending on a relation with materials of an electrode and an adjacent layer, and exemplified are electric conductive polymers such as polyaniline and its derivatives, polythiophene and its derivatives, polypyrrole and its derivatives, polyphenylenevinylene and its derivatives, polythienylenevinylene and its derivatives, polyquinoline and its derivatives, polyquinoxaline and its derivatives, polymers containing an aromatic amine structure on the main chain or side chain, and the like, and metal phthalocyanines (copper phthalocyanine and the like), carbon and the like.

The insulation layer has a function of making charge injection easy. The average thickness of this insulation layer is usually 0.1 to 20 nm, preferably 0.5 to 10 nm, more preferably 1 to 5 nm.

As the material of the insulation layer, metal fluorides, metal oxides, organic insulating materials and the like are mentioned. As the polymer light emitting device carrying an insulation layer provided thereon, there are mentioned polymer light emitting devices in which an insulation layer is disposed adjacent to one of an anode and a cathode or adjacent to both electrodes.

For example, the following structures q) to ab) are mentioned specifically.
q) anode/insulation layer/light emitting layer/cathode
r) anode/light emitting layer/insulation layer/cathode
s) anode/insulation layer/light emitting layer/insulation layer/cathode
t) anode/insulation layer/hole transporting layer/light emitting layer/cathode
u) anode/hole transporting layer/light emitting layer/insulation layer/cathode
v) anode/insulation layer/hole transporting layer/light emitting layer/insulation layer/cathode
w) anode/insulation layer/light emitting layer/electron transporting layer/cathode
x) anode/light emitting layer/electron transporting layer/insulation layer/cathode
y) anode/insulation layer/light emitting layer/electron transporting layer/insulation layer/cathode
z) anode/insulation layer/hole transporting layer/light emitting layer/electron transporting layer/cathode
aa) anode/hole transporting layer/light emitting layer/electron transporting layer/insulation layer/cathode
ab) anode/insulation layer/hole transporting layer/light emitting layer/electron transporting layer/insulation layer/cathode

The substrate which forms a polymer light emitting device of the present invention may advantageously be one which does not change in forming an electrode and a layer of an organic substance, and substrates made of glass, plastic, polymer film, silicon and the like are exemplified. In the case of an opaque substrate, it is preferable that the opposite electrode to an electrode nearer to the substrate is transparent or semi-transparent.

In the present invention, it is usually preferable that at least one of electrodes consisting of an anode and a cathode is transparent or semi-transparent, and the anode side is transparent or semi-transparent.

As the material of the anode, an electric conductive metal oxide membrane, a semi-transparent metal film and the like are used. Specifically, membranes (NESA and the like) formed by using electric conductive materials composed of indium oxide, zinc oxide, tin oxide, and composite thereof: indium•tin•oxide (ITO), indium•zinc•oxide and the like, and gold, platinum, silver, copper and the like are used, and ITO, indium•zinc•oxide and tin oxide are preferable. As the anode fabrication method, a vacuum vapor-deposition method, a sputtering method, an ion plating method, a plating method and the like are mentioned. As the anode, organic transparent electric conductive membranes made of polyaniline and its derivatives, polythiophene and its derivatives, and the like may be used.

The thickness of an anode can be selected in view of light transmission and electric conductivity, and it is usually 10 nm to 10 µm, preferably 20 nm to 1 µm, and further preferably 50 nm to 500 nm.

For making electric charge injection easy, a layer made of a phthalocyanine derivative, an electric conductive polymer, carbon and the like, or a layer made of a metal oxide, a metal fluoride, an organic insulation material and the like, may be provided on an anode.

As the material of a cathode, materials of small work function are preferable, and for example, metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys composed of two or more of them, or alloys composed of at least one of them and at least one of gold, silver, platinum, copper, manganese, titanium, cobalt, nickel, tungsten and tin, and, graphite or graphite intercalation compounds and the like are used. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like. The cathode may take a laminated structure consisting of two or more layers.

The thickness of a cathode can be selected in view of electric conductivity and durability, and it is usually 10 nm to 10 µm, preferably 20 nm to 1 µm, and further preferably 50 nm to 500 nm.

As the cathode fabrication method, a vacuum vapor-deposition method, a sputtering method, a lamination method of thermally press-binding a metal film, and the like are used.

A layer made of an electric conductive polymer, or a layer made of a metal oxide, a metal fluoride, an organic insulation material and the like, may be provided between a cathode and an organic substance layer, and after fabrication of a cathode, a protective layer for protecting the polymer light emitting device may be installed. For use of the polymer light emitting device stably for a long period of time, it is preferable to install a protective layer and/or protective cover, for protecting a device from outside.

As the protective layer, resins, metal oxides, metal fluorides, metal borides and the like can be used. As the protective cover, a glass plate, and a plastic plate having a surface which has been subjected to a low water permeation treatment, and the like can be used, and a method in which the cover is pasted to a device substrate with a thermosetting resin or a photo-curing resin to attain sealing is suitably used. When a space is kept using a spacer, blemishing of a device can be prevented easily. If an inert gas such as nitrogen, argon and the like is filled in this space, oxidation of a cathode can be prevented, further, by placing a drying agent such as barium oxide and the like in this space, it becomes easy to suppress moisture adsorbed in a production process from imparting a damage to the device. It is preferable to adopt at least one strategy among these methods.

The polymer light emitting device of the present invention shows light emission for a long period of time. Evaluation of the period is performed based on a time of reduction from the driving initiation luminance to 75% luminance, or a time of reduction from the driving initiation luminance to 50% luminance, though varying depending on the use of the polymer light emitting device.

The polymer light emitting device of the present invention can be used for a planar light source, displays such as a segment display, a dot matrix display, a liquid crystal display (for example, back light, etc.) and the like, a light source of an electrophotography mode printer (that is, a material for a printer head), a material for an image sensor, a material for an optical fiber, and the like.

For obtaining light emission in the form of plane using the polymer light emitting device of the present invention, it may be advantages to place a planar anode and a planar cathode so as to overlap. For obtaining light emission in the form of pattern, there are a method in which a mask having a window in the form of pattern is placed on the surface of the above-mentioned planar light emitting device, a method in which an organic layer in non-light emitting parts is formed with extremely large thickness to give substantially no light emission, a method in which either an anode or a cathode, or both electrodes are formed in the form pattern. By forming a pattern by any of these methods, and placing several electrodes so that on/off is independently possible, a display of segment type is obtained which can display digits, letters, simple marks and the like. Further, for providing a dot matrix device, it may be permissible that both an anode and a cathode are formed in the form of stripe, and placed so as to cross. By using a method in which several polymer compounds showing different emission colors are painted separately or a method in which a color filter or a fluorescence conversion filter is used, partial color display and multi-color display are made possible. In the case of a dot matrix device, passive driving is possible, and active driving may be carried out in combination with TFT and the like. These display devices can be used as a display of a computer, a television, a portable terminal, a cellular telephone, a car navigation, a view finder of a video camera, and the like.

Further, the above-mentioned planar light emitting device is of self emitting and thin type, and can be suitably used as a planar light source for back light of a liquid crystal display, or as a planar light source for illumination. If a flexible substrate is used, it can also be used as a curved light source or display.

### <Organic transistor>

Next, a polymer electric field effect type transistor as one embodiment of organic transistors will be described.

The polymer compound of the present invention can be suitably used as a material of a polymer electric field effect type transistor, particularly, as a material of an active layer. Regarding the structure of a polymer electric field effect type transistor, it may be usually advantageous that a source electrode and a drain electrode are placed in contact with an active layer composed of the polymer, further, a gate electrode is placed sandwiching an insulation layer in contact with the active layer.

The polymer electric field effect type transistor is usually formed on a supporting substrate. The material of the supporting substrate is not particularly restricted providing that it does not disturb a property as an electric field effect type transistor, and glass substrates and flexible film substrates and plastic substrates can also be used.

The polymer electric field effect type transistor can be produced by known methods described, for example, in JP-A No. 5-110069.

It is advantageous and preferable for production to use a copolymer soluble in an organic solvent, in forming an active layer. As the method of film formation from a solution prepared by dissolving an organic solvent-soluble copolymer in a solvent, application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method and the like can be used.

Preferable is an encapsulated polymer electric field effect type transistor obtained by fabricating a polymer electric field effect type transistor, then, encapsulating this. By this, the polymer electric field effect type transistor is blocked from atmospheric air, thus, lowering of properties of the polymer electric field effect type transistor can be suppressed.

As the encapsulation method, a method of covering with an ultraviolet (UV) hardening resin, a thermosetting resin, an inorganic SiONx membrane and the like, a method of pasting a glass plate or a film with an UV hardening resin, a thermosetting resin or the like, and other methods are mentioned. For effectively performing blocking from atmospheric air, it is preferable that processes after fabrication of a polymer electric field effect type transistor until encapsulation are carried out without exposing to atmospheric air (for example, in dried nitrogen atmosphere, in vacuum and the like).

### <Photoelectric conversion device >

Next, the photoelectric conversion device will be described. The photoelectric conversion device can be used in applications such as a solar battery, an optical sensor and the like. Here, a solar battery which is one embodiment of photoelectric conversion devices will be described.

The copolymer of the present invention can be suitably used as a material of a solar battery, particularly, as an organic semiconductor layer of a schottky barrier type device utilizing an interface between an organic semiconductor and a metal, or as an organic semiconductor layer of a pn hetero junction type device utilizing an interface between an organic semiconductor and an inorganic semiconductor or between organic semiconductors.

Further, the copolymer of the present invention can be suitably used as an electron donating polymer or an electron accepting polymer in a bulk hetero junction type device in which the donor-acceptor contact area is increased, or an electron donating conjugated polymer (dispersion supporting body) of a solar battery using a high molecular weight-low molecular weight composite system, for example, a bulk hetero junction type organic photoelectric conversion device containing a fullerene derivative dispersed as an electron acceptor. When the copolymer of the present invention is used in a solar battery, high conversion efficiency can be obtained.

With respect to the structure of a solar battery, in the case of a pn hetero junction type device, it is advantageous that a p type semiconductor layer is formed on an ohmic electrode, for example, on ITO, further, an n type semiconductor layer is laminated, and an ohmic electrode is provided thereon.

A solar battery is usually formed on a supporting substrate. The material of the supporting substrate is not particularly restricted providing that it does not disturb a property as an organic photoelectric conversion device, and glass substrates and flexible film substrates and plastic substrates can also be used.

A solar battery can be produced by known methods described, for example, in Synth. Met., 102, 982 (1999), and Science, 270, 1789 (1995).

### EXAMPLES

Examples and comparative examples will be shown below for illustrating the present invention further in detail, but the present invention is not limited to these examples.

The polystyrene-equivalent number average molecular weight and weight average molecular weight of a copolymer were measured by size exclusion chromatography (SEC) (manufactured by Shimadzu Corporation, trade name: LC-10 Avp). A copolymer to be measured was dissolved in tetrahydrofuran so as to give a concentration of about 0.5 wt%, and 50 µL of the solution was injected into SEC. Tetrahydrofuran was used as the mobile phase of SEC, and allowed to flow at a flow rate of 0.6 mL/min. As the column, two TSKgel Super HM-H (manufactured by Tosoh Corp.) and one TSKgel Super H2000 (manufactured by Tosoh Corp.) were connected serially. A differential refractive index detector (manufactured by Shimadzu Corp., trade name: RID-10A) was used as a detector.

### <Example 1> [Synthesis of copolymer <P-1>]

### (Synthesis of pentamer 1)

A pentamer 1 was synthesized by a method described in Japanese Patent Application National Publication (Laid-Open) No. 2004-534863.

4,7-bis(5-bromo-4-hexylthien-2-yl)-2,1,3-benzothiadiazole and 2-(tributylstannyl)thiophene were dissolved in toluene, and reacted for 18 hours while refluxing with heating in the presence of tetrakis(triphenylphosphine)palladium. The resultant reaction product was cooled down to room temperature, and filtrated through silica gel. The filtrate was concentrated and re-crystallized from hexane.

The re-crystallized intermediate was dissolved in DMF, further, a DMF solution of N-bromosuccinimide was dropped, and the mixture was stirred overnight at room temperature. The product was filtrated, and washed with methanol and deionized water. The washed product was re-crystallized from hexane, to obtain a pentamer 1.

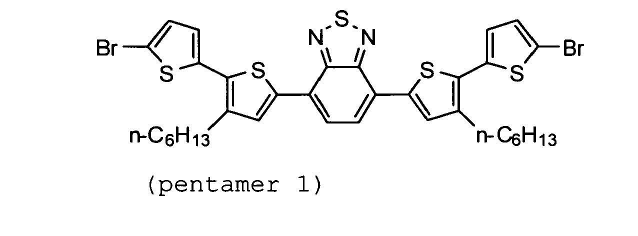

### (Synthesis of 4,7-bis(5-bromo-4-methylthiophen-2-yl)-2,1,3-benzothiadiazole)

4,7-dibromo-2,1,3-benzothiadiazole and 4-methylthiophene-2-boronic acid were dissolved in toluene, and 2 M sodium carbonate was added and the mixture was refluxed with heating in the presence of palladium acetate and triphenylphosphine, to synthesize 4,7-bis(4-methylthiophen-2-yl)-2,1,3-benzothiadiazole. 4,7-bis(4-methylthien-2-yl)-2,1,3-benzothiadiazole and N-bromosuccinimide were stirred at 70°C in o-dichlorobenzene. To the resultant reaction product was added ethanol, then, the mixture was cooled down to room temperature, to obtain a precipitate, and this precipitate was filtrated to obtain a crude product. The crude product was washed with water and ethanol, to obtain 4,7-bis(5-bromo-4-methylthiophen-2-yl)-2,1,3-benzothiadiazole represented by the following the formula.

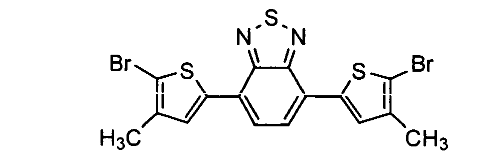

### (Synthesis of 4,7-bis(5-bromothiophen-2-yl)-2,1,3-benzothiadiazole)

4,7-dibromo-2,1,3-benzothiadiazole and 2-(tributylstannyl)thiophene were dissolved in THF, the solution was refluxed with heating in the presence of dichlorobis(triphenylphosphine)palladium, to synthesize 4,7-bis(2-thienyl)-2,1,3-benzothiadiazole. 4,7-bis(2-thienyl)-2,1,3-benzothiadiazole and N-bromosuccinimide were stirred at 140°C in o-dichlorobenzene. The resultant reaction product was cooled down to room temperature to find generation of a solid, and this solid was filtrated to obtain a crude product. The crude product was washed with water and ethanol. The crude product was re-crystallized from o-dichlorobenzene, to obtain 4,7-bis(5-bromothiophen-2-yl)-2,1,3-benzothiadiazole represented by the following the formula.

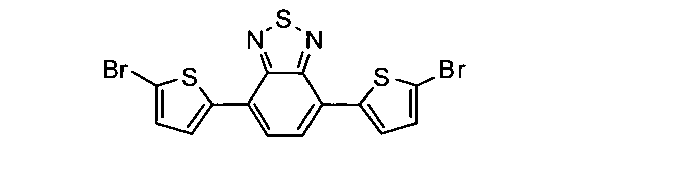

Under an inert atmosphere, 2,7-bis(1,3,2-dioxaborolan-2-yl)-9,9-dihexylfluorene (0.78 g), 4,7-dibromo-2,1,3-benzothiadiazole (0.29 g), 4,7-bis(5-bromo-4-methylthiophen-2-yl)-2,1,3-benzothiadiazole (0.21 g), 4,7-bis(5-bromothiophen-2-yl)-2,1,3-benzothiadiazole (0.10 g), pentamer 1 (0.17 g), dichlorobis(triphenylphosphine)palladium (3.9 mg), methyltrioctyl ammonium chloride (trade name: Aliquat (registered trademark) 336, manufactured by Aldrich) (0.76 g) and toluene (18 mL) were mixed, and heated at 105°C. Into thus obtained reaction solution was dropped a 17.5 wt% sodium carbonate aqueous solution (5 mL), and the mixture was refluxed for 1.5 hours, to obtain a compound having a block (A). The block (A) had a polystyrene-equivalent number average molecular weight of 6.0×10³ and a polystyrene-equivalent weight average molecular weight of 1.9×10⁴. The degree of polymerization of the block (A) was about 20, estimated from this polystyrene-equivalent number average molecular weight. The solution of the compound having the resultant block (A) was cooled down to 70°C, then, the reaction solution was mixed with 2,7-bis(1,3,2-dioxaborolan-2-yl)-9,9-dihexylfluorene (1.85 g), 2,7-dibromo-9,9-dihexylfluorene (0.96 g), bis(4-bromophenyl)-(4-secondary butylphenyl)-amine (0.74 g), dichlorobis(triphenylphosphine)palladium (7.5 mg) and toluene (36 mL), and the mixture was heated at 105°C. Into the resultant the reaction solution was added a 17.5 wt% sodium carbonate aqueous solution (9.7 mL), and the mixture was refluxed for 17 hours. To this was added phenylboronic acid (0.66 g), and the mixture was further refluxed for 9 hours. Then, a sodium N,N-diethyldithiocarbamate aqueous solution was added and the mixture was stirred at 80°C for 2 hours. After cooling, the solution was washed with water (70 mL) twice, with a 3 wt% acetic acid aqueous solution (70 mL) twice, and with water (70 mL) twice, and the organic layer was dropped into methanol (850 mL) to find generation of a precipitate, and this precipitate was filtrated, then, dried to obtain a solid. This solid was dissolved in toluene, and purified by passing through an alumina column and a silica gel column. The resultant toluene solution was dropped into methanol (850 mL), and the precipitate was filtrated, then, dried. The yielded amount of the resultant copolymer <P-1> was 2.72 g.

The copolymer <P-1> had a polystyrene-equivalent number average molecular weight of 4.5×10⁴ and a polystyrene-equivalent weight average molecular weight of 1.5×10⁵.

The copolymer <P-1> has the following block (A) and the following block (B). In the block (A), the total content ratio of a repeating unit represented by the formula (I-1) is 2 mol% with respect to all repeating units, and the content ratio of two kinds of repeating units represented by the formula (I-2) is 6 mol% with respect to all repeating units. The ratio of the block (A) in the copolymer <P-1> is 32.3 mol% and the content ratio of the block (B) is 67.7 mol%, calculated from the charged raw materials.

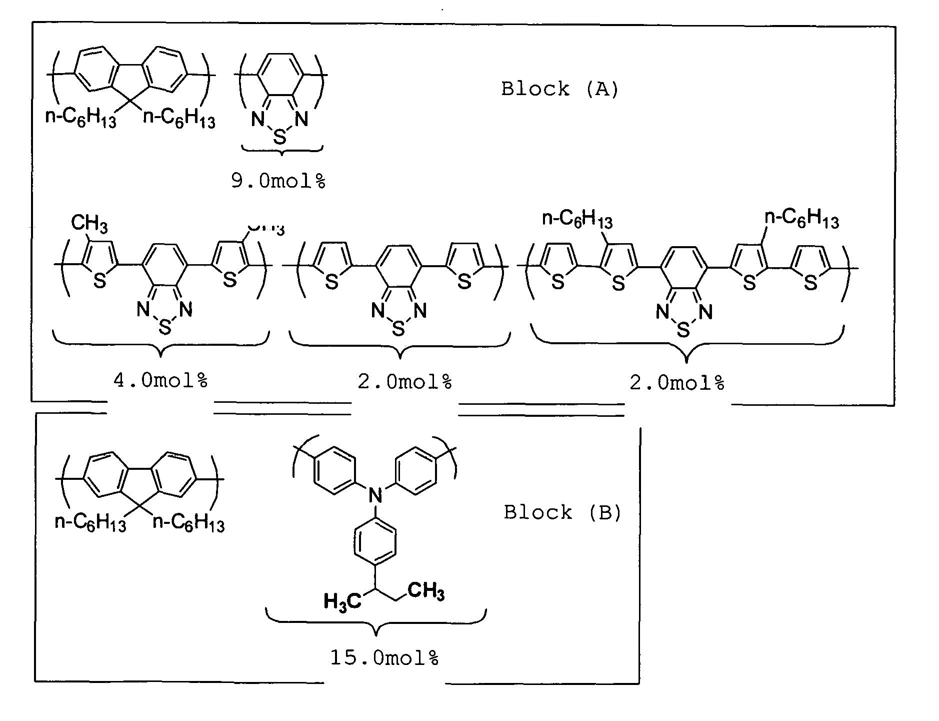

### <Synthesis Example 1> [Synthesis of copolymer <P-2>]

Under an inert atmosphere, 2,7-bis(1,3,2-dioxaborolan-2-yl)-9,9-dihexylfluorene (0.72 g), 4,7-dibromo-2,1,3-benzothiadiazole (0.33 g), 4,7-bis(5-bromo-4-methylthiophen-2-yl)-2,1,3-benzothiadiazole (0.18 g), 4,7-bis(5-bromothiophen-2-yl)-2,1,3-benzothiadiazole (0.08 g), dichlorobis(triphenylphosphine)palladium (3.5 mg), methyltrioctyl ammonium chloride (trade name: Aliquat (registered trademark) 336, manufactured by Aldrich) (0.22 g) and toluene (17 mL) were mixed, and heated at 105°C. Into the resultant the reaction solution was dropped a 2 M sodium carbonate aqueous solution (5 mL), and the mixture was refluxed for 2 hours, to obtain a compound having a block (A). The block (A) had a polystyrene-equivalent number average molecular weight of 3.7×10³ and a polystyrene-equivalent weight average molecular weight of 1.8x10⁴. The degree of polymerization of the block (A) was about 14, estimated from this polystyrene-equivalent number average molecular weight. The solution of the compound having the resultant block (A) was cooled down to 70°C, then, the reaction solution was mixed with 2,7-bis(1,3,2-dioxaborolan-2-yl)-9,9-dihexylfluorene (1.43 g), 2,7-dibromo-9,9-dihexylfluorene (0.62 g), bis(4-bromophenyl)-(4-secondary butylphenyl)-amine (0.73 g), dichlorobis(triphenylphosphine)palladium (6.0 mg), methyltrioctyl ammonium chloride (trade name: Aliquat (registered trademark) 336, manufactured by Aldrich) (0.37 g) and toluene (30 mL), and the mixture was heated at 105°C. Into the resultant the reaction solution was dropped a 2 M sodium carbonate aqueous solution (8 mL), and the mixture was refluxed for 5 hours. After the reaction, phenylboronic acid (0.05 g) was added, and the mixture was further refluxed for 2 hours. Then, to this was added a sodium diethyldithiacarbamate aqueous solution and the mixture was stirred at 80°C for 2 hours. After cooling, the solution was washed with water (100 mL) twice, with a 3 wt% acetic acid aqueous solution (100 mL) twice, and with water (100 mL) twice, and purified by passing through an alumina column and a silica gel column. The resultant toluene solution was dropped into methanol (1.5 L), and the mixture was stirred for 1 hour, then, the resultant solid was filtrated and dried. The yielded amount of the resultant copolymer <P-2> was 2.24 g.

The copolymer <P-2> had a polystyrene-equivalent number average molecular weight of 1.0×10⁵ and a polystyrene-equivalent weight average molecular weight of 2.7×10⁵.

The copolymer <P-2> has the following block (A) and the following block (B). In the block (A), a repeating unit represented by the formula (I-1) is not contained, and the content ratio of a repeating unit represented by the formula (I-2) is 6 mol% with respect to all repeating units. The ratio of the block (A) in the copolymer <P-2> is 28.5 mol% and the content ratio of the block (B) is 71.5 mol%, calculated from the charged raw materials.

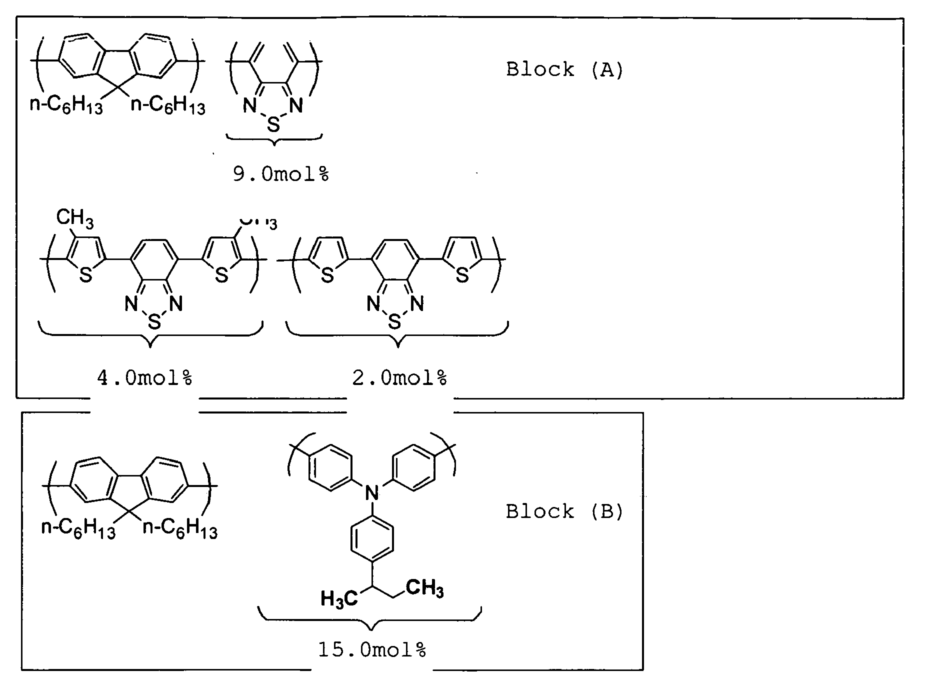

### <Synthesis Example 2> [Synthesis of copolymer <P-3>]

Under an inert atmosphere, 2,7-bis(1,3,2-dioxaborolan-2-yl)-9,9-dihexylfluorene (1.42 g), 4,7-dibromo-2,1,3-benzothiadiazole (0.16 g), 4,7-bis(5-bromo-4-methylthiophen-2-yl)-2,1,3-benzothiadiazole (0.12 g), 4,7-bis(5-bromothiophen-2-yl)-2,1,3-benzothiadiazole (0.06 g), pentamer 1 (0.09 g), bis(4-bromophenyl)-(4-secondary butylphenyl)-amine (0.41 g), 2,7-dibromo-9,9-dihexylfluorene (0.53 g), dichlorobis(triphenylphosphine)palladium (6.3 mg), methyltrioctyl ammonium chloride (trade name: Aliquat (registered trademark) 336, manufactured by Aldrich) (0.39 • g) and toluene (30 mL) were mixed, and heated at 105°C. Into the resultant the reaction solution was dropped a 17.5 wt% sodium carbonate aqueous solution (8.2 mL), and the mixture was refluxed for 3 hours. To this was added phenylboronic acid (0.37 g), and the mixture was further refluxed for 16 hours. Then, a sodium N,N-diethyldithiocarbamate aqueous solution was added and the mixture was stirred at 80°C for 2 hours. The resultant reaction solution was cooled, then, washed with water (40 mL) twice, with a 3 wt% acetic acid aqueous solution (mL) twice, and with water (40 mL) twice, and the organic layer was dropped into methanol (450 mL) to find generation of a precipitate, and this precipitate was filtrated, then, dried to obtain a solid. This solid was dissolved in toluene, and purified by passing through an alumina column and a silica gel column. The resultant toluene solution was dropped into methanol (450 mL), and the precipitate was filtrated, then, dried. The yielded amount of the resultant copolymer <P-3> was 1.49 g.

The copolymer <P-3> had a polystyrene-equivalent number average molecular weight of 5.4×10⁴ and a polystyrene-equivalent weight average molecular weight of 1.2×10⁵.

The copolymer <P-3> is a random copolymer having no block, and having the following repeating units at the same composition ratio as that in the copolymer <P-1>.

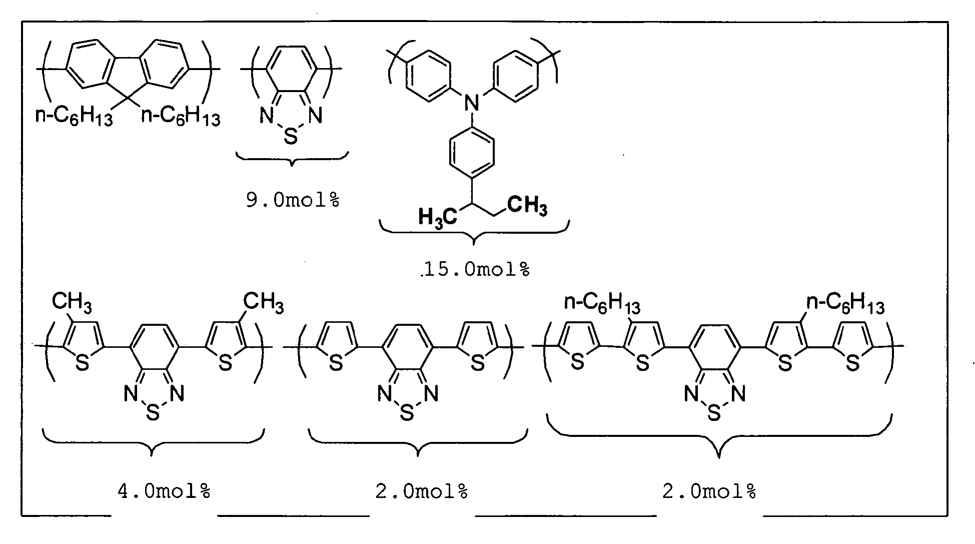

### <Example 2> [Production of composition]

The copolymer <P-1> (0.042 g) was dissolved in 2.958 g of xylene, to produce a 1.4 wt% xylene solution 1.

### <Synthesis Example 3> [Synthesis of copolymer <P-5>]

Under an inert atmosphere, 2,7-bis(1,3,2-dioxaborolan-2-yl)-9,9-dioctylfluorene, bis(4-bromophenyl)-(4-secondary butylphenyl)-amine, palladium acetate, tri(2-methylphenyl)phosphine, methyltrioctyl ammonium chloride (trade name: Aliquat (registered trademark) 336, manufactured by Aldrich) and toluene were mixed and heated at 105°C. Into the resultant the reaction solution was dropped a 2 M sodium carbonate (Na₂CO₃) aqueous solution, and the mixture was refluxed for 4 hours. After the reaction, phenylboronic acid was added, and the mixture was further refluxed for 3 hours. Then, a sodium N,N-diethyldithiocarbamate aqueous solution was added and the mixture was stirred at 80°C for 4 hours. The resultant the reaction solution was cooled, then, the organic layer was washed with water, a 3 wt% acetic acid aqueous solution and water in this order, and purified by passing through an alumina column and a silica gel column. The resultant toluene solution was dropped into methanol, then, the resultant solid was filtrated, then, dried, to obtain a copolymer <P-5>.

The copolymer <P-5> had a polystyrene-equivalent number average molecular weight of 7.9×10⁴ and a polystyrene-equivalent weight average molecular weight of 2.7×10⁵.

The copolymer <P-5> is a random copolymer having the following repeating units.

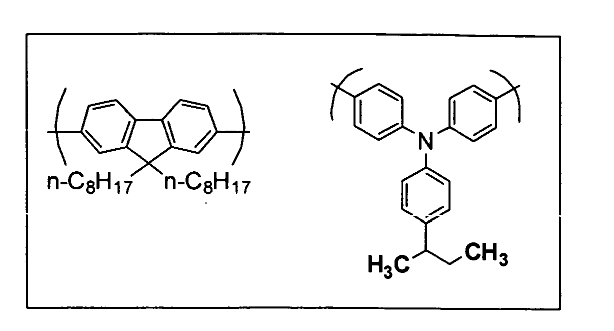

### <Example 3> [Fabrication of light emitting device and evaluation thereof]

On a glass substrate carrying thereon an ITO film having a thickness of 150 nm formed by a sputtering method, a solution of poly(ethylenedioxythiophene)/polystyrenesulfonic acid (manufactured by Bayer, trade name: BaytronP) was spin-coated to form a film having a thickness of 65 nm, and the film was dried on a hot plate at 200°C for 10 minutes. Then, the copolymer <P-5> was dissolved at a concentration of 1.5 wt% in xylene to prepare a xylene solution which was spin-coated at a revolution of 2500 rpm to form a film, and the film was dried at 180°C for 60 minutes under a nitrogen gas atmosphere having an oxygen concentration of 10 ppm or less and a water concentration of 10 ppm or less. This substrate was returned to room temperature under a nitrogen gas atmosphere, then, xylene was dropped onto the substrate, and spin-coated at 2000 rpm for 30 seconds, then, the above-prepared xylene solution 1 was spin-coated at a revolution of 2800 rpm to form a film. The film thickness was about 120 nm. This was dried at 130°C for 60 minutes under a nitrogen gas atmosphere, then, as a cathode, barium was vapor-deposited to form a film of about 5 nm, then, aluminum was vapor-deposited to form a film of about 100 nm. After the degree of vacuum reached 1×10⁻⁴ Pa or less, metal vapor-deposition was initiated. After vapor-deposition as described above, encapsulation was performed using a glass substrate, to fabricate a light emitting device. Voltage was applied to the resultant light emitting device, to observe EL light emission of extremely deep red color showing a peak at 750 nm at 8.0 V.

Driving at constant current was performed at a current density with which the initial light emission intensity was 42 mW/cm². After 119.6 hours, the light emission intensity became 75% of the initial value, and after 175.7 hours, the light emission intensity became half. A high luminance of 1000 cd/m² was obtained at a low voltage of 10.4 V. When a voltage of 8.0 V was applied, fluorescence was emitted under which the peak top of light emission wavelength was observed at 705 nm, and the luminance at this moment was 245 cd/m². The light emission efficiency showed a maximum value of 0.26 cd/A at 7.2 V.

### <Comparative Example 1>

A light emitting device was fabricated in the same manner as in Example 3 excepting that a 1.4 wt% xylene solution of the copolymer <P-3> was used instead of the xylene solution 1 and the revolution in the spin coat method was 1100 rpm instead of 2800 rpm.

Voltage was applied to the resultant light emitting device, to observe EL light emission of deep red color showing a peak at 705 nm.

Driving at constant current was performed at a current density with which the initial light emission intensity was 42 mW/cm². After 42.9 hours, the light emission intensity became 75% of the initial value. The voltage at which a luminance of 1000 cd/m² was obtained was 11.9 V, which was higher as compared with the value in Example 3. When a voltage of 8.0 V was applied, fluorescence was emitted under which the peak top of light emission wavelength was observed at 705 nm, and the luminance at this moment was 136 cd/m². The light emission efficiency showed a maximum value of 0.15 cd/A at 4.8 V.

### <Comparative Example 2>

A light emitting device was fabricated in the same manner as in Example 3 excepting that a 1.4 wt% xylene solution of the copolymer <P-2> was used instead of the xylene solution 1 and the revolution in the spin coat method was 1400 rpm instead of 2800 rpm.

Voltage was applied to the resultant light emitting device, to observe EL light emission of red color showing a peak at 675 nm when 8.0 V was applied, and the light emission wavelength was shorter as compared with that in Example 3.

Driving at constant current was performed at a current density with which the initial light emission intensity was 42 mW/cm². After 53.4 hours, the light emission intensity became 75% of the initial value, and after 95.5 hours, became half.

### <Example 4> [Synthesis of copolymer <P-4>]

Under an inert atmosphere, 2,7-bis(1,3,2-dioxaborolan-2-yl)-9,9-dioctylfluorene (0.88 g), 4,7-dibromo-2,1,3-benzothiadiazole (0.29 g), 4,7-bis(5-bromo-4-methylthiophen-2-yl)-2,1,3-benzothiadiazole (0.32 g), pentamer 1 (0.17 g), dichlorobis(triphenylphosphine)palladium (3.9 mg), methyltrioctyl ammonium chloride (trade name: Aliquat (registered trademark) 336, manufactured by Aldrich) (0.70 g) and toluene (18 mL) were mixed and heated at 105°C. Into the resultant reaction solution was dropped a 17.5 wt% sodium carbonate aqueous solution (5 mL) and the mixture was refluxed for 1.5 hours, to obtain a compound having a block (A). The block (A) had a polystyrene-equivalent number average molecular weight of 5.5.×10³ and a polystyrene-equivalent weight average molecular weight of 1.4×10⁴. The degree of polymerization of the block (A) was about 17, estimated from this polystyrene-equivalent number average molecular weight. The compound having the resultant block (A) was cooled down to 70°C, then, the reaction solution was mixed with 2,7-bis(1,3,2-dioxaborolan-2-yl)-9,9-dioctylfluorene (1.99 g), 2,7-dibromo-9,9-dioctylfluorene (1.10 g), bis(4-bromophenyl)-(4-secondary butylphenyl)-amine (0.74 g), dichlorobis(triphenylphosphine)palladium (7.5 mg) and toluene (36 mL), and the mixture was heated at 105°C. Into the resultant reaction solution was dropped a 17.5 wt% sodium carbonate aqueous solution (9.7 mL), and the mixture was refluxed for 6 hours. To this was added phenylboronic acid (0.66 g), and the mixture was further refluxed for 9 hours. Then, a sodium N,N-diethyldithiocarbamate aqueous solution was added and the mixture was stirred at 85°C for 2 hours. The resultant reaction solution was cooled, then, washed with water (70 mL) twice, with a 3 wt% acetic acid aqueous solution (70 mL) twice, and with water (70 mL) twice, and the organic layer was dropped into methanol (1200 mL) to find generation of a precipitate, and this precipitate was filtrated, then, dried to obtain a solid. This solid was dissolved in toluene, and purified by passing through an alumina column and a silica gel column. The resultant toluene solution was dropped into methanol (1500 mL), and the precipitate was filtrated, then, dried. The yielded amount of the resultant copolymer <P-4> was 3.30 g.

The copolymer <P-4> had a polystyrene-equivalent number average molecular weight of 5.7×10⁴ and a polystyrene-equivalent weight average molecular weight of 1.3×10⁵.

The copolymer <P-4> has the following block (A) and the following block (B). In the block (A), the total content ratio of a repeating unit represented by the formula (I-1) is 2 mol% with respect to all repeating units, and the constant ratio of a repeating unit represented by the formula (I-2) is 6 mol% with respect to all repeating units. The ratio of the block (A) in the copolymer <P-4> is 32.3 mol% and the content ratio of the block (B) is 67.7 mol%, calculated from the charged raw materials.

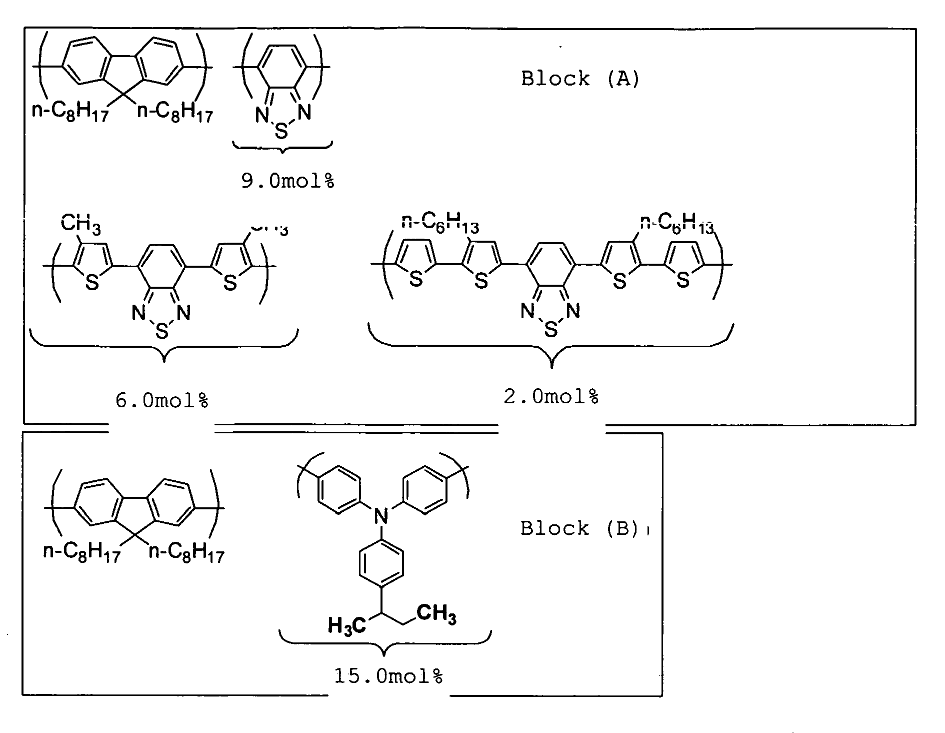

### Industrial Applicability

When the copolymer of the present invention is used, a polymer light emitting device showing light emission for a long period of time can be produced, thus, the present invention is industrially extremely useful.

## Claims

1. A copolymer having a block (A') composed of a repeating unit represented by the formula (I-1), and/or a block (A) containing a repeating unit represented by the formula (I-1) and a repeating unit represented by the formula (II). 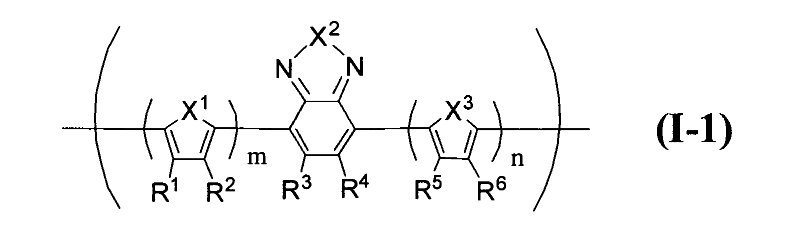 (wherein X¹, X² and X³ may be the same or mutually different and represent an oxygen atom, a sulfur atom or C(R⁷)=C(R⁸)-, and R¹, R² , R³ , R⁴, R⁵ , R⁶ , R⁷ and R⁸ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, and m and n may be the same or mutually different and represent 2 or 3. A plurality of R¹s may be the same or mutually different. A plurality of R²s may be the same or mutually different. A plurality of R⁵s may be the same or mutually different. A plurality of R⁶s may be the same or mutually different. A plurality of X¹s may be the same or mutually different. A plurality of X³s may be the same or mutually different.)
-(Ar¹)- (II)
(wherein Ar¹ represents an arylene group.).

2. The copolymer according to Claim 1 having a block (A) containing a repeating unit represented by the formula (I-1) and a repeating unit represented by the formula (II).

3. The copolymer according to Claim 1 or 2 wherein m and n represent 2.

4. The copolymer according to any one of Claims 1 to 3 wherein X¹, X² and X³ represent a sulfur atom.

5. The copolymer according to any one of Claims 1 to 4 wherein Ar¹ is a group represented by the formula (IV): 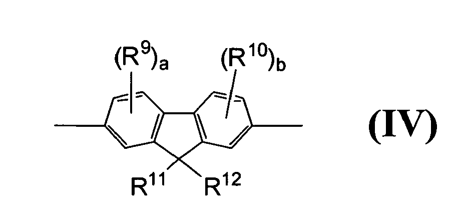 (wherein R⁹ and R¹⁰ may be the same or mutually different and represent a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, R¹¹ and R¹² may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group, and a and b may be the same or mutually different and represent an integer of 0 to 3. When there exist a plurality of R⁹s, these may be the same or mutually different. When there exist a plurality of R¹⁰s, these may be the same or mutually different.).

6. The copolymer according to any one of Claims 1 to 5 wherein the block (A) further contains two or more repeating units represented by the formula (I-2): 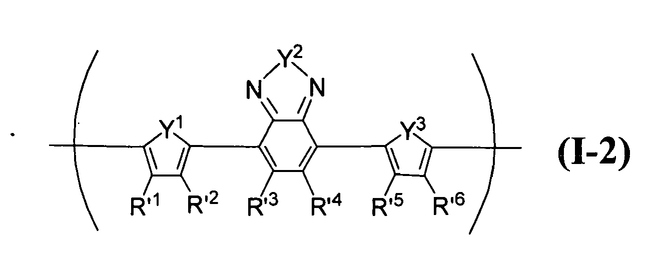 (wherein Y¹, Y² and Y³ may be the same or mutually different and represent an oxygen atom, a sulfur atom or -C (R'⁷)=C(R'⁸) -, and R'¹, R'², R'³ , R'⁴ , R'⁵, R'⁶, R'⁷ and R'⁸ may be the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a silyl group, an acyl group, an acyloxy group, an imine residue, an amide group, an acid imide group, a carboxyl group, a cyano group or a nitro group.).

7. The copolymer according to Claim 6 wherein Y¹, Y² and Y³ represent a sulfur atom.

8. The copolymer according to any one of Claims 1 to 7 further having a block (B) containing a repeating unit represented by the formula (II) and a repeating unit represented by the formula (III):
-(Ar²)- (III)
(wherein Ar² represents a di-valent aromatic amine residue.).

9. The copolymer according to Claim 8 wherein Ar² is a group represented by the formula (V-1), a group represented by the formula (V-2) or a group represented by the formula (V-3) : 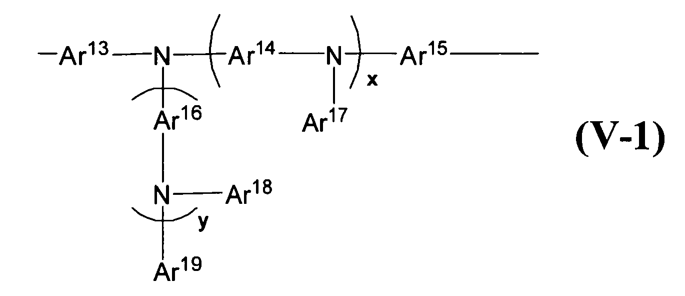 (wherein Ar¹³, Ar¹⁴, Ar¹⁵ and Ar¹⁶ may be the same or mutually different and represent an arylene group or a di-valent heterocyclic group. Ar¹⁷, Ar¹⁸ and Ar¹⁹ may be the same or mutually different and represent an aryl group or a mono-valent heterocyclic group. x and y may be the same or mutually different and represent 0 or 1, providing that 0≤x+y≤1.) 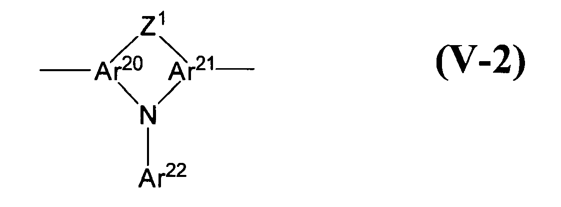 (wherein Ar²⁰ and Ar²¹ may be the same or mutually different and represent a tri-valent aromatic hydrocarbon group or a tri-valent heterocyclic group. Ar²² represents an aryl group or a mono-valent heterocyclic group. Z¹ represents an oxygen atom, a sulfur atom, -C(R^{Z1})=C(R^{Z2})-, -C(R^{Z3})(R^{Z4})-, -N(R^{Z5}) -or a direct bond. R^{Z1}, R^{Z2}, R^{Z3}, R^{Z4} and R^{Z5} may be the same or mutually different and represent a hydrogen atom, a halogen atom, an alkyl group, an aryl group or a mono-valent heterocyclic group.) 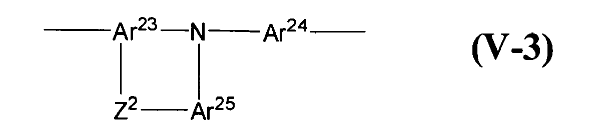 (wherein Ar²³ represents a tri-valent aromatic hydrocarbon group or a tri-valent heterocyclic group. Ar²⁴ and Ar²⁵ may be the same or mutually different and represent an arylene group or a di-valent heterocyclic group. Z² represents an oxygen atom, a sulfur atom, -C(R^{Z6})=C(R^{Z7})-, -C(R^{Z8})(R^{Z9})-, -N(R^{Z10})- or a direct bond. R^{Z6}, R^{Z7}, R^{Z8}, R^{Z9} and R^{Z10} may be the same or mutually different and represent a hydrogen atom, a halogen atom, an alkyl group, an aryl group or a mono-valent heterocyclic group.).

10. The copolymer according to Claim 8 or 9 wherein the block (B) contains two or more repeating units represented by the formula (III).

11. The copolymer according to any one of Claims 1 to 10 wherein the polystyrene-equivalent weight average molecular weight thereof is 1×10³ to 1×10⁷.

12. The copolymer according to any one of Claims 1 to 11 having a repeating unit represented by the formula (I-1) in an amount of 0.5 mol% or more and 40 mol% or less when the total amount of all repeating units in the copolymer is 100 mol%.

13. The copolymer according to any one of Claims 1 to 12 wherein the polystyrene-equivalent weight average molecular weight of the block (A) or block (A') is 1×10³ to 1×10⁵.

14. The copolymer according to any one of Claims 8 to 13 wherein the value represented by the formula (VI) is 0.1 or more and 10 or less:
(A) / (B) (VI)
(wherein (A) represents the maximum number among the number of the block (A) and the number of the block (A') contained in the copolymer, and (B) represents the number of the block (B) contained in the copolymer.).

15. The copolymer according to any one of Claims 1 to 13 wherein the value represented by the formula (VII) is 0.01 or more and 0.8 or less:
(C) / (D) (VII)
(wherein (C) represents the maximum value among the polystyrene-equivalent weight average molecular weight of the block (A) and the polystyrene-equivalent weight average molecular weight of the block (A'), and (D) represents the polystyrene-equivalent weight average molecular weight of the copolymer.).

16. A composition comprising the copolymer according to any one of Claims 1 to 15, and at least one material selected from the group consisting of a light emitting material, a hole transporting material and an electron transporting material other than the copolymer.

17. The composition according to Claim 16 containing at least two copolymers according to any one of Claims 1 to 15.

18. A composition comprising the copolymer according to any one of Claims 1 to 15, and a solvent.

19. A film comprising the copolymer according to any one of Claims 1 to 15.

20. A film comprising the composition according to Claim 16 or 17.

21. The film according to Claim 19 or 20 wherein the film is luminous.

22. The film according to Claim 19 or 20 wherein the film is electrically conductive.

23. A polymer light emitting device having an anode, a cathode, and an organic layer containing the copolymer according to any one of Claims 1 to 15 located between the anode and the cathode.

24. A polymer light emitting device having an anode, a cathode, and an organic layer containing the composition according to Claim 16 or 17 located between the anode and the cathode.

25. The polymer light emitting device according to Claim 23 or 24 wherein the organic layer is a light emitting layer.

26. A planar light source obtained by using the polymer light emitting device according to any one of Claims 23 to 25.

27. A liquid crystal display having the polymer light emitting device according to any one of Claims 23 to 25 as a backlight.

28. An illumination using the polymer light emitting device according to any one of Claims 23 to 25.

29. An organic transistor having an active layer containing the copolymer according to any one of Claims 1 to 15.

30. A photoelectric conversion device having an anode, a cathode, and an organic layer containing the copolymer according to any one of Claims 1 to 15 disposed between the anode and the cathode.

31. A method of producing the copolymer according to any one of Claims 1 to 15 having
a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, and
a step of condensation-polymerizing this first compound with a compound having two substituents capable of participating in condensation polymerization, to synthesize a copolymer having a block (A') and/or a block (A): (wherein -A- represents a repeating unit represented by the formula (I-1) or a repeating unit represented by the formula (I-2), Ar¹ represents the same meaning as described above, and W¹ and W² may be the same or mutually different and represent a substituent capable of participating in condensation polymerization.).

32. A method of producing the copolymer according to any one of Claims 8 to 15 having
a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound, and
a step of condensation-polymerizing this first compound with a compound represented by W¹-Ar¹-W² and a compound represented by W¹-Ar²-W², or condensation-polymerizing this first compound with a compound represented by W¹-Ar¹-W², a compound represented by W¹-Ar²-W² and a compound having two substituents capable of participating in condensation polymerization, to synthesize a copolymer having a block (A') and/or a block (A) and a block (B):
(wherein -A- represents a repeating unit represented by the formula (I-1) or a repeating unit represented by the formula (I-2), Ar¹ and Ar² represent the same meaning as described above, and W¹ and W² may be the same or mutually different and represent a substituent capable of participating in condensation polymerization.).

33. A method of producing the copolymer according to any one of Claims 8 to 15 having
a step of condensation-polymerizing only a compound represented by W¹-A-W², condensation-polymerizing a compound represented by W¹-A-W² with a compound represented by W¹-Ar¹-W², or condensation-polymerizing a compound represented by W¹-A-W² with a compound represented by W¹-Ar¹-W² and a compound having two substituents capable of participating in condensation polymerization, to synthesize a first compound,
a step of condensation-polymerizing a compound represented by W¹-Ar¹-W² with a compound represented by W¹-Ar²-W², or condensation-polymerizing a compound represented by W¹-Ar¹-W² with a compound represented by W¹-Ar²-W² and a compound having two substituents capable of participating in condensation polymerization, to synthesize a second compound,
and a step of condensation-polymerizing this first compound with this second compound, to synthesize a copolymer having a block (A') and/or a block (A) and a block (B):
(wherein -A- represents a repeating unit represented by the formula (I-1) or a repeating unit represented by the formula (I-2), Ar¹ and Ar² represent the same meaning as described above, and W¹ and W² may be the same or mutually different and represent a substituent capable of participating in condensation polymerization.).
